(19) Europäisches Patentamt
European Patent Office
Office européen des brevets

(11) EP 4 408 139 A2

(12) # EUROPEAN PATENT APPLICATION

(43) Date of publication:
**31.07.2024 Bulletin 2024/31**

(21) Application number: **24154647.2**

(22) Date of filing: **30.01.2024**

(51) International Patent Classification (IPC):
***H10K 50/852*** *(2023.01)* ***H10K 50/856*** *(2023.01)*
*H10K 101/10* *(2023.01)*

(52) Cooperative Patent Classification (CPC):
**H10K 50/852; H10K 50/85;** H10K 50/19; H10K 2101/10; H10K 2102/351

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**30.01.2023 US 202363482186 P**
**10.04.2023 US 202363495197 P**
**28.06.2023 US 202363510702 P**
**11.07.2023 US 202363512966 P**
**14.12.2023 US 202363610024 P**
**22.12.2023 US 202363613961 P**
**16.01.2024 US 202418413235**

(71) Applicant: **The Regents Of The University Of Michigan**
**Ann Arbor, Michigan 48109 (US)**

(72) Inventors:
- **ZHAO, Haonan**
  **Ann Arbor, MI, 48109 (US)**
- **FORREST, Stephen R.**
  **Ann Arbor, MI, 48109 (US)**

(74) Representative: **Maiwald GmbH**
**Engineering**
**Elisenhof**
**Elisenstrasse 3**
**80335 München (DE)**

(54) **ORGANIC ELECTROLUMINESCENT DEVICES**

(57) An organic light emitting device comprises an anode and a cathode, an organic emissive layer positioned between the anode and the cathode, the organic emissive layer comprising a host material and a dopant, a host material layer positioned between the cathode and the organic emissive layer, and a charge transport layer positioned between the cathode and the host material layer, wherein the charge transport layer is configured to form plasmon exciton polaritons in a region between the cathode and the charge transport layer. Stacked devices are also disclosed.

EP 4 408 139 A2

## Description

CROSS-REFERENCE TO RELATED APPLICATIONS

This application claims priority to U.S. provisional patent application No. 63/613,961 filed on December 22, 2023, U.S. provisional patent application No. 63/610,024 filed on December 14, 2023, U.S. provisional patent application No. 63/512,966 filed on July 11, 2023, U.S. provisional patent application No. 63/510,702 filed on June 28, 2023, U.S. provisional patent application No. 63/495,197 filed on April 10, 2023, and U.S. provisional patent application No. 63/482,186 filed on January 30, 2023, and U.S. Patent Application No. 18/413,235 filed January 16, 2024; each of which is incorporated herein by reference in its entirety.

STATEMENT REGARDING FEDERALLY SPONSORED RESEARCH OR DEVELOPMENT

This invention was made with government support under DE-EE0009688 awarded by the U.S. Department of Energy. The government has certain rights in the invention.

BACKGROUND OF THE INVENTION

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

Phosphorescent organic light emitting devices (PHOLEDs) have been extensively employed in both display and lighting applications owing to their vibrant colors and high efficiencies. However, since degradation is fundamentally energy-driven [4-7], blue PHOLEDs used in displays have unacceptably short lifetimes [10-22] compared to green and red PHOLEDs [3]. The primary, energetically-driven mechanisms leading to short blue PHOLED lifetimes are triplet-polaron (TPA) [5-6] and/or triplet-triplet annihilation (TTA) [4,5,7]. These reactions approximately double the energy of the excited states up to about 6.0 eV [4,11], which is sufficient to break intramolecular bonds and convert an organic molecule to a non-radiative quenching center[5,7,10,11].

To minimize the probability for high-energy annihilation events while maintaining high efficiency, the triplet density should be reduced via rapid radiative energy transfer. An OLED is by nature a weak multimode microcavity [23] comprising outcoupled and waveguided modes in the organic and substrate layers, and surface plasmon polaritons (SPPs), among others [4]. The enhancement of the radiative decay rates using a microcavity, known as the Purcell effect, can reduce the triplet density to approximately the inverse of the Purcell factor (PF) [5,8], and thereby reduce the probability for TPA and/or TTA. Here, the PF is the triplet radiative decay rate in the OLED microcavity normalized by its natural radiative decay rate, viz. $PF = k_r/k_{r,0}$. However, as depicted in Fig. 3, in a conventional PHOLED, the weak triplet energy transfer to conventional metal cathode SPPs induces only a modest change in the decay rate, leaving a high triplet density at equilibrium. A promising approach to enhance decay rates was reported by Fusella et al. [24], who doubled the lifetime of a green PHOLED via energy transfer from triplets to SPPs in a thin top metal cathode containing a random array of Ag nanocubes for top-emission extraction. However, this technique introduces complexity that is incompatible with full-color, stable and scalable displays manufacturing. In triplet-rich OLEDs such as phosphorescent OLED (PHOLEDs), TADF OLEDs and hyperfluorescent OLEDs, the triplet-polaron annihilation (TPA) and the triplet-triplet annihilation (TTA) are two common causes of the short-lived blue OLEDs. Thus there is a need in the art for improved devices.

SUMMARY OF THE INVENTION

Some embodiments of the invention disclosed herein are set forth below, and any combination of these embodiments (or portions thereof) may be made to define another embodiment.

In one aspect, an organic light emitting device comprises an anode, an organic emissive layer positioned over the anode, the organic emissive layer comprising a host material and a dopant, a charge transport layer positioned over the organic emissive layer, having a thickness of less than 20 nm, and a metal cathode positioned over the charge transport layer, wherein the charge transport layer and the cathode are configured to form plasmon exciton polaritons between the metal cathode and the charge transport layer.

In one embodiment, the device further comprises a reflector positioned under the anode.

In one embodiment, the reflector comprises a stack of layers of alternating materials.

In one embodiment, the reflector and the cathode form a cavity having a total cavity Q of 5 or less.

In one embodiment, at least a portion of the organic emissive layer is at an antinode of the cavity.

In one embodiment, the metal cathode is selected from the group consisting of Ag, Au, Ag alloys, and/or Au alloys.

In one embodiment, the charge transport layer has a thickness less than 18 nm.

In one embodiment, the charge transport layer has a thickness less than 15 nm.

In one embodiment, the charge transport layer has a thickness less than 10 nm.

In one embodiment, the reflector and the cathode form a cavity having a total cavity Q of 4 or less.

In one embodiment, the reflector and the cathode form a cavity having a total cavity Q of 3 or less.

In one embodiment, the device further comprises a blocking layer between the metal cathode and the charge transport layer.

In one embodiment, the device further comprises a buffer layer between the metal cathode and the charge transport layer.

In one embodiment, the blocking layer prevents diffusion between the metal cathode and the charge transport layer.

In one embodiment, the blocking layer is two or more layers.

In one embodiment, at least one layer of the two or more layers is made of Al.

In one embodiment, the at least one layer is adjacent to the metal cathode.

In one embodiment, the at least one layer is less than 3 nm thick.

In one embodiment, at least one layer of the two or more layers is Liq (8-Hydroxyquinolinolato-lithium).

In one embodiment, the at least one layer is adjacent to the charge transport layer.

In one embodiment, the at least one layer is less than 3 nm thick.

In one embodiment, an interface is formed between the metal cathode and the charge transport layer.

In one embodiment, plasmon exciton polariton strength is a function of the oscillator strength of the metal cathode and the charge transport layer.

In one embodiment, the charge transport layer comprises an electron transport layer.

In one embodiment, the charge transport layer comprises an absorption tail that overlaps a portion of the emission spectrum of the emissive layer.

In another aspect, a consumer product comprises the device as described above, wherein the consumer product is selected from the group consisting of a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, a light therapy device, and a sign.

In one embodiment, the organic emissive layer positioned over the anode comprises an emitter stack above the anode, comprising a charge generation layer between first and second emission layers and wherein the charge transport layer positioned over the organic emissive layer, having a thickness of less than 20 nm comprises at least one of a hole transport layer and hole injection layer between the anode and the emitter stack, with an absorption tail that overlaps at least a first portion of a first emission spectrum of a first triplet controlled emitting material of the emitter stack and further comprising: a substrate; the anode above the substrate; the metal cathode above the emitter stack; and an electron transport layer between the emitter stack and the metal cathode, with an absorption tail that overlaps at least a second portion of a second emission spectrum of a second triplet controlled emitting material of the emitter stack.

In one embodiment, at least one of the hole transport layer and hole injection layer has a thickness of 1 nm to 40 nm, or combined thickness of 5 nm to 40 nm

In one embodiment, at least one of the hole transport layer and hole injection layer comprises a composition of BCFN and HATCN.

In one embodiment, the electron transport layer has a thickness of 5 nm to 60 nm.

In one embodiment, the electron transport layer comprises BPyTP2.

In one embodiment, the anode comprises a metal anode.

In one embodiment, the thickness of the charge generation layer is tuned to match the first and second emission layers with the anti-nodes of a metal-metal cavity defined by the metal anode and metal cathode.

In one embodiment, the first and second emission layers are configured to emit blue light.

In one embodiment, the first and second emission layers each have a thickness of 60 nm to 70 nm.

In one embodiment, the first emission layer or second emission layer comprises a first layer with a thickness of 5 nm comprising SiCzCz, a second layer with a thickness of 5nm comprising mSiTrz, and a third layer between the

first and second layers with a thickness of 50 nm to 60 nm comprising SiCzCz:SiTrzCz2 (1:1) and PtON-TBBI doped 6-13 vol%.

In one embodiment, the first emission layer or second emission layer comprises a first layer with a thickness of 55 nm to 65 nm comprising mCBP:$Ir(dmp)_3$ doped 18-8 vol%, and a second layer above or below the first layer with a thickness of 5 nm comprising mCBP.

In one embodiment, the charge generation layer has a thickness of 30 nm to 100 nm.

In one embodiment, the charge generation layer comprises a first layer with a thickness of 8 nm to 30 nm comprising BPyTP2, a second layer with a thickness of 15 nm to 40 nm comprising a composition of BCFN and HATCN, and a third layer between the first and second layers with a thickness of 12 nm comprising BPyTP2:Li 2%.

In one embodiment, the anode comprises an Ag composite electrode.

In one embodiment, the Ag composite electrode comprises a first layer of thickness 20 nm to 70 nm comprising ITO, a second layer above the first layer with a thickness of 2 nm to 3 nm comprising Ti or NiCr, a third layer above the second layer with a thickness of 15 nm to 20 nm comprising Ag, a fourth layer above the third layer with a thickness of 2 nm to 3 nm comprising Al, Ti, $TiO_2$, or NiCr, and a fifth layer above the fourth layer with a thickness of 5 nm to 20 nm comprising ITO.

In one embodiment, the substrate comprises glass.

In one embodiment, the device has a lifetime enhancement of at least 36 times.

In another aspect, a product comprises the device as described above, where the product is selected from the group consisting of a flat panel display, a curved display, a computer monitor, a computer, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro-display, a 3-D display, a virtual reality or augmented reality display or device, a vehicle, a video wall comprising multiple displays tiled together, a theater or stadium screen, a light therapy device, a camera, an imaging device, and a sign.

In another aspect, an organic light emitting device (OLED) comprises a substrate, a reflector above the substrate, a first electrode above the reflector, an emissive layer above the first electrode, an electron transport layer above the emissive layer, and a second electrode above the electron transport layer wherein the electron transport layer and the second electrode are configured to form plasmon exciton polaritons between the second electrode and the electron transport layer.

In one embodiment, the device further comprises at least one of a hole blocking layer, electron blocking layer, a hole transport layer, and a hole injection layer between the first electrode and the emissive layer.

In one embodiment, the device further comprises a second hole blocking layer between the emissive layer and the electron transport layer.

In one embodiment, the device further comprises a buffer layer between the electron transport layer and the second electrode.

In one embodiment, the reflector comprises a distributed Bragg reflector.

In one embodiment, the OLED includes a cavity between the first and second electrodes.

In one embodiment, the emissive layer is positioned to span an antinode of the cavity.

In one embodiment, the second electrode comprises a metal electrode.

In one embodiment, the emissive layer comprises a blue emissive layer.

In one embodiment, the emissive layer comprises a phosphorescent emitter material.

In one embodiment, the phosphorescent emitter material is a blue phosphorescent emitter material.

In one embodiment, the emissive layer comprises a sensitizer material and an acceptor material and wherein the sensitizer material transfers energy to the acceptor material.

In one embodiment, the acceptor material is a fluorescent emitter material.

In one embodiment, the sensitizer material is selected from the group consisting of a phosphorescent material or delayed fluorescent material.

In one embodiment, the sensitizer material is a blue emissive material.

In one embodiment, the fluorescent emitter material can be a delayed fluorescent emitter material.

In one embodiment, the electron transport layer has a large oscillator strength at wavelengths shorter than a triplet emission wavelength of the organic emissive layer.

In one embodiment, the reflector has a reflectivity in a range of 50-100%.

In one embodiment, the reflector has a reflectivity of 50-80%.

In one embodiment, the reflector has a reflectivity of 60-70%.

In another aspect, an organic light emitting device comprises a substrate, a first electrode above the substrate, an emitter stack above the first electrode, comprising a charge generation layer between first and second emission layers, and a second electrode above the emitter stack.

In one embodiment, the device further comprises at least one of a hole transport layer and hole injection layer between the first electrode and the emitter stack, with an absorption tail that overlaps at least a first portion of a first emission spectrum of a first triplet controlled emitting material of the emitter stack.

In one embodiment, the at least one of the hole transport layer and hole injection layer has a thickness of 1 nm to 40 nm, or about 10 nm, or combined thickness of 5 nm to 40 nm.

In one embodiment, the at least one of the hole transport layer and hole injection layer comprises a composition of BCFN and HATCN.

In one embodiment, the device further comprises a electron transport layer between the emitter stack and the second electrode, with an absorption tail that overlaps at least a second portion of a second emission spectrum of a second triplet controlled emitting material of the emitter stack.

In some embodiments, the first and second triplet controlled emitting materials of the emitter stack may be the same or different. In some embodiments, the first and second emission spectrums may be the same or different. In some embodiments, the first and second portions of the emission spectrums may be the same or different.

In one embodiment, the electron transport layer has a thickness of 5 nm to 60 nm.

In one embodiment, the electron transport layer comprises BPyTP2.

In one embodiment, the first and second electrodes comprise metal electrodes.

In one embodiment, the thickness of the charge generation layer is tuned to match the first and second emission layers with the anti-nodes of a metal-metal cavity defined by the first and second electrodes.

In one embodiment, the first and second emission layers are configured to emit blue light.

In one embodiment, the first and second emission layers each have a thickness of 60 nm to 70 nm.

In one embodiment, the first emission layer or second emission layer comprises a first layer with a thickness of 5 nm comprising SiCzCz, a second layer with a thickness of 5nm comprising mSiTrz, and a third layer between the first and second layers with a thickness of 50 nm to 60 nm comprising SiCzCz:SiTrzCz2 (1:1) and PtON-TBBI doped 6-13 vol%.

In one embodiment, the first emission layer or second emission layer comprises a first layer with a thickness of 55 nm to 65 nm comprising mCBP:$Ir(dmp)_3$ doped 18-8 vol%, and a second layer above or below the first layer with a thickness of 5 nm comprising mCBP.

In one embodiment, the charge generation layer has a thickness of 30 nm to 100 nm.

In one embodiment, the charge generation layer comprises a first layer with a thickness of 8 nm to 30 nm comprising BPyTP2, a second layer with a thickness of 15 nm to 40 nm comprising a composition of BCFN and HATCN, and a third layer between the first and second layers with a thickness of 12 nm comprising BPyTP2:Li 2%.

In one embodiment, the first electrode comprises an Ag composite electrode.

In one embodiment, the Ag composite electrode comprises a first layer of thickness 20 nm to 70 nm comprising ITO, a second layer above the first layer with a thickness of 2 nm to 3 nm comprising Ti or NiCr, a third layer above the second layer with a thickness of 15 nm to 20 nm comprising Ag, a fourth layer above the third layer with a thickness of 2 nm to 3 nm comprising Al, Ti, $TiO_2$, or NiCr, and a fifth layer above the fourth layer with a thickness of 5 nm to 20 nm comprising ITO.

In one embodiment, the substrate comprises glass.

In one embodiment, the device has a lifetime enhancement of at least 36 times.

In another aspect, a product comprises the device as described above, where the product is selected from the group consisting of a flat panel display, a curved display, a computer monitor, a computer, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro-display, a 3-D display, a virtual reality or augmented reality display or device, a vehicle, a video wall comprising multiple displays tiled together, a theater or stadium screen, a light therapy device, a camera, an imaging device, and a sign.

In another aspect, an organic light emitting device comprises a substrate, a first electrode above the substrate, two or more emitter stacks above the first electrode, each stack comprising alternating emission layers and charge generation layers, with emission layers as the top most and bottom most layers, a second electrode above the emitter stack, a hole transport layer or hole injection layer between the first electrode and the emitter stacks with an absorption tail that overlaps at least a first portion of a first emission spectrum of a first triplet controlled emitting material of the emitter stacks, and an electron transport layer between the emitter stack and the second electrode with an absorption tail that overlaps at least a second portion of a second emission spectrum of a second triplet controlled emitting material of the emitter stacks.

In another aspect, a stacked organic light emitting device comprises a substrate, a first electrode above the substrate, a second electrode above the first electrode, and two or more emission layers employing polariton-enhanced Purcell effects in the regions of the first and second electrodes.

In another aspect, an organic light emitting device comprises an anode, an organic emissive layer positioned over the anode, the organic emissive layer comprising a host material and a dopant, an electron transport layer positioned over the organic emissive layer, having a thickness of less than 20 nm and an absorption tail that overlaps a portion of the emission spectrum of the emissive layer, and a metal cathode positioned over the charge transport layer, wherein the electron transport layer and the cathode are configured to form plasmon exciton polaritons between the metal cathode and the electron transport layer.

BRIEF DESCRIPTION OF THE DRAWINGS

The foregoing purposes and features, as well as other purposes and features, will become apparent with reference to the description and accompanying figures below, which are included to provide an understanding of the invention and constitute a part of the specification, in which like numerals represent like elements, and in which:

Fig. 1 is a block diagram depicting an exemplary organic light emitting device (OLED) in accordance with some embodiments.

Fig. 2 is a block diagram depicting an exemplary inverted organic light emitting device that does not have a separate electron transport layer in accordance with some embodiments.

Fig. 3 depicts the plasmon-exciton-polariton (PEP)-enhanced Purcell effect in Cyan-emitting conventional devices in accordance with some embodiments. Triplets have a small energy transfer (ET) rate to the surface plasmon polaritons (SPPs) at the cathode surface, and thus only a moderate change in the photoluminescence (PL) lifetime. The slow radiative decay of triplets results in a large density at equilibrium, inducing a high probability for triplet-polaron (TPA) and triplet-triplet annihilation (TTA), leading to rapid degradation. Deep blue emitting cavity devices employ an Ag/electron transporting layer (ETL) combination, leading to an enhanced Purcell effect via fast ET to PEPs. Consequently, the triplet density is reduced, thereby reducing TPA and TTA. The Purcell-enhanced devices employ distributed Bragg reflectors (DBRs) to form an optical cavity with the metal cathode to improve light extraction and emission color saturation.

Fig. 4 depicts polariton dispersion engineering in accordance with some embodiments. Shown here is angle-resolved polariton dispersion of (from left to right) Ag/BPyTP2, Ag/SF3Trz, Al/BPyTP2, and Al/SF3Trz cathode/ETLs relative to measured reflectance using ellipsometry (top row). The Al/BPyTP2 LP, MP, and UP are fit to the corrected local minima (circles) using the coupled oscillator model, labeled by solid lines. The color bar is for both measurement (top row) and simulation (center row). Simulated reflectance is done using transfer matrix methods. The extinction coefficients of BPyTP2 and SF3Trz are shown in the righthand panel. BPyTP2/SF3Trz exciton absorption peak fits are labeled by dashed lines. Angular photoluminescence (PL) is measured using Fourier-imaging spectroscopy (bottom row). The PL intensities are multiplied by 100, 40 and 100X for Ag/SF3Trz, Al/BPyTP2 and Al/SF3Trz, respectively. See below for method details and Fig. 9 for analysis of the PEP dispersion.

Figs. 5A-5C depict optical engineering of exemplary blue phosphorescent organic light emitting diodes(PHOLEDs) in accordance with some embodiments. Fig. 5A shows structures of conventional PHOLEDs, C, with an Al/Liq cathode; a polariton-enhanced half cavity, H, with Ag cathode buffered by 3 nm thick Al and Liq; a full cavity, F, by adding a bottom DBR to H. All structures include a 50 nm thick emission layer (EML). Triplet energy transfer rates for different channels are shown for !r(dmp)3 at top. The nonradiative channels include nonradiative recombination in the EML (grey) and quenching by defects (red). Red arrows indicate the growing fraction of nonradiative quenching by defects generated during aging. Dashed rectangles indicate the generated defect density at LT85. Fig. 5B shows time-resolved PL spectra for 50 nm thick $Ir(cb)_3$ EML structures C, H, and F. See method details below and Figs. 11A-11C for details. All data are fit to the TTA model in addition to a single exponential decay. Fig. 5C depicts an exemplary stacked OLED in accordance with some embodiments.

Figs. 6A-6D depict $Ir(dmp)_3$ device performance in accordance with some embodiments. Fig. 6 A shows external quantum efficiency (EQE) vs. current density (J) for $Ir(dmp)_3$ devices C1-3 and F1-3. Fig. 6B shows electroluminescence (EL) intensity spectra for C1, F1-3. The relative EL intensity calculated based on the EQE at J = 10 $mA/cm^2$ is shown. Fig. 6C shows angle-resolved PL spectra for F2. Inset, angle-resolved PL intensity of F2 and C2. The Lambertian emission is labeled by the black solid line. Fig. 6D shows luminance decay for C1-3 and F1-3 at J=7 $mA/cm^2$ (corresponding to an approximate initial luminance of about 1000 $cd/m^2$ for C3, see Table 1 below). Structure 1 employs a 17 nm thick SF3Trz ETL, 2 and 3 employ 17 nm and 25 nm thick BPyTP2 ETLs. Black solid lines are fits to a stretched exponential:$L(t)/L_0 = \exp[-(t/t_0)^{\beta}]$ where $L_0$ is the initial luminance, and $t_0$ and $\beta$ are parameters.

Error bars in the legend indicate 95% confidence intervals.

Figs. 7A-7C depict an $Ir(dmp)_3$ device performance summary in accordance with some embodiments. Fig. 7A shows a power law relating device operational lifetime to the calculated average Purcell factor for $Ir(dmp)_3$ devices C1-3, H1-3, and F1-3. Three lifetime standards of LT90, LT80 and LT70 are shown at an aging current density of 7 $mA/cm^2$ with corresponding power laws of m = 2.4 $\pm$ 0.4, 2.1 $\pm$ 0.3 and 1.7 $\pm$ 0.3. Fig. 7B shows a comparison of LT90 at J = 7 $mA/cm^2$, peak external quantum efficiency $EQE_{max}$ and $CIE_y$ coordinates for C1 and F1-3. Fig. 7C shows normalized LT90 versus $CIE_y$ of Ir-complex-based PHOLEDs reported for this work, and from the literature. Devices F1-3 are labeled by stars, gaining a conservative 10-14X increase in LT90 compared to devices with similar $CIE_y$ reported to date (vertical arrows). The conventional devices C1-3 are labeled by triangles within the ellipse. Operational lifetimes are normalized to the photon exitance $M_{p,0}$ = EQE $\times$ J, equivalent to a device with EQE = 25% driven at J = 2 $mA/cm^2$. An aging acceleration factor of 1.8 $\pm$ 0.2 is adopted from literature. The black solid line shows the linear regression of the scattered data (except for the Purcell-enhanced devices in this work), with the upper/lower bound denoted by dashed lines.

Fig. 8 depicts exemplary molecular structural formulae of organic materials used in the EML, ETL, and hosts in accordance with some embodiments.

Fig. 9 depicts angle-resolved transverse magnetic (TM)-mode reflectance of Al/BPyTP2. The measurement angles are increased from $\theta$ = 51° to 87° by 3° increments, indicated by solid lines. The black dashed lines provide guides to the dispersion of lower (LP), middle, (MP) and upper polariton (UP) branches. The extinction coefficient of BPyTP2 is shown by the filled pink area. The PEP dispersion in Fig. 4 is fit to the local minima. Inset: Ellipsometry measurement setup. 20 nm thick Al/20nm BPyTP2 is coated on a prism coupler.

Fig. 10 depicts additional exemplary device structures in accordance with some embodiments. Letters C, H and F label the cathode and anode structures. Numbers 1-6 label the organic structures sandwiched between the electrodes.

Figs. 11A-11C depict example experimental results in accordance with some embodiments. Fig. 11A shows an optical density of states (ODoS) distribution simulated using dyadic Green's functions for structure C with a 15 nm thick SF3Trz ETL, and structure F with a 15 nm thick BPyTP2 ETL. The triplet dipole position is in the middle of the EML with an isotropic orientation relative to the film plane. White dashed lines separate regions of different optical modes. Structure F has a low-Q Ag/DBR cavity mode at $k_x/k_0 < 1$. The relative ODoS intensity is labeled by the color bar at right. The ODoS for structure C is multiplied by five for comparison. Fig. 11B shows simulated Purcell factor (PF) vs. triplet emitter position for structures C and F for different cathode/ETL combinations. The horizontal and vertical dipoles are labeled by blue and red dashed lines, respectively. The PF for isotropic dipoles is averaged over 67% horizontal (in-plane) and 33% vertical (orange line) dipoles. The measured PF for horizontal dipoles is labeled by diamonds at 45 nm from the cathode, corresponding to the center of the 50 nm thick EML. The simulated center wavelength is 465nm. Fig. 11C shows measured normalized decay rate, $k_r/k_{r,0}$ overlayed with simulated PFs for horizontal (PFhor) and isotropic dipoles (PFiso) using the Green's function method. Here, $k_{r,0}$ is the decay rate of the bare EML.

Figs. 12A-12E depict $Ir(dmp)_3$ device energy levels and performance in accordance with some embodiments. Fig. 12A shows an example device structure and frontier orbital levels (in eV). Fig. 12B shows external quantum efficiency vs. J of C1-3, H1-3, and F1-3. Fig. 12C shows EL spectra of C1-3, H1-3, and F1-3 at J = 10 $mA/cm^2$. Inset: Chromaticity coordinates of the devices. The arrow indicates the blueshift from the control to the full cavity devices. Fig. 12D shows Current-Voltage (J-V, left axis) and luminance (right axis) characteristics of C1-3, H1-3, and F1-3. Fig. 12E shows device operational lifetime for C1-3, H1-3, and F1-3 at J = 7 $mA/cm^2$. Error bars in the legend indicate 95% confidence intervals.

Figs. 13A-13E depict $Ir(cb)_3$ device energy levels and performance. Fig. 13A shows an example device structure and frontier orbital levels (in eV). Fig 13B shows device operational lifetime at J = 5 $mA/cm^2$. Errors are indicated in Table 1. Fig. 13C shows EL spectra of C4-6 and H5-6 at J = 10 $mA/cm^2$. Fig. 13D shows external quantum efficiency vs. J of C4, C5-6 and H5-6. Errors are indicated in Table 1. Fig. 13E shows J-V (left axis) and luminance (right axis) characteristics of C4-6 and H5-6.

Figs. 14A-14F depict experimental results for the stacked device of Fig. 5C. Fig. 14A is a plot depicting an experimental refractive index of BPyTP2 in accordance with some embodiments. Fig. 14B is a plot depicting experimental PEP

reflection spectra of Al/BPyTP2 in accordance with some embodiments. Fig. 14C is a plot depicting simulated PEP reflection spectra of Ag/BPyTP2 and Al/ BPyTP2 vs. SPP reflection of Ag/SF3Trz and Al/SF3Trz. Fig. 14D is a plot depicting an experimental refractive index of BCFN. Fig. 14E is a plot depicting simulated PEP reflection spectra of Al/BCFN. Fig. 14F is a plot depicting measured PEP PL of Al/BCFN.

Figs. 15A-15C are plots showing further experimental results of the stacked device of Fig. 5C. Fig. 15A is a plot depicting simulated Purcell factor of the experimental stacked device. Fig. 15B is a plot depicting simulated Outcoupling efficiency of the experimental stacked device. Fig. 15C is a plot depicting a cavity mode of the experimental stacked device.

Fig. 16 is a plot depicting normalized LT90 versus $CIE_y$ of Ir-complex-based PHOLEDs reported for this work, and from the literature. The double stack device with Purcell enhancements is labeled by a solid star, gaining 200X lifetime from the predicted conventional device with the same deep blue color. Single stack devices with Purcell enhancements are labeled by hollow stars, gaining a *conservative* 10-14X increase in LT90 compared to devices with similar $CIE_y$ reported to date (vertical arrows). The conventional single stacked devices without Purcell enhancements are labeled by triangles within the ellipse. Operational lifetimes are normalized to the photon exitance $M_{p,0} = EQE \times J$, equivalent to a device with EQE = 25% driven at $J$ = 2 mA/cm$^2$. An aging acceleration factor of 1.8 $\pm$ 0.2 is adopted from literature, see Methods for details. The black solid line shows the linear regression of the scattered data (except for the Purcell-enhanced devices in this work), with the upper/lower bound denoted by dashed lines.

## DETAILED DESCRIPTION

It is to be understood that the figures and descriptions of the present invention have been simplified to illustrate elements that are relevant for a clear understanding of the present invention, while eliminating, for the purpose of clarity, many other elements found in related systems and methods. Those of ordinary skill in the art may recognize that other elements and/or steps are desirable and/or required in implementing the present invention. However, because such elements and steps are well known in the art, and because they do not facilitate a better understanding of the present invention, a discussion of such elements and steps is not provided herein. The disclosure herein is directed to all such variations and modifications to such elements and methods known to those skilled in the art.

Unless defined otherwise, all technical and scientific terms used herein have the same meaning as commonly understood by one of ordinary skill in the art to which this invention belongs. Although any methods and materials similar or equivalent to those described herein can be used in the practice or testing of the present invention, exemplary methods and materials are described.

As used herein, each of the following terms has the meaning associated with it in this section.

The articles "a" and "an" are used herein to refer to one or to more than one (i.e., to at least one) of the grammatical object of the article. By way of example, "an element" means one element or more than one element.

"About" as used herein when referring to a measurable value such as an amount, a temporal duration, and the like, is meant to encompass variations of ±20%, ±10%, ±5%, ±1%, and ±0.1% from the specified value, as such variations are appropriate.

Throughout this disclosure, various aspects of the invention can be presented in a range format. It should be understood that the description in range format is merely for convenience and brevity and should not be construed as an inflexible limitation on the scope of the invention. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 2.7, 3, 4, 5, 5.3, 6 and any whole and partial increments therebetween. This applies regardless of the breadth of the range.

In some aspects of the present invention, software executing the instructions provided herein may be stored on a non-transitory computer-readable medium, wherein the software performs some or all of the steps of the present invention when executed on a processor.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety. One application for phosphorescent emissive molecules is a full color display. Industry standards for such a display call for pixels adapted to emit particular colors, referred to as "saturated" colors. In particular, these standards call for saturated red, green, and blue pixels. Color may be measured using CIE coordinates, which are well known to the art.

One example of a green emissive molecule is tris(2-phenylpyridine) iridium, denoted Ir(ppy)$_3$, which has the following structure:

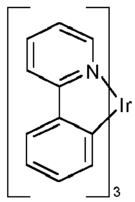

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, on a conventional energy level diagram, with the vacuum level at the top, a "shallower" energy level appears higher, or closer to the top, of such a diagram than a "deeper" energy level, which appears lower, or closer to the bottom.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704, which is incorporated herein by reference in its entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices

based on electrophosphorescence," Appl. Phys. Lett., vol. 75, No. 3, 4-6 (1999) ("Baldo-II"), which are incorporated by reference in their entireties. Phosphorescence is described in more detail in US Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with $F_4$-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred

methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theaters or stadium screens, light therapy devices, and signs. Various control mechanisms may be used to control devices fabricated in accordance with the present disclosure, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

Although certain embodiments of the disclosure are discussed in relation to one particular device or type of device (for example OLEDs) it is understood that the disclosed improvements to light outcoupling properties of a substrate may be equally applied to other devices, including but not limited to PLEDs, OPVs, charge-coupled devices (CCDs), photosensors, or the like.

Although exemplary embodiments described herein may be presented as methods for producing particular circuits or devices, for example OLEDs, it is understood that the materials and structures described herein may have applications in devices other than OLEDs. For example, other optoelectronic devices such as organic solar cells and organic photodetectors may employ the materials and structures. More generally, organic devices, such as organic transistors, or other organic electronic circuits or components, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, at least one of the anode, the cathode, or a new layer disposed over the organic emissive

layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layers can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the

outcoupling layer also acts as an electrode of the device.

Disclosed herein are devices utilizing the polariton-enhanced Purcell effect to extend the operational lifetime of PHOLEDs, such a blue, red, green, and/or white PHOLEDS. Energy transfer to PEPs significantly reduces the triplet radiative lifetime and their density within the PHOLED emission layer (EML). PEPs are a strongly coupled state at the metal/dielectric interface resulting from mixing of the SPP mode of the metal with excitons in the adjacent dielectric layer(s). Here, the PEP strength is a function of the oscillator strengths of both the cathode and electron transport layer (ETL), see Fig. 3 (right). Combined with a low-quality factor (Q) optical cavity comprising an Ag cathode and a distributed Bragg reflector (DBR) mirror, the light extraction efficiency and the emission color saturation are increased. In some examples, a portion of the ETL absorption spectrum such as the long wavelength tail (i.e. imaginary part of index of refraction) is in the emission spectrum of the EML. In some embodiments, the polariton is detuned from absorption. In some embodiments, the ETL absorption spectrum (or the imaginary part of index of refraction) is higher than (i.e. shorter wavelength) the emission spectrum of the EML, instead in the EML emission spectrum. In some embodiments, the polariton is detuned to overlap with the EML emission to enhance the Purcell effect, instead of detuning from the absorption. In some embodiments, this overlap can be tuned to balance light extraction and absorption. In some embodiments, inefficient triplets are encouraged to radiate into polaritons.

Three archetype exemplary devices are shown to maximize the total deep blue photon output featuring long device lifetime, saturated emission, and high external quantum efficiency (EQE). By engineering the PEP-enhanced Purcell effect, a deep blue $Ir(dmp)_3$-based PHOLED is demonstrated with an average Purcell factor of PF = 2.4 $\pm$ 0.2 across the 50 nm thick EML, leading to a 5.3-fold increase in LT90 compared to a conventional PHOLED using this same phosphor. By optimizing the Ag/DBR cavity, the Commission Internationale d'Eclairage (CIE) coordinates of the conventional $Ir(dmp)_3$ PHOLED shift from cyan at (0.16, 0.26), to deep blue at (0.14, 0.14), gaining almost three-fold increase in LT90 using the Purcell effect enhanced by the strong Ag SPP, while maintaining the same EQE. Considering the prolonged device operational lifetime and saturated color, the device achieves a 14 times enhancement in LT90 compared to other, similarly deep blue Ir-complex-based PHOLEDs. By balancing the EQE and the PF, a PEP-enhanced device employing Ag cathode/BPyTP2 ETL achieves the longest normalized LT90 = 140 $\pm$ 20 h at CIE = (0.15, 0.20) among Ir-complex-based PHOLEDs with $CIE_y < 0.31$ reported to date.

A strongly coupled PEP state is formed at the metal cathode/ETL interface at wavelengths where the ETL singlet exciton is resonant with the SPP mode of the cathode, see Fig. 8 for chemical structures of the molecules used. In some embodiments, resonance is defined by the ETL singlet exciton absorption peak (i.e. major frequency). In some embodiments, the SPP mode is broad spectrum, and one or a few wavelengths are chosen out of that spectrum. Fig. 4 shows the match between the measured and calculated angle-resolved spectra, respectively. The strongly coupled PEPs for the Al/BPyTP2 combination dispersion splits into upper (UP), middle (MP) and lower polariton (LP) branches. Owing to the large oscillator strength of BPyTP2 at energies slightly above the blue phosphor $Ir(dmp)_3$ triplet of 2.8 - 3.0 eV, an anti-crossing is formed between the Al SPP and excitons in the ETL, resulting in a relatively flat, redshifted LP dispersion at l = 400-500 nm (See Fig. 9 and below for detailed methods of the analysis of the PEPs). When BPyTP2 is replaced by another common ETL, SF3Trz, the polariton red shift is weaker due to the higher SF3Trz exciton energy. The overlap between the Al/BPyTP2 LP energy and the $Ir(dmp)_3$ triplet emission is, therefore, larger than the Al/SF3Trz polariton. Using an Ag cathode, the splitting between the BPyTP2 exciton and the Ag/BPyTP2 PEP dispersion is even larger owing to the stronger SPP in Ag than Al. The MP and UP branches are not observed due to their higher energy than the Ag absorption band. The Ag/BPyTP2 PEP has an asymptotically flat region limited by the BPyTP2 exciton energy at $1 < k_x/k_0 < \infty$. Here, $k_0$ is the wavevector in vacuum. Therefore, Ag/BPyTP2 shows the most complete overlap between the PEP and the blue-cyan region at wavelengths of 400-500 nm, followed by Ag/SF3Trz > Al/BPyTP2 > Al/SF3Trz.

Fig. 4 also shows the angular photoluminescence (PL). The Ag/BPyTP2 PEP LP branch shows a PL intensity that is two orders of magnitude higher than the other three cathode/ETLs, showing enhanced mixing between the SPP and ETL excitons. Note that the strong coupling is between the ETL and the cathode, and the triplet from the blue phosphor emission is transferred to the PEPs in the weak coupling regime due to the low oscillator strength of triplets.

Fig. 5A illustrates several exemplary PHOLED structures labeled as C, H and F (see. Fig. 10 for further devices studied).

In some embodiments, an organic light emitting device 300 comprises an anode 303, an organic emissive layer 305 positioned over the anode 303, the organic emissive layer 305 comprising a host material and a dopant, a charge transport layer 307 positioned over the organic emissive layer 305, having a thickness of less than 20 nm, and a metal cathode 309 positioned over the charge transport layer 307, wherein the charge transport layer 307 and the cathode 309 are configured to form plasmon exciton polaritons between the metal cathode 309 and the charge transport layer 307.

In some embodiments, the device 300 further comprises a reflector 302 positioned under the anode. In some embodiments, the reflector 302 comprises a stack of layers of alternating materials.

In some embodiments, the reflector 302 and the cathode 309 form a cavity having a total cavity Q of 5 or less, a total cavity Q of 4 or less, a total cavity Q of 3 or less, or any other suitable Q. In some embodiments, at least a portion

of the organic emissive layer 305 is at an antinode of the cavity.

In some embodiments, the metal cathode 309 is selected from the group consisting of Ag, Au, Ag alloys, and/or Au alloys.

In some embodiments, the charge transport layer 307 has a thickness less than 18 nm, less than 15 nm, less than 10 nm, or any other suitable thickness. In some embodiments, the charge transport layer 307 comprises an electron transport layer 307.

In some embodiments, the device 300 further comprises a blocking layer and/or buffer layer 308 between the metal cathode 309 and the charge transport layer 307. In some embodiments, the blocking layer and/or buffer layer 308 prevents diffusion between the metal cathode 309 and the charge transport layer 307. In some embodiments, the blocking layer and/or buffer layer 308 is two or more layers. In some embodiments, at least one layer of the two or more layers is made of Al. In some embodiments, the at least one layer is adjacent to the metal cathode 309. In some embodiments, the at least one layer is less than 3 nm thick. In some embodiments, at least one layer of the two or more layers is Liq (8-Hydroxyquinolinolato-lithium). In some embodiments, the at least one layer is adjacent to the electron transport layer 307.

In some embodiments, an interface is formed between the metal cathode 309 and the charge transport layer 307.

In some embodiments, plasmon exciton polariton strength is a function of the oscillator strength of the metal cathode 309 and the electron transport layer 307.

In some embodiments, a consumer product comprises the device 300 as described above, wherein the consumer product is selected from the group consisting of a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, a light therapy device, and a sign.

In some embodiments, an organic light emitting device (OLED) 300 comprises a substrate 301, a reflector 302 above the substrate 301, a first electrode 303 above the reflector 302, an emissive layer 305 above the first electrode 303, an electron transport layer 307 above the emissive layer 305, and a second electrode 309 above the electron transport layer 307 wherein the electron transport layer 307 and the second electrode 309 are configured to form plasmon exciton polaritons between the second electrode 309 and the electron transport layer 307.

In some embodiments, the device 300 further comprises at least one of a hole blocking layer, electron blocking layer, a hole transport layer, and a hole injection layer (collectively 304) between the first electrode 303 and the emissive layer 305. In some embodiments, the device 300 further comprises a second hole blocking layer 306 between the emissive layer 305 and the electron transport layer 307. In some embodiments, the device 300 further comprises a buffer layer 308 between the electron transport layer 307 and the second electrode 309.

In some embodiments, the reflector 302 comprises a distributed Bragg reflector. In some embodiments, the reflector 302 has a reflectivity in a range of 50-100%, 50-80%, 60-70%, or any other suitable range.

In some embodiments, the OLED 300 includes a cavity between the first electrode 301 and second electrode 309. In some embodiments, the emissive layer 305 is positioned to span an antinode of the cavity.

In some embodiments, the second electrode 309 comprises a metal electrode.

In some embodiments, the emissive layer 305 comprises a blue, green, red, white, infrared, ultraviolet, and/or broad-spectrum emissive layer and/or emissive layer stack comprising a combination of a blue, green, red, white, infrared, ultraviolet, and/or broad-spectrum emissive layers. In some embodiments, the emissive layer 305 comprises a phosphorescent emitter material. In some embodiments, the phosphorescent emitter material is a blue phosphorescent emitter material. In some embodiments, the emissive layer 305 comprises a sensitizer material and an acceptor material and wherein the sensitizer material transfers energy to the acceptor material. In some embodiments, the acceptor material is a fluorescent emitter material. In some embodiments, the sensitizer material is selected from the group consisting of a phosphorescent material or delayed fluorescent material. In some embodiments, the sensitizer material is a blue emissive material. In some embodiments, the fluorescent emitter material can be a delayed fluorescent emitter material.

In some embodiments, the electron transport layer 307 has a large oscillator strength at wavelengths shorter than a triplet emission wavelength of the organic emissive layer. In some embodiments, the electron transport layer 307 has a large oscillator strength at wavelengths 0.1 nm to 1000 nm, 1 nm to 100 nm, 1 nm to 50 nm, 1 nm to 20 nm, 0.1 nm to 15 nm, 0.1 nm to 5 nm, about 1 nm, about 2 nm, about 5 nm, about 10 nm, about 15 nm, about 20 nm, less than 25 nm, or other suitable wavelength shorter than the triplet emission wavelength of the organic emissive layer.

In some embodiments, compared to device C with a conventional Al cathode and an ITO anode, the half cavity device H employs an Ag cathode buffered by a 3 nm thick Al layer supporting enhanced energy transfer to polariton modes. In some embodiments, full cavity device F is identical to H except that it employs a bottom Distributed Bragg

Reflector (DBR) and the top Ag cathode low-Q cavity used to tune the emission color. In some embodiments, low-Q cavities are created by utilizing mirrors or DBRs that aren't as reflective due to fewer mirror/reflector layers and/or material choice. In some embodiments, the DBR has a reflectivity of about 50%-100%, about 50%-80%, or about 60%-70%. The calculated distribution of radiative and nonradiative channels at 465-475nm in the three archetype exemplary $Ir(dmp)_3$ devices is illustrated in the histograms of Fig. 5A, while the optical density of states (ODoS) distributions are shown in Fig. 11A. Compared to the weak energy transfer to the Al SPP in C, the ODoS and the PF are increased via enhanced polariton energy transfer near the Ag/BPyTP2 or Ag/SF3Trz in devices H and F. In some embodiments, the Al buffer layer is used to keep the Ag cathode from diffusing into the ETL. Other materials for the cathode can be used which have a strong plasmonic resonance, such as Au and/or Au for red and infrared OLEDs, Al for UV OLEDs, Ag for visible spectrum OLEDS, and/or Au/Ag alloys such as MgAg. Other materials for the barrier can be used that are transparent to the emission such as organics with a wide band gap energy, polyaromatic hydrocarbons (PAH), and/or oxidative metals such as Cr, Ti, and Ni.

The generation of defects by TPA/TTA is reduced via reducing the triplet density by increasing the radiative rate, which is directly proportional to PF. The defect generation rate is consequently slowed in devices H and F, indicated by the shorter red arrows in Fig. 5A. On the other hand, given the same loss in PL quantum yield, $\eta_{PL}$, a larger defect density is required in devices H and F to match the increased radiative energy transfer, indicated by the larger dashed rectangular area at LT85. This suggests a nonlinear dependence between device lifetime and PF (see Methods). The Ag/DBR cavity mode in F increases the outcoupling efficiency compared to H, corresponding to $k_x/k_0 < 1$, by placing the EML at the antinode of the Ag/DBR cavity mode[4]. Consequently, the Ag/DBR cavity device F features a large PF, an enhanced EQE compared to H, and a narrowed emission spectrum. In some embodiments, the antinode position depends on wavelength of the EML and size of the cavity formed by the DBR 302 and metal cathode 308/309, such as being positioned halfway through the thickness of the cavity. In some embodiments, at least a portion of the EML spans the antinode of the cavity.

Fig. 5B shows time-resolved PL (TrPL) of a 50nm thick $Ir(cb)_3$ EML in structures C, H, and F. Here, $Ir(cb)_3$was studied due to its high $\eta_{PL} = 85 \pm 8\%$ [16] relative to $Ir(dmp)_3$, as well as to understand the generality of the effects. Samples H and F with an Ag cathode have larger k, than those with an Al cathode (C); those with a BPyTP2 ETL have a larger k, than those with SF3Trz, following the trend of the polariton dispersion in Fig. 4. Full Ag/DBR cavity samples show a negligible change compared to half cavities, indicating that the low-Q Ag/DBR cavity mode has little impact on the PF. By increasing energy transfer to SPPs or PEPs in the TM modes, the PL becomes dominated by the horizontally aligned triplets, see Figs 11B-11C. The average PF for isotropic orientation was examined by comparing measurement and simulation, see Figs. 13B-13D. Cavity F using a 15nm thick BPyTP2 ETL results in an average PF = 2.4 $\pm$ 0.2, followed by PF = 1.9 $\pm$ 0.2 and 1.40 $\pm$ 0.03 for F and C devices.

Referring now to Fig. 5C, an exemplary stacked device 400 structure includes stacked EMLs (404, 406) separated by a charge generation layer (CGL) 405. A hole injection layer (HIL) and/or a hole transporting layer (HTL) 403, an electron transporting layer (ETL) 407 and an electron injection layer (EIL) 408 (typically Liq and LiF) is adjacent to the metal electrodes for charge injection.

In some embodiments the EMLs (404, 406) are blue EMLs. The blue EML is typically 60-70nm, and connected to the ETL/cathode, HTL/anode and/or the CGL.

In some embodiments, the EMLs (404, 406) can be any combination of blue EMLs, red EMLs, green EMLs, white EMLs, or other suitable color tint EMLs.

In some embodiments, the thickness of the CGL 405 is fine-tuned to match the metal-metal cavity mode antinodes with the EMLs, where at least a portion of each EML spans at least one cavity antinode.

In some embodiments, the number of EML stacks can be more than two. In some embodiments, only the two EML stacks that connect to the metal electrodes have enhanced stability from polariton-enhanced Purcell effect. In some embodiments, only the two EML stacks closest to the metal electrodes have enhanced stability from polariton-enhanced Purcell effect.

In some embodiments, an organic light emitting device 400 comprises a substrate 401, a first electrode 402 above the substrate 401, an emitter stack 409 above the first electrode 402, and a second electrode 408 above the emitter stack 409. In some embodiments, the emitter stack 409 comprises a charge generation layer 405 between first 404 and second 406 emission layers.

In some embodiments, an organic light emitting device 400 comprises a substrate 401, a first electrode 402 above the substrate 401, two or more emitter stacks 409 above the first electrode 402, and a second electrode 408 above the two or more emitter stacks 409. In some embodiments, each emitter stack 409 comprises alternating emission layers (404, 406) and charge generation layers 405, with emission layers (404, 406) as the top most and bottom most layers.

In some embodiments, a stacked organic light emitting device 400 comprises a substrate 401, a first electrode 402 above the substrate, a second electrode 408 above the first electrode 402, and two or more emission layers (404, 406) employing polariton-enhanced Purcell effects in the regions of the first and second electrodes (402, 408).

In some embodiments, the device 400 further comprises a hole transport layer 403 and/or a hole injection layer 403 between the first electrode 402 and the emitter stack(s) 409. In some embodiments, the hole transport layer 403 and/or hole injection layer 403 is configured to have an absorption tail that overlaps at least a portion of the emission spectrum of one or more triplet controlled emitting materials of the emitter stack 409. In some embodiments, the hole transport layer 403 and/or hole injection layer 403 has a thickness of 1 nm to 40 nm, or about 10 nm, or combined thickness of 5 nm to 40 nm. In some embodiments, the hole transport layer 403 and/or the hole injection layer 403 comprises BCFN, HATCN, and/or a composition of BCFN and HATCN.

In some embodiments, the device 400 further comprises an electron transport layer 407 between the emitter stack 409 and the second electrode 408. In some embodiments, the electron transport layer 407 is configured to have an absorption tail that overlaps at least a portion of the emission spectrum of one or more triplet controlled emitting materials of the emitter stack 409. In some embodiments, the electron transport layer 407 has a thickness of 5 nm to 60 nm. In some embodiments, the electron transport layer 407 comprises BPyTP2.

In some embodiments, the first and/or second electrodes (402, 408) comprise a metal electrode.

In some embodiments, the thickness of the charge generation layer 405 is tuned to match the anti-modes of a metal-metal cavity defined by the first and second electrodes (402, 408) with the first and second emission layers (404, 406) or emitter stack 409. In some embodiments, the charge generation layer 405 has a thickness of 30 nm to 100 nm. In some embodiments, the charge generation layer 405 comprises a first layer with a thickness of 8 nm to 30 nm comprising BPyTP2, a second layer with a thickness of 15 nm to 40 nm comprising a composition of BCFN and HATCN, and a third layer between the first and second layers with a thickness of 12 nm comprising BPyTP2:Li 2%. In some embodiments, the charge generation layer 405 may be made of any combination of layers comprising either BPyTP2, BCFN, HATCN, or BPyTP2:Li 2%, or any combination thereof including any other materials known in the art.

In one embodiment, the first and/or second emission layers (404, 406) are configured to emit blue light. In some embodiments, the first and/or second emission layers (404, 406) each have a thickness of 60 nm to 70 nm. In some embodiments, the first and/or second emission layers (404, 406) may be configured to emit any color light including blue, red, green and/or white.

In some embodiments, the first emission layer 404 and/or second emission layer 406 comprises a first layer with a thickness of 5 nm comprising SiCzCz, a second layer with a thickness of 5nm comprising mSiTrz, and a third layer between the first and second layers with a thickness of 50 nm to 60 nm comprising SiCzCz:SiTrzCz2 (1:1) and PtON-TBBI doped 6-13 vol%. In some embodiments, any emissive layer 404/406 may be made of any combination of layers comprising either SiCzCz, mSiTrz, SiCzCz:SiTrzCz2 (1:1), PtON-TBBI doped 6-13 vol%, or any combination thereof including any other materials known in the art.

In some embodiments, the first emission layer 404 and/or second emission layer 406 comprises a first layer with a thickness of 55 nm to 65 nm comprising mCBP:$Ir(dmp)_3$ doped 18-8 vol%, and a second layer above or below the first layer with a thickness of 5 nm comprising mCBP. In some embodiments, any emissive layer 404/406 may be made of any combination of layers comprising either mCBP:$Ir(dmp)_3$ doped 18-8 vol% or mCBP, or any combination therefore including any other materials known in the art.

In some embodiments, the first electrode 402 comprises an Ag composite electrode. In some embodiments, the first electrode 402 comprises an Ag composite electrode including at least one layer of ITO, Ti, NiCr, Ag, Al, $TiO_2$, or any other suitable material or combinations thereof. In some embodiments, the Ag composite electrode comprises a first layer of thickness 20 nm to 70 nm comprising ITO, a second layer above the first layer with a thickness of 2 nm to 3 nm comprising Ti or NiCr, a third layer above the second layer with a thickness of 15 nm to 20 nm comprising Ag, a fourth layer above the third layer with a thickness of 2 nm to 3 nm comprising Al, Ti, $TiO_2$, or NiCr, and a fifth layer above the fourth layer with a thickness of 5 nm to 20 nm comprising ITO.

In some embodiments, the substrate 401 comprises glass.

In some embodiments, the second electrode 408 comprises Ag/Al/Liq or any combination thereof and has a thickness of 100 nm.

In some embodiments, the device 400 has a lifetime enhancement of at least 10 times, at least 20 times, or at least 30 times compared to a conventional device.

## Combination with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed

herein. Examples of suitable materials are disclosed in U.S. Patent Application Publication No. 2017/0229663, which is incorporated by reference in its entirety.

Conductivity Dopants

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

HIL/HTL

A hole injecting/transporting material to be used in the present disclosure is not particularly limited, and any compound may be used as long as the compound is typically used as a hole injecting/transporting material.

EBL

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

Host

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

HBL

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

ETL

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials

include n and p conductivity dopants used in the transport layers.

As previously disclosed, OLEDs and other similar devices may be fabricated using a variety of techniques and devices. For example, in OVJP and similar techniques, one or more jets of material is directed at a substrate to form the various layers of the OLED.

EXPERIMENTAL EXAMPLES AND METHODS

The invention is further described in detail by reference to the following experimental examples. These examples are provided for purposes of illustration only, and are not intended to be limiting unless otherwise specified. Thus, the invention should in no way be construed as being limited to the following examples, but rather, should be construed to encompass any and all variations which become evident as a result of the teaching provided herein.

Without further description, it is believed that one of ordinary skill in the art can, using the preceding description and the following illustrative examples, make and utilize the system and method of the present invention. The following working examples therefore, specifically point out the exemplary embodiments of the present invention, and are not to be construed as limiting in any way the remainder of the disclosure.

Figures 6A-6B show the EQE and electroluminescent (EL) spectrum of devices C1-3 and F1-3 employing a cyan-emitting mCBP:Ir(dmp)$_3$graded EML with $\eta_{PL} = 44 \pm 1\%$[10,11] (see Table 1 for device performance data). Structure 1 employed a 17 nm thick SF3Trz ETL featuring only SPP energy transfer, while 2 and 3 employed 17 nm / 25 nm thick BPyTP2 ETL for PEP energy transfer. F1 has PF = 1.9 $\pm$ 0.2, and shifts the CIE coordinates of C1 from (0.16, 0.26) to (0.14, 0.14) while maintaining the same EQE. With a similar ETL thickness, device F2 has PF = 2.4 $\pm$ 0.2 and shifts the CIE coordinates to (0.14, 0.18), whereas it suffers from EQE loss due to the strong energy transfer to PEPs. The ETL thickness of F3 is optimized to balance the trade-off between PF and EQE, resulting in PF = 2.0 $\pm$ 0.2, a deep blue color of CIE = (0.15, 0.20) and a peak EQE = 10.4 $\pm$ 0.5%, compared to the corresponding device C3 with EQE = 9.9 $\pm$ 0.1% and CIE = (0.16, 0.27). In some embodiments, the product of EQE and the Purcell factor can be used in layer thickness optimization, such that EQE, PF, or their product is optimized based on needed device characteristics. Given that surface polariton modes exponentially decay in the out-of-plane direction, the PEP-enhanced F3 with a thicker ETL still features a slightly higher PF than the SPP-enhanced F1 along with a 45% increase in outcoupling efficiency. Besides converting the cyan emission into the deep blue, the low-Q Ag/DBR cavity mode has only a small impact on the angular dependence of the emission spectrum, shown in F2 in Fig. 6C. The angular dependence of the emission intensity of F2 differs only slightly from C2 (see inset). From C to F, the current-voltage characteristics show no change in devices using the same ETL, see Fig. 12D indicating there is no power penalty associated with this device design.

Fig. 6D shows the operational lifetime of F1-3 compared to C1-3. Aged at a current density of J = 7 mA/cm$^2$ (corresponding to an initial luminance of $L_0$ ~ 1000 cd/m$^2$ for cyan-emitting C3, see Table 1) a 4.4X enhancement in LT90 is achieved from the most strongly Purcell-enhanced F2 from C2, compared to 2.5X for F1 versus C1 and 2.2X from F3 to C3. Fig. 7A summarizes the Ir(dmp)$_3$ device operational lifetime versus the calculated average PF. From LT90 to LT70, the power law between the operational lifetime versus PF decreases from m = 2.4 $\pm$ 0.3 to m = 1.7 $\pm$ 0.3, suggesting contributions from both TPA and TTA to aging. Apparently, extending device operational lifetime via increasing the radiative decay rate, $k_r$, is most effective early in the aging process. As time progresses, triplets are decreasingly affected by the Purcell effect due to increased fraction of nonradiative quenching by the rising population of defects (see Eq. 2).

Fig. 7B summarizes the device performance achieved by the polariton-enhanced Purcell effect, compared to that of the conventional Ir(dmp)$_3$ device C1 with the lowest PF. The enclosed triangular areas are proportional to the total number of equivalent deep blue photons emitted throughout the device lifetime. Device F1 achieves the deepest blue color and a 2.7X increase from C1 in lifetime, while maintaining the same EQE as C1. Device F2 achieves the longest LT90, a 5.3X increase from C1. However, the EQE is slightly reduced due to the strong, competing energy transfer to PEPs. Device F3 has the highest EQE = 10.4 $\pm$ 0.5% and achieves a 4X increase in LT90. Devices F1-3 reach the best performance along each axis. Therefore, the introduction of PEPs in low-Q cavities significantly increases total deep blue photon output throughout the device lifetime while loosening the usual trade-off between device lifetime, color, and efficiency that characterizes conventional devices.

Fig. 7C compares the normalized LT90 vs. CIE$_y$ from this work with previously reported blue Ir-complex-based PHOLEDs. Here, the normalized LT90 is calculated under a standard photon exitance $M_{p,0}$ = EQE $\times$ J, equivalent to a device with initial EQE = 25% aged at J = 2 mA/cm$^2$, or an initial luminance $L_0$ = 1000 cd/m$^2$ for a cyan-emitting device with CIE = (0.17, 0.32) (see Table 1). A small CIE$_y$ coordinate is required for a blue pixel to reach the full color gamut in displays, although the normalized LT90 shows an exponential decrease in the total number of outcoupled photons during the device lifetime with CIE$_y$ due to a corresponding increase in exciton energy. As above, this results in a greater potential for excitons to engage in destructive bimolecular annihilation. Thus, as commonly observed, deeper blue devices have substantially shorter lives than cyan-emitting PHOLEDs, making the challenge of achieving adequate lifetimes for deep blue devices increasingly more difficult.

Past demonstrations have reduced the effects of energetically-driven degradation via spatial spreading of the triplet density profile by grading the EML doping or using mixed co-hosts in the EML, besides increasing chemical stability or steric hindrance to close packing of dopants and hosts to prevent their fragmentation. These efforts have increased the normalized LT90 from conventional, single host, uniformly doped devices by one order of magnitude. Based on previous graded-doped devices, the disclosed method further achieves a three-fold increase in LT90 and a shift of $\Delta CIE_y = -0.09 \pm 0.03$, representing a conservative estimate 14-fold improvement of F1 over similarly deep blue Ir-based PHOLEDs. F1 represents the longest-lived deep blue PHOLEDs with $CIE_y < 0.15$. Moreover, by tuning PF and EQE of the Ag/BPyTP2 PEP-enhanced $Ir(dmp)_3$ device F3 via adjusting the ETL thickness, we achieved a normalized LT90 = 140 $\pm$ 20 h with CIE = (0.15, 0.20), which is apparently the most stable blue Ir-based PHOLED reported to date.

Since the cavity design is independent of the host matrix and emitter composition, it can be applied to a variety of structures and other triplet-dominated devices, including those based on exciplex forming cohost matrices. For example, a deep blue, exciplex-forming co-host $Ir(cb)_3$ device achieved a 3.4-time device lifetime improvement compared to the control, see Fig. 13B. Also, the fabrication of the bottom and the top cavity structures are non-intrusive of the OLED layers while following standard OLED fabrication and general lithography processes. The solutions presented here for bottom emitting devices can equally be applied to top emitting PHOLEDs with suitable changes in the cavity structure.

In summary, the Purcell effect in PHOLEDs is significantly enhanced by polaritons through the plasmon-exciton polaritons (PEPs), thereby dramatically extending the operational lifetime of deep blue devices while maintaining a high EQE. Polariton dispersion and cavity engineering provides new degrees of freedom for the design of OLEDs. For example, an average Purcell factor of 2.4 $\pm$ 0.2 via PEPs was achieved, leading to a maximum 5.3X lifetime enhancement compared to analogous, conventional PHOLEDs. By introducing a weak cavity mode using a bottom DBR, a color shift was achieved from cyan to deep blue for Purcell-enhanced $Ir(dmp)_3$ devices without decreasing EQE or introducing noticeable angle dependence to the emission color. Compared to similar devices with the same emission color, a conservative estimate of 10-14 times increase was achieved in normalized LT90 which is the longest-lived blue Ir-based PHOLEDs yet reported. A 1.7-2.4 power law dependence was demonstrated between the device operational lifetime and PF, showing the potential of this technique for significantly prolonging PHOLED lifetimes, particularly in the deep blue as useful for both display and lighting applications.

Strong light-matter interactions of polaritons increase the total ODoS by introducing an anti-crossing between the ETL singlet exciton energy and the resonant optical modes. The anti-crossing shifts the polariton dispersion to be resonant with blue triplet emission. According to Fermi's golden rule, the triplet radiative decay rate is:

$$k_r = \frac{2\pi}{\hbar} \sum_{\hbar\omega_0, p} \left|\hat{\mu}_{\omega_0, p}\right|^2 \rho_p(r_0, \omega_0). \qquad (1)$$

Here, $\hat{\mu}_{\omega 0,p}$ and h are the triplet transition dipole moment matrix element and the reduced Planck's constant, respectively. The triplets transfer energy to the polaritons in the weak coupling regime due to their low oscillator strength, which is proportional to $|\hat{\mu}_{\omega 0,p}|^2$. In the weak coupling regime, PF is proportional to the ODoS. For planar OLEDs, the ODoS is determined by the dyadic Green's function $G(r_0, r_0; \omega_0)$ by $\rho_p(r_0, \omega_0) \propto n_p \cdot Im[G(r_0, r_0; \omega_0)] \cdot n_p \propto \Sigma_k |u_{k,p}|^2 \delta(\omega_k - \omega_0)$, which is a function of the dispersion relation, $\omega_{k,}$ for multimode expansion $u_{k,p}$ with modal wavevector, k, and dipole orientation, p, (horizontal or vertical in cylindrical coordinates, depicted by the unit vector $n_p$). The PEPs and Ag-enhanced SPPs have a larger mode density $|u_{k,p}|^2$ integrating over the high-$k_x$ region. PF is primarily controlled by the energy transfer rate to the polaritons at the metal/ETL interface. The PEP is due to coupling of excitons in the ETL with SPPs on the metal cathode. ETLs such as BPyTP2, with a large extinction coefficient of 0.95 $\pm$ 0.05 at a wavelength of l = 345 nm, and an energy gap of 3.0 eV. This results in strongly coupled PEPs with Ag or Al plasmon modes, see Fig. 4 and Fig. 9. Compared to the conventional Al cathode, Ag has an absorption band starting from 3.8 eV that leads to the flattening of the high-$k_x$ plasmon modes.

The Purcell effect prolongs the device operational lifetime by reducing the triplet density, thus slowing defect generation (and hence nonradiative quenching) via TPA and TTA. Device degradation is a function of the decreasing PL quantum yield, $\eta_{PL}$:

$$\eta_{PL}(t) = \frac{k_r}{k_{tot}} = \frac{PF\, k_{r0}}{PF\, k_{r0} + k_{nr} + K_{QN} Q(t)} \qquad (2)$$

$$\frac{dQ(t)}{dt} = K_{TPA}N(t)n(t) + K_{TTA}N(t)^2 + \text{etc.} \quad (3)$$

Here, $k_{tot}$, $k_{nr}$, $K_{TPA}$, $K_{TTA}$ and $K_{QN}$ are the total decay rate, the natural nonradiative decay rate, the defect generation rates due to TPA, TTA, and the bimolecular quenching rate between the triplets of density, N, and the defects of density, Q, respectively. For a phosphor with $\eta_{PL}$ ~ 100%, the Purcell effect reduces the initial triplet density by 1/PF. This, in turn, reduces the initial rate of defect generation induced by TPA or TTA by 1/PF or $1/PF^2$, respectively . Moreover, for the same $\eta_{PL}$ loss, a larger defect density is required to match the increased radiative decay rates equivalent to that required prior to aging. The slowed defect generation and reduced quenching give rise to a power law m > 1 between the lifetime enhancement and PF in Eqs. (2)-(3).

Vertical dipoles only excite transverse magnetic (TM) modes, and thus are inefficiently outcoupled, while the horizontal (in-plane) dipoles couple to both transverse electric (TE) and TM modes. Since PEPs and SPPs are TM-polarized, the vertical dipoles share a higher PF than horizontal dipoles, with a local maximum of PF = 7.5 nearest to the cathode (see Fig. 11B). As a result, the TM-polariton-enhanced Purcell effect reduces the probability of annihilation of inefficiently outcoupled triplets with vertical transition dipole moments.

This is consistent with TrPL measurements in Fig. 5B and Fig. 11C. With increasing TM-polariton energy transfer, the contrast in PF between vertical and horizontal dipoles diverges, such that the outcoupled PL signal is eventually dominated by horizontal dipoles. To estimate the actual PF, we calculate its value assuming isotropic dipoles averaged over the 50 nm thick EML.

The measured PL transients in Fig. 5B show a negligible change in low-Q Ag/DBR cavities. This is consistent with the dominance of the polariton ODoS, among outcoupled, substrate and waveguided modes in Fig. 11A. Due to the near-field nature of surface modes, the average PF is primarily controlled by the ETL thickness.

The ETL is chosen for its large oscillator strength at wavelengths slightly shorter than the triplet emission wavelength. Therefore, the LP branch of the PEP is redshifted from the bare SPP due to its anti-crossing behavior. The dispersion and ODoS are tuned by the thickness of the ETL using transfer matrix and Green's function simulations. A higher ETL exciton energy than the dopant triplet energy prevents exciton leakage via Förster or Dexter energy transfer from the triplets, which reduces PHOLED efficiency. However, an ETL exciton energy close to the triplet energy increases the overlap between the PEP LP dispersion and the triplet emission spectra, leading to a large ODoS at the emission wavelengths. Therefore, an efficient ETL exciton with large oscillator strength at wavelengths slightly shorter than the triplet emission wavelength is optimal for exciting PEP-enhanced Purcell effects.

In Fig. 4, the PEP of a 20 nm Al/20 nm BPyTP2 bilayer is identified by angle-dependent reflectance spectroscopy. The measured Al/BPyTP2 PEP dispersions are extracted from the local minima with the linear background subtracted in Fig. 9 and fit to the coupled oscillator model:

$$\hat{H}(k_x/k_0) = \begin{pmatrix} E_{SPP} & g_1 & g_2 & g_3 \\ g_1 & E_{ex1} & 0 & 0 \\ g_2 & 0 & E_{ex2} & 0 \\ g_3 & 0 & 0 & E_{ex3} \end{pmatrix} \quad (4)$$

Here, $E_{SPP}$ is the bare SPP dispersion, and $g_1$, $g_2$, and $g_3$ are the coupling strengths between the SPP mode and BPyTP2 0-0, 0-1, and 0-2 exciton vibronic states, respectively. The strongly coupled PEP is identified by the anti-crossing between the bare SPP dispersion and the exciton, with a Rabi splitting energy of $\Omega_i = \sqrt{4g_i^2 - \left(\Gamma_{ex,i} - \Gamma_{SPP}\right)^2}$, (i = 1,2,3), that is larger than the linewidths of the SPP mode and the exciton ($\Gamma_{SPP} + \Gamma_{ex,i}$). Here, $g_1$ and $g_2$ obtained from the spectral fits are 0.64 $\pm$ 0.05 eV and 0.70 $\pm$ 0.05 eV, respectively. The linewidths extracted from the extinction coefficients and SPP angle-resolved reflection measurements are $\Gamma_{ex,\,0\text{-}0}$ = 0.48 $\pm$ 0.01 eV, $\Gamma_{ex,\,0\text{-}1}$ = 0.50 $\pm$ 0.01 eV and $\Gamma_{SPP}$ = 0.3 $\pm$ 0.1 eV. The Rabi splitting energies for the 0-0 exciton and the 0-1 excitons are 1.3 $\pm$ 0.1 eV and 1.4 $\pm$ 0.1 eV, confirming that the strong coupling regime is reached.

Operational lifetime improvements have also been found for PHOLEDs employing the deep blue but relatively short-lived phosphor, $Ir(cb)_3$, in a mixed co-host mCBP:SiTrzCz2 EML . See Data Table 1 and Fig. 13B for detailed lifetime data. $Ir(cb)_3$ devices C4-6 feature Al/BPyTP2 PEPs, whereas H5-6 interact with Ag/BPyTP2 PEPs. All $Ir(cb)_3$ devices are aged at J = 5 mA/cm$^2$. Among $Ir(cb)_3$ devices, structures 4-6 employ a BPyTP2 ETL with thicknesses reduced from 40nm to 15nm for enhanced ET to the PEPs. Increasing the near-field energy transfer to Al/BPyTP2 PEP by reducing the ETL thickness doubles the device lifetime from C4 to C5 and C6. In contrast, when the ETL thickness is

reduced from 20 nm to 15 nm and the PF is increased from 2.1 ± 0.2 to 2.4 ± 0.2 for H5 to H6, the operational lifetime is increased from 2.1 ± 0.1 to 3.4 ± 0.1 times compared to C4. The similar device lifetime of C5 and H5 with different PFs may be due to other factors introduced to the $Ir(cb)_3$ devices by changing the cathode. Nevertheless, the Purcell effect enhanced by Ag/BPyTP2 PEPs in H6 still significantly prolongs the device lifetime. Compared to the lifetime enhancement, the EQE only shows a moderate decrease for H5 and H6 due to energy transfer to Ag/BPyTP2 PEP, while the emission color is saturated with a shift of $\Delta CIE_y$= -0.1, see Figs. 13C-13D and Table 1. The current-voltage characteristics show no change, see Fig. 13E.

PHOLEDs were grown on glass substrates with pre-patterned bottom electrodes that were solvent-cleaned and treated by UV-ozone plasma for 15 min. For full cavity devices, the DBRs were grown by plasma-enhanced chemical vapor deposition (PECVD) at a temperature of 200°C. The 50-60 nm thick indium-tin-oxide (ITO) layer was deposited via magnetron sputtering in an Ar plasma with a partial pressure of 2 mTorr at a deposition rate of 1.5 Å/s. The thickness and number of pairs of the DBR are iterated to match the linewidth and spectral overlap of the phosphor emission spectrum. The $SiN_x/SiO_2$ layer thicknesses are 56nm/80nm targeted at a central wavelength of 465nm, with 10% variation from batch to batch. The thicknesses of the ITO and $SiN_x$ capping layer are iterated to align the cavity modes with the phosphor emission spectrum. The ITO is rapid thermal annealed at 450°C under forming gas for 3 min (20-40 Ω/sq). The ITO is wet-etched in HCl: $H_2O$ (1:1 volume ratio) for 16 min with the electrode pattern protected by 3 μm thick S1813 photoresist. The organic layers are deposited by thermal evaporation in a vacuum chamber with a base pressure < $10^{-7}$ torr.

The materials used, some of which are shown in Fig. 8 are: 2-(9,9'-spirobi[fluoren]-3-yl)-4,6-diphenyl-1,3,5-triazine (SF3Trz) 17 nm / 3,3'-Di(9H-carbazol-9-yl)-1,1'-biphenyl (mCBP) 5 nm / mCBP: iridium (III) tris[3-(2,6-dimethylphenyl)-7-methylimidazo[1,2-f] phenanthridine] ($Ir(dmp)_3$) 18-8 vol.% graded / N,N'-Di(1-naphthyl)-N,N'-diphenyl-(1,1'-biphenyl)-4,4'-diamine (NPD) + Dipyrazino[2,3-f:2',3'-h]quinoxaline-2,3,6,7,10,11-hexacarbonitrile (HATCN) 10 nm; 2,7-Di(2,2'-bipyridin-5-yl)triphenylene (BPyTP2) 17 nm / mCBP 5 nm / mCBP: $Ir(dmp)_3$ 18-8 vol.% graded / NPD + HATCN 10 nm. BPyTP2 25 nm / mCBP 5 nm / mCBP: $Ir(dmp)_3$ 18-8 vol.% graded / NPD + HATCN 10 nm; BPyTP2 40nm / 9,9'-(6-(3-(triphenylsilyl)phenyl)-1,3,5-triazine-2,4-diyl) bis(9H-carbazole) (SiTrzCz2) 5 nm / mCBP: SiTrzCz2: fac-tris(5-(tert-butyl)-1,3-diphenyl2,3-dihydro-1H-imidazo[4,5-b]pyrazine)iridium] ($Ir(cb)_3$) (40:40:20 vol. %) 50 nm / mCBP 5 nm / NPD 5 nm / HATCN 5nm; and BPyTP2 20nm / SiTrzCz2 5nm / mCBP: SiTrzCz2: $Ir(cb)_3$ (40:40:20 vol. %) 50nm / mCBP 5nm /NPD 5nm / HATCN 5nm; BPyTP2 15nm / SiTrzCz2 5nm / mCBP: SiTrzCz2: $Ir(cb)_3$ (40:40:20 vol. %) 50nm / mCBP 5nm /NPD 5nm / HATCN 5nm.

The cathodes are deposited using a thin metal shadow mask to define the 2 $mm^2$ device active area. All Al layers are deposited first at a rate of 0.1 Å/s up to a thickness of 50 Å, and then at 1 Å/s until 100 nm total thickness is reached. All Ag layers are deposited at a rate of 0.1 Å/s up to a thickness of 150 Å, and then at 0.6 Å/s until 100 nm total thickness is reached. The devices are encapsulated by a glass cover attached to the substrate using a bead of UV-cured epoxy around its periphery in a $N_2$ environment with $O_2$ / $H_2O$ concentrations < 0.1 ppm.

The J-V, luminance and EQE characteristics are measured using a semiconductor parameter analyzer (B1500A, Keysight Technologies) and a calibrated, large-area photodiode (S3584-08, Hamamatsu Photonics) collecting all photons in the forward-viewing direction following standard procedures to eliminate errors due to the angular dependence of emission. The electroluminescence (EL) spectra are measured via a fiber-coupled spectrometer (USB4000, Ocean Optics, Inc.). The EQE data are taken from at least two different batches with at least two devices in each batch.

Device operational lifetime is measured at a constant current density and room temperature. The luminance data are collected via automated source-measurement units (SMUs, Agilent, U2722 and Agilent, 34972A). Lifetime data are taken from at least two different batches comprising at least two devices.

Operational lifetime of $Ir(dmp)_3$ and $Ir(cb)_3$ devices are fit to a stretched exponential: $L(t)/L_0 = \exp[-(t/t_0)^\beta]$. The fitting parameters $t_0$ and $\beta$ are listed in Table 2.

To compare PHOLEDs employing different phosphors, emission spectra and device structures in the literature, device operational lifetime data was normalized to an empirical acceleration model:

$$\mathrm{LTx}(\mathrm{M_{p,0}}) = \mathrm{LTx}(\mathrm{M_{p,test}}) \cdot \left[\frac{\mathrm{M_{p,test}}}{\mathrm{M_{p,0}}}\right]^{n} \quad (5)$$

Here, $M_p$ = EQE × J is the initial photon exitance of the device and n is the acceleration factor. $M_{p,test}$ is the initial photon exitance at the test condition, and $M_{p,0}$ is the initial photon exitance close to the mean of the reference data. We adopt an acceleration factor n = 1.8 ± 0.2.

Given the same phosphor and emission spectra, the luminance of the device is directly proportional to the photon exitance. Therefore, normalizing to the initial photon exitance provides the bridge between the energy-based, physical degradation process and the usual photometric standard. In this study, all lifetime data was normalized to $M_{p,0}$

= 25% × 2 mA/$cm^2$, equivalent to a PHOLED with EQE = 25% aged at 2 mA/$cm^2$. For a cyan-emitting device with $CIE_y$ ~ 0.30 [13,20], this corresponds to an initial luminance of $L_0$ = 1000 cd/$m^2$.

The TrPL measurements use a 50 nm thick mCBP: SiTrzCz2:Ir$(cb)_3$ (40:40:20 vol. %) EML due to its high $\eta_{PL}$ = 85 ± 8%[16]. The optical structures are: 100 nm metal/ × nm ETL/ 5 nm SiTrzCz2/ 50nm mCBP: SiTrzCz2:Ir$(cb)_3$ (40:40:20 vol. %) /5nm mCBP/ 10nm HATCN /50 nm ITO or 50-60nm ITO/DBR (15nm $SiN_x$/80 nm $SiO_2$/56 nm $SiN_x$/80 nm $SiO_2$/56 nm $SiN_x$).

The TrPL data for the full device structures are collected via a time-correlated single-photon counter (PicoHarp 300, PicoQuant) coupled to a microscope (Eclipse Ti2, Nikon). The pump laser (P-C-405, PicoQuant) wavelength is 405nm, with a repetition rate of 10 kHz, a pump power < 1nW and a beam diameter of 0.5μm. The pump wavelength is selected to reach the maximum ratio of the phosphor-to-background emission in other organic layers such as BPyTP2. After the prompt emission, the slowly decaying TrPL data are fit using:

$$\frac{dN}{N_0 dt} = \frac{1}{\tau}\frac{N}{N_0} + K_{TT}\left(\frac{N}{N_0}\right)^2 \qquad (6)$$

Here, τ, $K_{TT}$ and $N_0$ are the PL lifetime of the phosphor, triplet-triplet quenching rate, and the initial triplet density, respectively. The pump power is selected such that $\tau K_{TT} N_0$ « 10% to avoid the effects of the bimolecular quenching.

Angle-resolved reflectance is measured using ellipsometry (Woollam 2000, Woollam). The structures for Fig. 4 are: ETL 20nm / Al 20nm and ETL 20nm / Ag 40nm on a UV-fused silica prism coupler. The transfer matrix method is used to model the angle-resolved reflection of the multilayer structures.

The angle-resolved PL spectra in Figs. 4 and 6C are obtained using an oil-immersion objective (×100, NA=1.40, Olympus) and a 4f Fourier-imaging system (f = 200mm). The Fourier image of the reflection and PL signal passes through an analyzer, reconstructed on the charge coupled device (PIXIS 1024B, Teledyne Princeton Instruments) and resolved by a spectrograph (HRS500, Teledyne Princeton Instruments). All angle-resolved PL spectra in Fig. 4C are pumped by a 405 nm wavelength, 1 kHz ns-pulsed laser with a fluence of 1 J/$cm^2$ and integrated for 1 min. The signal is filtered by a 425 nm long-pass filter placed before the monochromator.

Optical constants are measured from 250 -1700 nm using an ellipsometer (Woollam 2000, Woollam) and averaged over several thin films (20 - 50 nm) on Si/$SiO_2$ substrates fit to B-spline and general oscillator models. The extinction coefficient, k, is iterated by comparing it to the UV-Vis spectra (Perkin Elmer 1050) of the same thin films on sapphire substrates.

The dyadic Green's function method follows Celebi et al. based on a dipole embedded in a multilayer structure. The OLED structure determines the multimode expansion of the Green's function, and thereby, the electrical field and OdoS. The dissipated power, simulated by taking the real part of the Poynting vector, is proportional to the decay rate of the dipole, and thus proportional is to the OdoS. Based on the in-plane wavevector $k_x/k_0$, the optical modes are outcoupled modes (including outcoupled cavity modes), substrate modes, waveguide modes, and SPP/PEP modes, among others. Therefore, the Purcell factor and energy transfer rates are calculated through the OdoS and dissipated radiative power of each mode. The PF is the total OdoS, $\rho_{tot}(\omega_k)$, of a dipole normalized by that of a dipole in an isotropic, infinite medium of the EML. The outcoupling efficiency is calculated from the dissipated power through modes with $k_x/k_0$ < 1 normalized to the total OdoS $\rho_{tot}(\omega_k)$. The average PF of each device is calculated from the overlap of the emission spectra of Ir$(dmp)_3$ and a uniform exciton spatial distribution assuming isotropic dipole orientation. The energy transfer rates of each dissipation channel in Fig. 3a are calculated from measured EQE, PLQY, EL spectra and the calculated average PF, where the ratio of natural radiative to natural nonradiative decay rates is $k_{r,0} : k_{nr} = \eta_{PL} : 1- \eta_{PL}$, outcoupling efficiency is $\eta_{out} = EQE_{max}$/ PLQY assuming perfect charge balance, outcoupled and high $k_x$ radiative channel coupling rates of $k_{r,out}=PF\times\eta_{out}$ and $k_{r,high}=PF\times(1-\eta_{out})$.

Stacked devices were also experimentally studied. First, plasmon-exciton polaritons (PEPs) were demonstrated at the interface of metal/transporting layers (electron transporting layer, ETL, and hole transporting layer, HTL). Two exemplary ETL and HTL materials showed the PEPs. The PEPs featured a flat dispersion in the lower polariton branch, and a high optical density of states (OdoS) in the blue visible region. The polariton dispersion and OdoS was engineered to match the final emitter spectrally in the near-field to maximize the radiative decay rates. Second, the metal-metal cavity was designed for optimizing outcoupling efficiency and the polariton-enhanced Purcell effect by placing the emission layers (EMLs) at the antinodes of metal-metal cavity mode and close to the metal surface.

An example of a stacked blue OLED using Purcell effect enhancement that was explored comprised of Ag 100nm /Al 3nm/ Liq 1.5nm/ BpyTP2 15-20nm/ mSiTrz 5nm/ SiCzCz:SiTrzCz2 (1:1):PtON-TBBi 6-13 vol% 50-60nm /SiCzCz 5nm/BCFN 5-30 nm/HATCN 10nm/BpyTP2:Li 50:50 mol % 12nm / BpyTP2 8-30 nm/ mSiTrz 5nm/ SiCzCz:SiTrzCz2 (1:1):PtON-TBBi 6-13 vol% 50-60nm /SiCzCz 5nm/BCFN 5nm/ HATCN 5nm/ ITO 5-20nm /Al, Ti, $TiO_2$ or NiCr 2-3nm/Ag 16-20nm/ Ti, $TiO_2$ or NiCr 2-3nm/ITO 20-70nm/Glass.

Another example of a stacked blue OLED using Purcell effect enhancement that was explored comprised of Ag 100nm /Al 3nm/ Liq 1.5nm/ BpyTP2 15-20nm/ mCBP 5nm/ mCBP:Ir(dmp)$_3$ doped 18-8 vol% 50-60nm /BCFN 5-30 nm/HATCN 10nm/BpyTP2:Li 50:50 mol % 12nm / BpyTP2 8-30 nm/ mCBP 5nm/ mCBP:Ir(dmp)$_3$ doped 18-8 vol% 50-60nm /BCFN 5nm/ HATCN 5nm/ ITO 5-20nm /Al, Ti, $TiO_2$ or NiCr 2-3nm/Ag 16-20nm/Ti, $TiO_2$ or NiCr 2-3nm/ITO 20-70nm/Glass.

The ETL, HTL and/or HIL had large extinction coefficient right above 400-450 nm, typically in the range of 300-400 nm. The criteria for the large extinction coefficient are when the material is adjacent to the metal electrode, an anti-crossing forms between the metal electrode surface plasmon polaritons (SPPs) and the material excitonic absorption, forming plasmon-exciton-polaritons (PEPs). Such materials include BpyTP2 (ETL), BCFN (HTL), and anthracene-based ETL material including MADN, ZADN and TBADN etc. Examples of PEPs are in Figs. 14A-14F.

The stacked device lifetime enhancement originated both from the Purcell effect and lower driving current density by stacking EMLs. The simulated Purcell factor and outcoupling efficiency are shown in Figs. 15A-15C. The optimized Purcell factor was >2.4 and outcoupling efficiency was >25%. Previous reports show a PF=2.4 can increase a single stacked PHOLED lifetime by 12 $\pm$ 2 times and a double stacked PHOLED lifetime with no Purcell enhancement by 3 times. Since the two techniques are uncorrelated, the predicted device lifetime enhancement is 36X. The cavity mode in Fig. 15C further saturates the emission color to CIE = (0.13, 0.09) for cyan-emitting Ir(dmp)$_3$. A chromatic coordinate of Commission Internationale de l'eclairage y coordinate of $\Delta CIE_y$=-0.1 corresponds to approximately 7X increase, see Fig. 16. Therefore, the lifetime enhancement via the PEP-enhanced stacked PHOLED is estimated from 36X to 200X.

Table 1:

| No. | Phosphor | Optical Structure | $EQE_{max}$ (%) | Calc. $PF_{avg}$ | CIE | L0 (cd/m$^2$) | LT90 (h) | LT80 (h) | LT70 (h) |
|---|---|---|---|---|---|---|---|---|---|
| | | | | | | at 7ma/cm$^2$ | | | |
| C1 | Ir(dmp)$_3$ | Al/SF3Trz 17nm/... /ITO | 7.2 $\pm$ 0.1 | 1.4 $\pm$ 0.1 | (0.16, 0.26) | 770 $\pm$ 10 | 28 $\pm$ 3 | 93 $\pm$ 4 | 208 $\pm$ 3 |
| H1 | | Ag/SF3Trz 17nm/... /ITO | 6.5 $\pm$ 0.1 | 2.0 $\pm$ 0.2 | (0.16, 0.26) | 750 $\pm$ 10 | 79 $\pm$ 5 | 211 $\pm$ 5 | 387 $\pm$ 5 |
| F1 | | Ag/SF3Trz 17nm/... /DBR | 7.4 $\pm$ 0.2 | 1.9 $\pm$ 0.2 | (0.14, 0.14) | 500 $\pm$ 20 | 76 $\pm$ 5 | 217 $\pm$ 5 | 400 $\pm$ 10 |
| C2 | | Al/BpyTP2 17nm/... /ITO | 7.6 $\pm$ 0.1 | 1.5 $\pm$ 0.1 | (0.16, 0.25) | 880 $\pm$ 10 | 36 $\pm$ 3 | 132 $\pm$ 5 | 286 $\pm$ 3 |
| H2 | | Ag/BpyTP217nm/... /ITO | 6.5 $\pm$ 0.1 | 2.4 $\pm$ 0.2 | (0.17, 0.28) | 800 $\pm$ 10 | 110 $\pm$ 10 | 360 $\pm$ 10 | 600 $\pm$ 20 |
| F2 | | Ag/BpyTP217nm/... /DBR | 6.3 $\pm$ 0.3 | 2.4 $\pm$ 0.2 | (0.14, 0.18) | 530 $\pm$ 20 | 160 $\pm$ 20 | 430 $\pm$ 20 | 700 $\pm$ 30 |
| C3 | | Al/BpyTP2 25nm/... /ITO | 9.9 $\pm$ 0.1 | 1.4 $\pm$ 0.1 | (0.16, 0.27) | 1030 $\pm$ 10 | 50 $\pm$ 5 | 171 $\pm$ 5 | 360 $\pm$ 5 |
| H3 | | Ag/BpyTP225nm/... /ITO | 9.0 $\pm$ 0.1 | 2.0 $\pm$ 0.2 | (0.17, 0.32) | 1000 $\pm$ 10 | 77 $\pm$ 5 | 251 $\pm$ 5 | 470 $\pm$ 20 |
| F3 | | Ag/BpyTP225nm/... /DBR | 10.4 $\pm$ 0.5 | 2.0 $\pm$ 0.2 | (0.15, 0.20) | 800 $\pm$ 50 | 110 $\pm$ 10 | 270 $\pm$ 10 | 430 $\pm$ 20 |

(continued)

| | | | | | | at 5 ma/cm$^2$ | | | |
|---|---|---|---|---|---|---|---|---|---|
| C4 | Ir(cb)$_3$ | Al/BpyTP2 40nm/... /ITO | 20.4 ± 0.5 | 1.4 ± 0.1 | (0.14, 0.26) | 1350 ± 20 | 1.6 ± 0.1 | 4.6 ± 0.1 | 9.6 ± 0.1 |
| C5 | | Al/BpyTP2 20nm/... /ITO | 18.0 ± 0.2 | 1.5 ± 0.1 | (0.14, 0.15) | 1050 ± 20 | 3.4 ± 0.1 | 9.9 ± 0.1 | 20.1 ± 0.1 |
| H5 | | Ag/BpyTP2 20nm /... /ITO | 16.4 ± 0.2 | 2.1 ± 0.2 | (0.14, 0.17) | 1020 ± 20 | 2.9 ± 0.1 | 9.6 ± 0.2 | 20.0 ± 0.3 |
| C6 | | Al/BpyTP2 15nm/... /ITO | 16.0 ± 0.1 | 1.6 ± 0.1 | (U. 14, 0.14) | 910 ± 20 | 2.7 ± 0.1 | 9.0 ± 0.1 | 18.7 ± 0.1 |
| H6 | | Ag/BPyTP2 15nm /... /ITO | 15.9 ± 0.2 | 2.4 ± 0.2 | (0.14, 0.16) | 930 ± 20 | 5.3 ± 0.1 | 14.9 ± 0.1 | 29.3 ± 0.1 |

Table 1 Notes:

- See Fig. 10 for details of the Optical structures.
- For $EQE_{max}$ the natural photoluminescence quantum yield of the bare EML is $\eta_{PL,0}$ = 85 ± 8% [16] for Ir(cb)$_3$ and $\eta_{PL,0}$ = 44 ± 1% [11] for Ir(dmp)$_3$.
- For Calc. $PF_{avg}$ the average Purcell factors $PF_{avg}$ is calculated by averaging across a triplet ensemble with isotropic dipole orientation: $PF_{avg}$ = 2/3 $PF_{horiz.}$+ 1/3 $PF_{vert.}$. Here, PFs of horizontal and vertical dipoles are $PF_{horiz.}$ and $PF_{vert.}$, respectively.
- For LT90, LT80, and LT70, the device lifetime data at constant current density are extracted from Figs. 12E and 13B.

Table 2:

| No. | Phosphor | Stretched Exp Model | |
|---|---|---|---|
| | | τ(h) | β |
| C1 | Ir(dmp)$_3$ | 900 ± 40 | 0.67 ± 0.01 |
| H1 | | 1600 ± 40 | 0.77 ± 0.01 |
| F1 | | 1650 ± 60 | 0.65 ± 0.01 |
| C2 | | 1290 ± 20 | 0.65 ± 0.01 |
| H2 | | 3600 ± 150 | 0.63 ± 0.01 |
| F2 | | 2680 ± 80 | 0.78 ± 0.01 |
| C3 | | 1730 ± 90 | 0.64 ± 0.01 |
| H3 | | 2150 ± 80 | 0.69 ± 0.01 |
| F3 | | 2200 ± 120 | 0.72 ± 0.01 |
| C4 | Ir(cb)$_3$ | 55.0 ± 0.1 | 0.57 ± 0.01 |
| C5 | | 95.7 ± 0.1 | 0.64 ± 0.01 |
| H5 | | 104.0 ± 0.1 | 0.62 ± 0.01 |
| C6 | | 102.5 ± 0.1 | 0.60 ± 0.01 |
| H6 | | 131.0 ± 0.1 | 0.67 ± 0.01 |

Table 2 Notes:

- Stretched exponential model: $L(t)/L_0 = \exp[-(t/t_0)^{\beta}]$

References

The following publications are incorporated by reference herein in their entireties:

1. Baldo, M. A. et al. Highly efficient phosphorescent emission from organic electroluminescent devices. Nature 395, 151 (1998).

2. Adachi, C., Baldo, M. A., Thompson, M. E. & Forrest, S. R. Nearly 100% internal phosphorescence efficiency in an organic light emitting device. J. Appl. Phys. 90, 5048-5051 (2001).

3. Universal PHOLED Product sheets. (2011). Available at: https://www.oled-i nfo.com/fi les/U DC-Prod uct-Sheets-sid-2011. pdf.

4. Forrest, S. R. Organic Electronics: Foundations to applications. Organic Electronics: Foundations to Applications (Oxford University Press, 2020). doi:10.1093/oso/9780198529729.001.0001

5. Giebink, N. C. et al. Intrinsic luminance loss in phosphorescent small-molecule organic light emitting devices due to bimolecular annihilation reactions. J. Appl. Phys. 103, (2008).

6. Giebink, N. C., D'Andrade, B. W., Weaver, M. S., Brown, J. J. & Forrest, S. R. Direct evidence for degradation of polaron excited states in organic light emitting diodes. J. Appl. Phys. 105, (2009).

7. Jeong, C. et al. Understanding molecular fragmentation in blue phosphorescent organic light-emitting devices. Org. Electron. 64, 15-21 (2019).

8. Ha, D. G. et al. Dominance of Exciton Lifetime in the Stability of Phosphorescent Dyes. Adv. Opt. Mater. 7, 1-5 (2019).

9. Dintinger, J., Klein, S., Bustos, F., Barnes, W. L. & Ebbesen, T. W. Strong coupling between surface plasmon-polaritons and organic molecules in subwavelength hole arrays. Phys. Rev. B 71, 1-5 (2005).

10. Zhang, Y., Lee, J. & Forrest, S. R. Tenfold increase in the lifetime of blue phosphorescent organic light-emitting diodes. Nat. Commun. 5, 1-7 (2014).

11. Lee, J. et al. Hot excited state management for long-lived blue phosphorescent organic light-emitting diodes. Nat. Commun. 8, 1-9 (2017).

12. Kim, S. et al. Degradation of blue-phosphorescent organic light-emitting devices involves exciton-induced generation of polaron pair within emitting layers. Nat. Commun. 9, 1-11 (2018).

13. Bae, H. J. et al. Protecting Benzylic C-H Bonds by Deuteration Doubles the Operational Lifetime of Deep-Blue Ir-Phenylimidazole Dopants in Phosphorescent OLEDs. Adv. Opt. Mater. 9, (2021).

14. Sim, B. et al. Comprehensive model of the degradation of organic light-emitting diodes and application for efficient, stable blue phosphorescent devices with reduced influence of polarons. Phys. Rev. Appl. 14, 1 (2020).

15. Yang, K. et al. Effects of Charge Dynamics in the Emission Layer on the Operational Lifetimes of Blue Phosphorescent Organic Light-Emitting Diodes. Adv. Funct. Mater. 32, (2022).

16. Zhao, H. et al. Control of Host-Matrix Morphology Enables Efficient Deep-Blue Organic Light-Emitting Devices. Adv. Mater. 35, 2210794 (2023).

17. Ihn, S. G. et al. Cohosts with efficient host-to-emitter energy transfer for stable blue phosphorescent organic light-emitting diodes. J. Mater. Chem. C 9, 17412-17418 (2021).

18. Choi, K. H., Lee, K. H., Lee, J. Y. & Kim, T. Simultaneous Achievement of High Efficiency and Long Lifetime in Deep Blue Phosphorescent Organic Light-Emitting Diodes. Adv. Opt. Mater. 7, 1-7 (2019).

19. Shin, S. K., Han, S. H. & Lee, J. Y. High triplet energy exciplex host derived from a CN modified carbazole based n-type host for improved efficiency and lifetime in blue phosphorescent organic light-emitting diodes. J. Mater. Chem. C 6, 10308-10314 (2018).

20. Kim, J. S. et al. Improved Efficiency and Stability of Blue Phosphorescent Organic Light Emitting Diodes by Enhanced Orientation of Homoleptic Cyclometalated Ir(III) Complexes. Adv. Opt. Mater. 8, (2020).

21. Jung, M., Lee, K. H., Lee, J. Y. & Kim, T. A bipolar host based high triplet energy electroplex for an over 10000 h lifetime in pure blue phosphorescent organic light-emitting diodes. Mater. Horizons 7, 559-565 (2020).

22. Sun, J. et al. Exceptionally stable blue phosphorescent organic light-emitting diodes. Nat. Photonics 16, 212-218 (2022).

23. Bulović, V., Khalfin, V., Gu, G., Burrows, P. & Garbuzov, D. Weak microcavity effects in organic light-emitting devices. Phys. Rev. B 58, 3730-3740 (1998).

24. Fusella, M. A. et al. Plasmonic enhancement of stability and brightness in organic light-emitting devices. Nature 585, 379-382 (2020).

25. Zengin, G. et al. Realizing strong light-matter interactions between single-nanoparticle plasmons and molecular excitons at ambient conditions. Phys. Rev. Lett. 114, 1-6 (2015).

26. Deng, H., Haug, H. & Yamamoto, Y. Exciton-polariton Bose-Einstein condensation. Rev. Mod. Phys. 82, 1489-1537 (2010).

The disclosures of each and every patent, patent application, and publication cited herein are hereby incorporated herein by reference in their entirety. While this invention has been disclosed with reference to specific embodiments, it is apparent that other embodiments and variations of this invention may be devised by others skilled in the art without departing from the true spirit and scope of the invention. The appended claims are intended to be construed to include all such embodiments and equivalent variations.

In the following, different numbered aspects of the present invention are disclosed.

1. An organic light emitting device, comprising:

   an anode;
   an organic emissive layer positioned over the anode, the organic emissive layer comprising a host material and a dopant;
   a charge transport layer positioned over the organic emissive layer, having a thickness of less than 20 nm; and
   a metal cathode positioned over the charge transport layer;
   wherein the charge transport layer and the cathode are configured to form plasmon exciton polaritons between the metal cathode and the charge transport layer.

2. The device of aspect 1, further comprising a reflector positioned under the anode.

3. The device of any of the previous aspects, wherein the reflector comprises a stack of layers of alternating materials.

4. The device of any of the previous aspects, wherein the reflector and the cathode form a cavity having a total cavity Q of 5 or less.

5. The device of any of the previous aspects, wherein at least a portion of the organic emissive layer is at an antinode of a cavity formed between the reflector and the cathode.

6. The device of any of the previous aspects, wherein the metal cathode is selected from the group consisting of Ag, Au, Ag alloys, and/or Au alloys.

7. The device of any of the previous aspects, wherein the charge transport layer has a thickness less than 18 nm.

8. The device of any of the previous aspects, wherein the charge transport layer has a thickness less than 15 nm.

9. The device of any of the previous aspects, wherein the charge transport layer has a thickness less than 10 nm.

10. The device of any of the previous aspects, wherein the reflector and the cathode form a cavity having a total

cavity Q of 4 or less.

11. The device of any of the previous aspects, wherein the reflector and the cathode form a cavity having a total cavity Q of 3 or less.

12. The device of any of the previous aspects, further comprising a blocking layer between the metal cathode and the charge transport layer.

13. The device of any of the previous aspects, wherein the blocking layer prevents diffusion between the metal cathode and the charge transport layer.

14. The device of any of the previous aspects, wherein the blocking layer is two or more layers.

15. The device of any of the previous aspects, wherein at least one layer of the two or more layers is made of Al.

16. The device of any of the previous aspects, wherein the at least one layer is adjacent to the metal cathode.

17. The device of any of the previous aspects, wherein the at least one layer is less than 3 nm thick.

18. The device of any of the previous aspects wherein at least one layer of the two or more layers is Liq (8-Hydroxyquinolinolato-lithium).

19. The device of any of the previous aspects, wherein the at least one layer is adjacent to the charge transport layer.

20. The device of any of the previous aspects, wherein the at least one layer is less than 3 nm thick.

21. The device of any of the previous aspects, wherein an interface is formed between the metal cathode and the charge transport layer.

22. The device of any of the previous aspects, wherein plasmon exciton polariton strength is a function of the oscillator strength of the metal cathode and the charge transport layer.

23. The device of any of the previous aspects, wherein the charge transport layer comprises an electron transport layer.

24. The device of any of the previous aspects, wherein the charge transport layer comprises an absorption tail that overlaps a portion of an emission spectrum of the emissive layer.

25. A consumer product comprising the device of any of the previous aspects, wherein the consumer product is selected from the group consisting of a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, a light therapy device, and a sign.

26. The device of any of the previous aspects, wherein the organic emissive layer positioned over the anode comprises an emitter stack above the anode, comprising a charge generation layer between first and second emission layers and wherein the charge transport layer positioned over the organic emissive layer, having a thickness of less than 20 nm comprises at least one of a hole transport layer and hole injection layer between the anode and the emitter stack, with an absorption tail that overlaps at least a first portion of a first emission spectrum of a first triplet controlled emitting material of the emitter stack and further comprising:

a substrate;
the anode above the substrate;
the metal cathode above the emitter stack; and
an electron transport layer between the emitter stack and the metal cathode, with an absorption tail that overlaps

at least a second portion of a second emission spectrum of a second triplet controlled emitting material of the emitter stack.

27. The device of any of the previous aspects, preferably aspect 26, wherein at least one of the hole transport layer and hole injection layer has a thickness of 1 nm to 40 nm, or combined thickness of 5 nm to 40 nm.

28. The device of any of the previous aspects, preferably aspect 26, wherein at least one of the hole transport layer and hole injection layer comprises a composition of BCFN and HATCN.

29. The device of any of the previous aspects, preferably aspect 26, wherein the electron transport layer has a thickness of 5 nm to 60 nm.

30. The device of any of the previous aspects, preferably aspect 26, wherein the electron transport layer comprises BPyTP2.

31. The device of any of the previous aspects, preferably aspect 26, wherein the anode comprises a metal anode.

32. The device of any of the previous aspects, preferably aspect 26, wherein the thickness of the charge generation layer is tuned to match the first and second emission layers with the anti-nodes of a metal-metal cavity defined by the metal anode and metal cathode.

33. The device of any of the previous aspects, preferably aspect 26, wherein the first and second emission layers are configured to emit blue light.

34. The device of any of the previous aspects, preferably aspect 26, wherein the first and second emission layers each have a thickness of 60 nm to 70 nm.

35. The device of any of the previous aspects, preferably aspect 26, wherein the first emission layer or second emission layer comprises a first layer with a thickness of 5 nm comprising SiCzCz, a second layer with a thickness of 5nm comprising mSiTrz, and a third layer between the first and second layers with a thickness of 50 nm to 60 nm comprising SiCzCz:SiTrzCz2 (1:1) and PtON-TBBI doped 6-13 vol%.

36. The device of any of the previous aspects, preferably aspect 26, wherein the first emission layer or second emission layer comprises a first layer with a thickness of 55 nm to 65 nm comprising mCBP:Ir(dmp)3 doped 18-8 vol%, and a second layer above or below the first layer with a thickness of 5 nm comprising mCBP.

37. The device of any of the previous aspects, preferably aspect 26, wherein the charge generation layer has a thickness of 30 nm to 100 nm.

38. The device of any of the previous aspects, preferably aspect 26, wherein the charge generation layer comprises a first layer with a thickness of 8 nm to 30 nm comprising BPyTP2, a second layer with a thickness of 15 nm to 40 nm comprising a composition of BCFN and HATCN, and a third layer between the first and second layers with a thickness of 12 nm comprising BPyTP2:Li 2%.

39. The device of any of the previous aspects, preferably aspect 26, wherein the anode comprises an Ag composite electrode.

40. The device of any of the previous aspects, preferably aspect 26, wherein the Ag composite electrode comprises a first layer of thickness 20 nm to 70 nm comprising ITO, a second layer above the first layer with a thickness of 2 nm to 3 nm comprising Ti of NiCr, a third layer above the second layer with a thickness of 15 nm to 20 nm comprising Ag, a fourth layer above the third layer with a thickness of 2 nm to 3 nm comprising Al, Ti, TiO2, or NiCr, and a fifth layer above the fourth layer of with a thickness of 5 nm to 20 nm comprising ITO.

41. The device of any of the previous aspects, preferably aspect 26, wherein the substrate comprises glass.

42. The device of any of the previous aspects, preferably aspect 26, wherein the device has a lifetime enhancement of at least 36 times.

43. A product comprising the device of aspect 26, the product selected from the group consisting of a flat panel display, a curved display, a computer monitor, a computer, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro-display, a 3-D display, a virtual reality or augmented reality display or device, a vehicle, a video wall comprising multiple displays tiled together, a theater or stadium screen, a light therapy device, a camera, an imaging device, and a sign.

44. An organic light emitting device (OLED), comprising:

a substrate;
a reflector above the substrate;
a first electrode above the reflector;
an emissive layer above the first electrode;
an electron transport layer above the emissive layer; and
a second electrode above the electron transport layer wherein the electron transport layer and the second electrode are configured to form plasmon exciton polaritons between the second electrode and the electron transport layer.

45. The device of aspect 44, further comprising at least one of a hole blocking layer, electron blocking layer, a hole transport layer, and a hole injection layer between the first electrode and the emissive layer.

46. The device of any of the previous aspects 44 to 45, further comprising a second hole blocking layer between the emissive layer and the electron transport layer.

47. The device of any of the previous aspects 44 to 46, further comprising a buffer layer between the electron transport layer and the second electrode.

48. The device of any of the previous aspects 44 to 47, wherein the reflector comprises a distributed Bragg reflector.

49. The device any of the previous aspects 44 to 48, wherein the OLED includes a cavity between the first and second electrodes.

50. The device of any of the previous aspects 44 to 49, wherein the emissive layer is positioned to span an antinode of the cavity.

51. The device of any of the previous aspects 44 to 50, wherein the second electrode comprises a metal electrode.

52. The device of any of the previous aspects 44 to 51, wherein the emissive layer comprises a blue emissive layer.

53. The device of any of the previous aspects 44 to 52, wherein the emissive layer comprises a phosphorescent emitter material.

54. The device of any of the previous aspects 44 to 53, wherein the phosphorescent emitter material is a blue phosphorescent emitter material.

55. The device of any of the previous aspects 44 to 54, wherein the emissive layer comprises a sensitizer material and an acceptor material and wherein the sensitizer material transfers energy to the acceptor material.

56. The device of any of the previous aspects 44 to 55, wherein the acceptor material is a fluorescent emitter material.

57. The device of any of the previous aspects 44 to 56, wherein the sensitizer material is selected from the group consisting of a phosphorescent material or delayed fluorescent material.

58. The device of any of the previous aspects 44 to 57, wherein the sensitizer material is a blue emissive material.

59. The device of any of the previous aspects 44 to 58, wherein the fluorescent emitter material comprises a delayed

fluorescent emitter material.

60. The device of any of the previous aspects 44 to 59, wherein the electron transport layer has a large oscillator strength at wavelengths shorter than a triplet emission wavelength of the organic emissive layer.

61. The device of any of the previous aspects 44 to 60, wherein the electron transport layer has a large oscillator strength at wavelengths 0.1 nm to 1000 nm shorter than a triplet emission wavelength of the organic emissive layer.

62. The device of any of the previous aspects 44 to 61, wherein the electron transport layer has a large oscillator strength at wavelengths less than 25 nm shorter than a triplet emission wavelength of the organic emissive layer.

63. The device of any of the previous aspects 44 to 62, wherein the reflector has a reflectivity in a range of 50-100%.

64. The device of any of the previous aspects 44 to 63, wherein the reflector has a reflectivity of 50-80%.

65. The device of any of the previous aspects 44 to 64, wherein the reflector has a reflectivity of 60-70%.

66. An organic light emitting device, comprising:

a substrate;
a first electrode above the substrate;
two or more emitter stacks above the first electrode, each stack comprising alternating emission layers and charge generation layers, with emission layers as the top most and bottom most layers;
a second electrode above the emitter stack;
at least one of a hole transport layer and hole injection layer between the first electrode and the emitter stacks, with an absorption tail that overlaps at least a first portion of a first emission spectrum of a first triplet controlled emitting material of the emitter stacks; and
an electron transport layer between the emitter stacks and the second electrode, with an absorption tail that overlaps at least a second portion of a second emission spectrum of a second triplet controlled emitting material of the emitter stacks.

67. A stacked organic light emitting device, comprising:

a substrate;
a first electrode above the substrate;
a second electrode above the first electrode; and
two or more emission layers employing polariton-enhanced Purcell effects in the regions of the first and second electrodes.

68. An organic light emitting device, comprising:

an anode;
an organic emissive layer positioned over the anode, the organic emissive layer comprising a host material and a dopant;
an electron transport layer positioned over the organic emissive layer, having a thickness of less than 20 nm and an absorption tail that overlaps a portion of an emission spectrum of the emissive layer; and
a metal cathode positioned over the charge transport layer;
wherein the electron transport layer and the cathode are configured to form plasmon exciton polaritons between the metal cathode and the electron transport layer.

69. An organic light emitting device, comprising:

a substrate;
a first electrode above the substrate;
an emitter stack above the first electrode, comprising a charge generation layer between first and second emission layers;
a second electrode above the emitter stack;
at least one of a hole transport layer and hole injection layer between the first electrode and the emitter stack,

with an absorption tail that overlaps at least a first portion of a first emission spectrum of a first triplet controlled emitting material of the emitter stack; and

an electron transport layer between the emitter stack and the second electrode, with an absorption tail that overlaps at least a second portion of a second emission spectrum of a second triplet controlled emitting material of the emitter stack.

70. The device of aspect 69, wherein at least one of the hole transport layer and hole injection layer has a thickness of 1 nm to 40 nm, or combined thickness of 5 nm to 40 nm.

71. The device of any of the previous aspects 69 to 70, wherein at least one of the hole transport layer and hole injection layer comprises a composition of BCFN and HATCN.

72. The device of any of the previous aspects 69 to 71, wherein the electron transport layer has a thickness of 5 nm to 60 nm.

73. The device of any of the previous aspects 69 to 72, wherein the electron transport layer comprises BPyTP2.

74. The device of any of the previous aspects 69 to 73, wherein the first and second electrodes comprise metal electrodes.

75. The device of any of the previous aspects 69 to 74, wherein the thickness of the charge generation layer is tuned to match the first and second emission layers with the anti-nodes of a metal-metal cavity defined by the first and second electrodes.

76. The device of any of the previous aspects 69 to 75, wherein the first and second emission layers are configured to emit blue light.

77. The device of any of the previous aspects 69 to 76, wherein the first and second emission layers each have a thickness of 60 nm to 70 nm.

78. The device of any of the previous aspects 69 to 77, wherein the first emission layer or second emission layer comprises a first layer with a thickness of 5 nm comprising SiCzCz, a second layer with a thickness of 5nm comprising mSiTrz, and a third layer between the first and second layers with a thickness of 50 nm to 60 nm comprising SiCzCz:SiTrzCz2 (1:1) and PtON-TBBI doped 6-13 vol%.

79. The device of any of the previous aspects 69 to 78, wherein the first emission layer or second emission layer comprises a first layer with a thickness of 55 nm to 65 nm comprising mCBP:Ir(dmp)3 doped 18-8 vol%, and a second layer above or below the first layer with a thickness of 5 nm comprising mCBP.

80. The device of any of the previous aspects 69 to 79, wherein the charge generation layer has a thickness of 30 nm to 100 nm.

81. The device of any of the previous aspects 69 to 80, wherein the charge generation layer comprises a first layer with a thickness of 8 nm to 30 nm comprising BPyTP2, a second layer with a thickness of 15 nm to 40 nm comprising a composition of BCFN and HATCN, and a third layer between the first and second layers with a thickness of 12 nm comprising BPyTP2:Li 2%.

82. The device of any of the previous aspects 69 to 81, wherein the first electrode comprises an Ag composite electrode.

83. The device of aspect 82, wherein the Ag composite electrode comprises a first layer of thickness 20 nm to 70 nm comprising ITO, a second layer above the first layer with a thickness of 2 nm to 3 nm comprising Ti of NiCr, a third layer above the second layer with a thickness of 15 nm to 20 nm comprising Ag, a fourth layer above the third layer with a thickness of 2 nm to 3 nm comprising Al, Ti, TiO2, or NiCr, and a fifth layer above the fourth layer of with a thickness of 5 nm to 20 nm comprising ITO.

84. The device of any of the previous aspects 69 to 83, wherein the substrate comprises glass.

85. The device of any of the previous aspects 69 to 84, wherein the device has a lifetime enhancement of at least 36 times.

86. A product comprising the device of any of the previous aspects 69 to 85, the product selected from the group consisting of a flat panel display, a curved display, a computer monitor, a computer, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a micro-display, a 3-D display, a virtual reality or augmented reality display or device, a vehicle, a video wall comprising multiple displays tiled together, a theater or stadium screen, a light therapy device, a camera, an imaging device, and a sign.

## Claims

**1.** An organic light emitting device, comprising:

an anode;
an organic emissive layer positioned over the anode, the organic emissive layer comprising a host material and a dopant;
a charge transport layer positioned over the organic emissive layer, having a thickness of less than 20 nm; and
a metal cathode positioned over the charge transport layer;
wherein the charge transport layer and the cathode are configured to form plasmon exciton polaritons between the metal cathode and the charge transport layer.

**2.** The device of claim 1, further comprising a reflector positioned under the anode.

**3.** The device of claim 1 or 2, wherein at least a portion of the organic emissive layer is at an antinode of a cavity formed between the reflector and the cathode.

**4.** The device of any of the preceding claims, wherein the charge transport layer comprises an absorption tail that overlaps a portion of an emission spectrum of the emissive layer.

**5.** A consumer product comprising the device of any of the preceding claims, wherein the consumer product is selected from the group consisting of a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, a light therapy device, and a sign.

**6.** The device of any of the preceding claims, wherein the organic emissive layer positioned over the anode comprises an emitter stack above the anode, comprising a charge generation layer between first and second emission layers and wherein the charge transport layer positioned over the organic emissive layer, having a thickness of less than 20 nm comprises at least one of a hole transport layer and hole injection layer between the anode and the emitter stack, with an absorption tail that overlaps at least a first portion of a first emission spectrum of a first triplet controlled emitting material of the emitter stack and further comprising:

a substrate;
the anode above the substrate;
the metal cathode above the emitter stack; and
an electron transport layer between the emitter stack and the metal cathode, with an absorption tail that overlaps at least a second portion of a second emission spectrum of a second triplet controlled emitting material of the emitter stack.

**7.** The device of claim 6, wherein the anode comprises a metal anode.

8. The device of claim 6 or 7, wherein the thickness of the charge generation layer is tuned to match the first and second emission layers with the anti-nodes of a metal-metal cavity defined by the metal anode and metal cathode.

9. An organic light emitting device (OLED), comprising:

a substrate;
a reflector above the substrate;
a first electrode above the reflector;
an emissive layer above the first electrode;
an electron transport layer above the emissive layer; and
a second electrode above the electron transport layer wherein the electron transport layer and the second electrode are configured to form plasmon exciton polaritons between the second electrode and the electron transport layer.

10. The device of claim 9, wherein the OLED includes a cavity between the first and second electrodes.

11. The device of claim 9 or 10, wherein the emissive layer is positioned to span an antinode of the cavity.

12. The device of any of the claims 9 to 11, wherein the electron transport layer has a large oscillator strength at wavelengths shorter than a triplet emission wavelength of the organic emissive layer.

13. An organic light emitting device, comprising:

a substrate;
a first electrode above the substrate;
an emitter stack above the first electrode, comprising a charge generation layer between first and second emission layers;
a second electrode above the emitter stack;
at least one of a hole transport layer and hole injection layer between the first electrode and the emitter stack, with an absorption tail that overlaps at least a first portion of a first emission spectrum of a first triplet controlled emitting material of the emitter stack; and
an electron transport layer between the emitter stack and the second electrode, with an absorption tail that overlaps at least a second portion of a second emission spectrum of a second triplet controlled emitting material of the emitter stack.

14. The device of claim 13, wherein the first and second electrodes comprise metal electrodes.

15. The device of claim 13 or 14, wherein the thickness of the charge generation layer is tuned to match the first and second emission layers with the anti-nodes of a metal-metal cavity defined by the first and second electrodes.

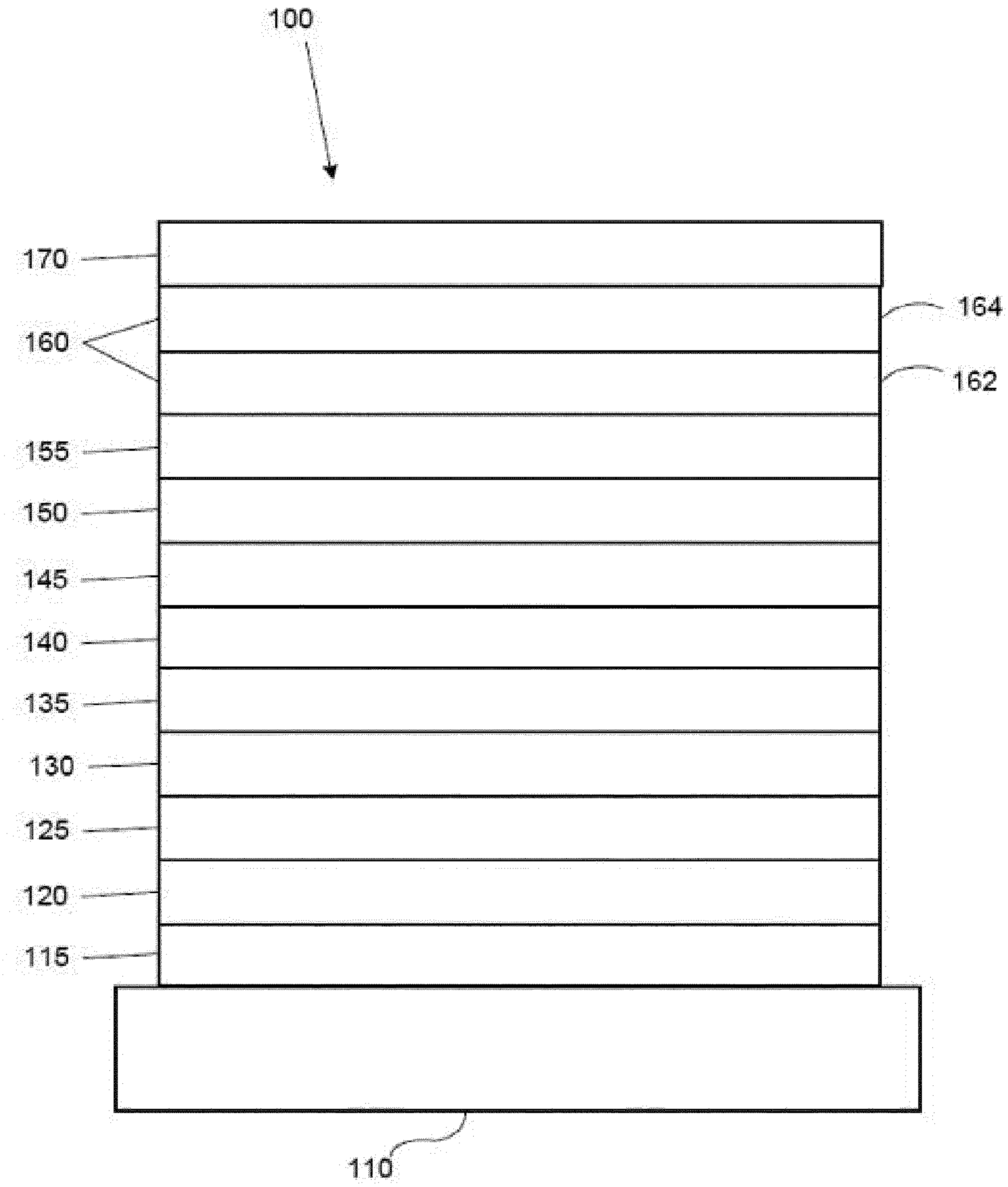


FIG. 1

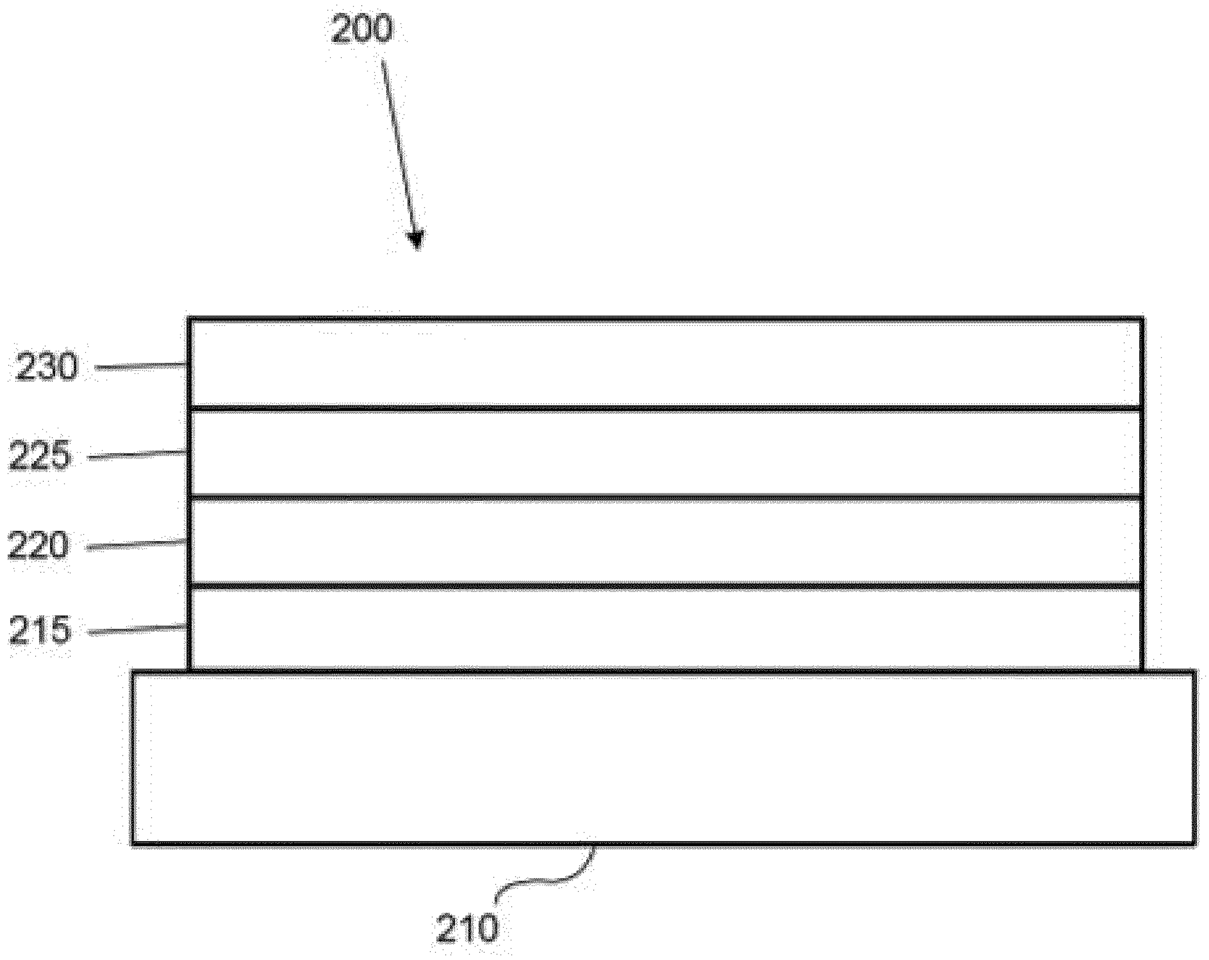


FIG. 2

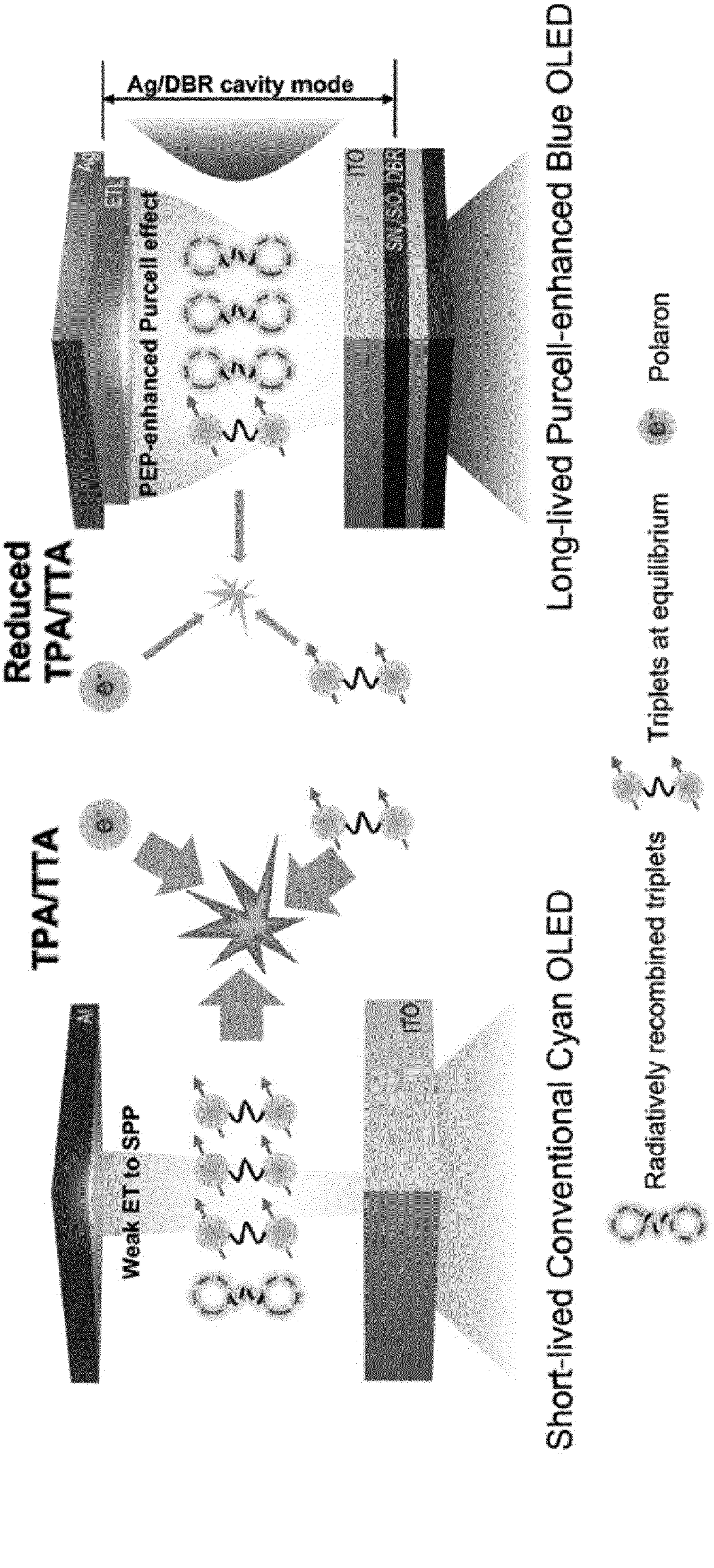

TPA/TTA
Al
Weak ET to SPP
ITO
e-
Short-lived Conventional Cyan OLED
Reduced TPA/TTA
Ag/DBR cavity mode
Ag
ETL
PEP-enhanced Purcell effect
ITO
SiN/SiO2 DBR
Long-lived Purcell-enhanced Blue OLED
Radiatively recombined triplets
Triplets at equilibrium
Polaron


FIG. 3

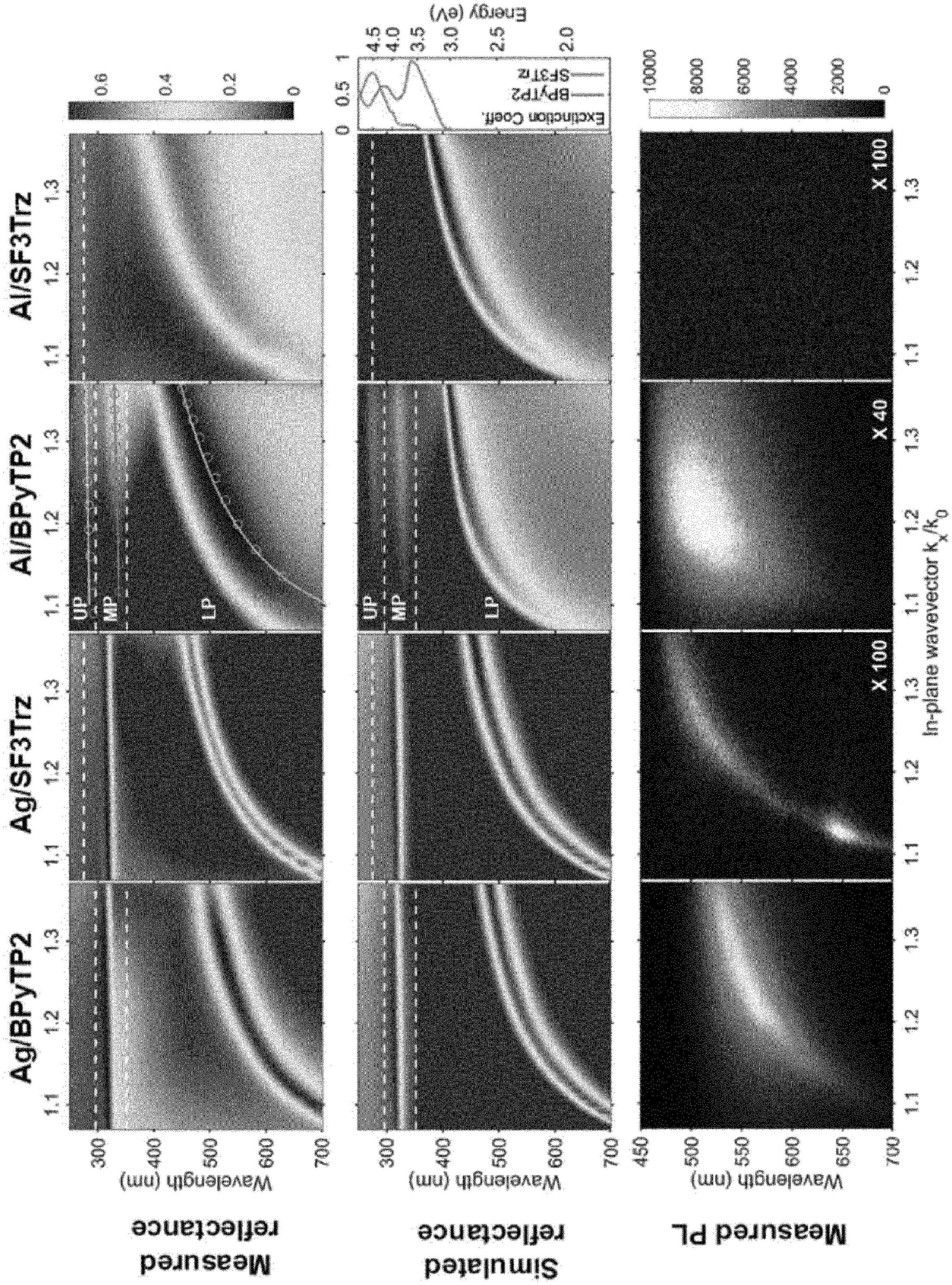
Ag/BPyTP2
Ag/SF3Trz
Al/BPyTP2
Al/SF3Trz
Measured reflectance
Simulated reflectance
Measured PL
Wavelength (nm)
In-plane wavevector $k_x/k_0$
Energy (eV)
Extinction Coeff.
BPyTP2
SF3Trz
UP
MP
LP
X 100
X 40
X 100

FIG. 4

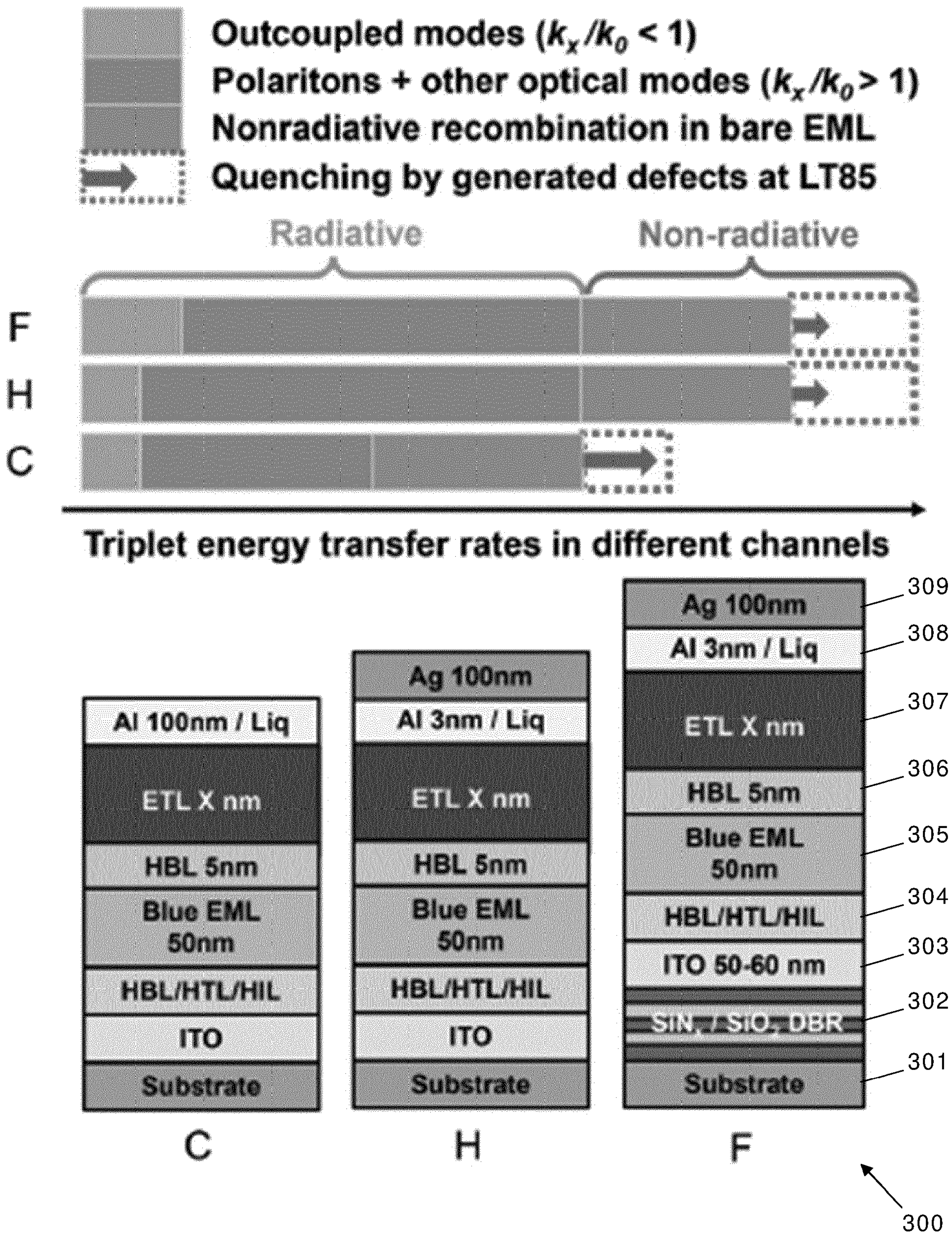

Outcoupled modes ($k_x/k_0 < 1$)
Polaritons + other optical modes ($k_x/k_0 > 1$)
Nonradiative recombination in bare EML
Quenching by generated defects at LT85
Radiative
Non-radiative
F
H
C
Triplet energy transfer rates in different channels
Al 100nm / Liq
ETL X nm
HBL 5nm
Blue EML 50nm
HBL/HTL/HIL
ITO
Substrate
Ag 100nm
Al 3nm / Liq
ETL X nm
HBL 5nm
Blue EML 50nm
HBL/HTL/HIL
ITO
Substrate
Ag 100nm
Al 3nm / Liq
ETL X nm
HBL 5nm
Blue EML 50nm
HBL/HTL/HIL
ITO 50-60 nm
$SiN_x$ / $SiO_2$ DBR
Substrate
309
308
307
306
305
304
303
302
301
C
H
F
300


FIG. 5A

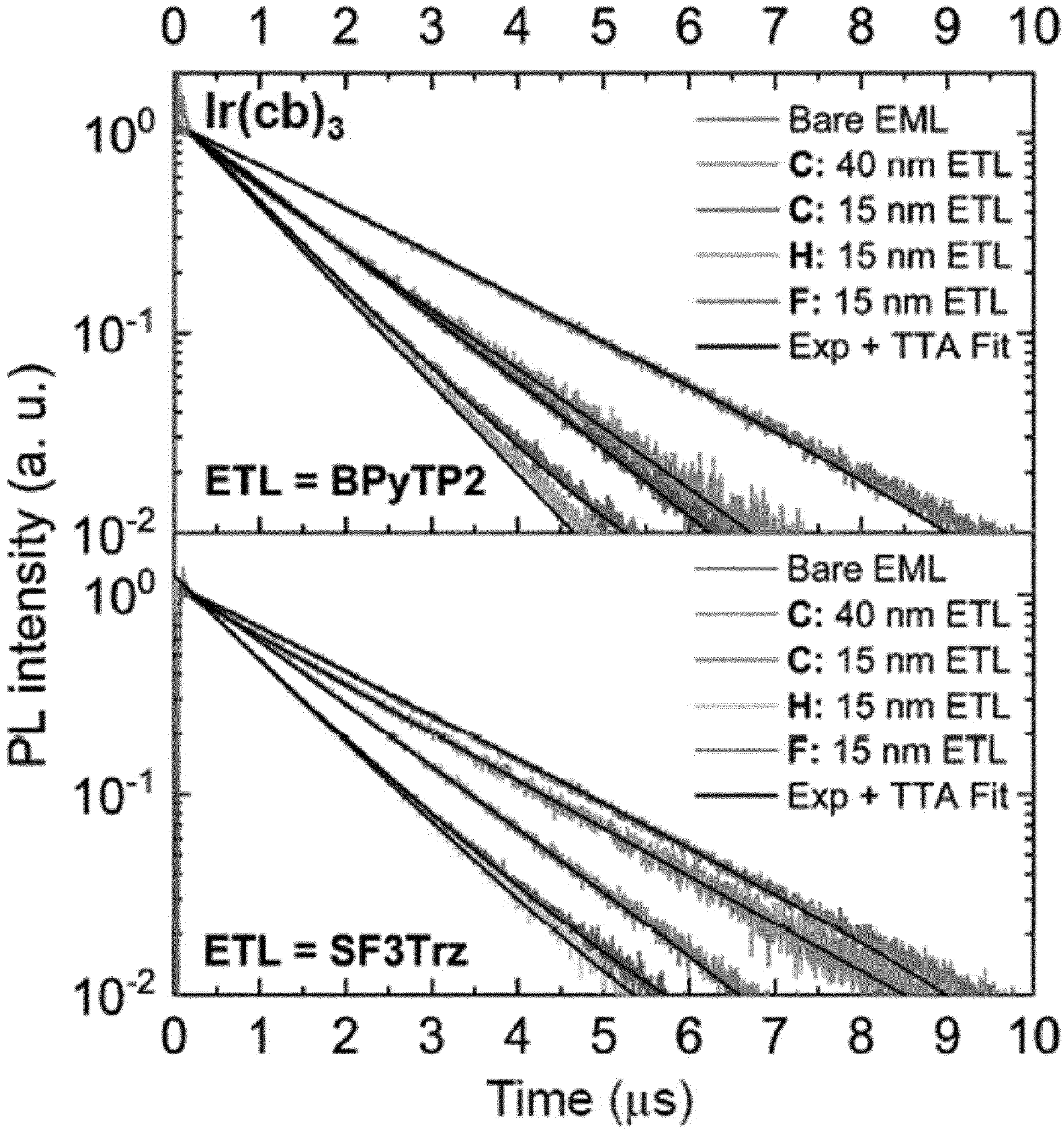
Ir(cb)$_3$
Bare EML
C: 40 nm ETL
C: 15 nm ETL
H: 15 nm ETL
F: 15 nm ETL
Exp + TTA Fit
ETL = BPyTP2
ETL = SF3Trz
PL intensity (a. u.)
Time (μs)

FIG. 5B

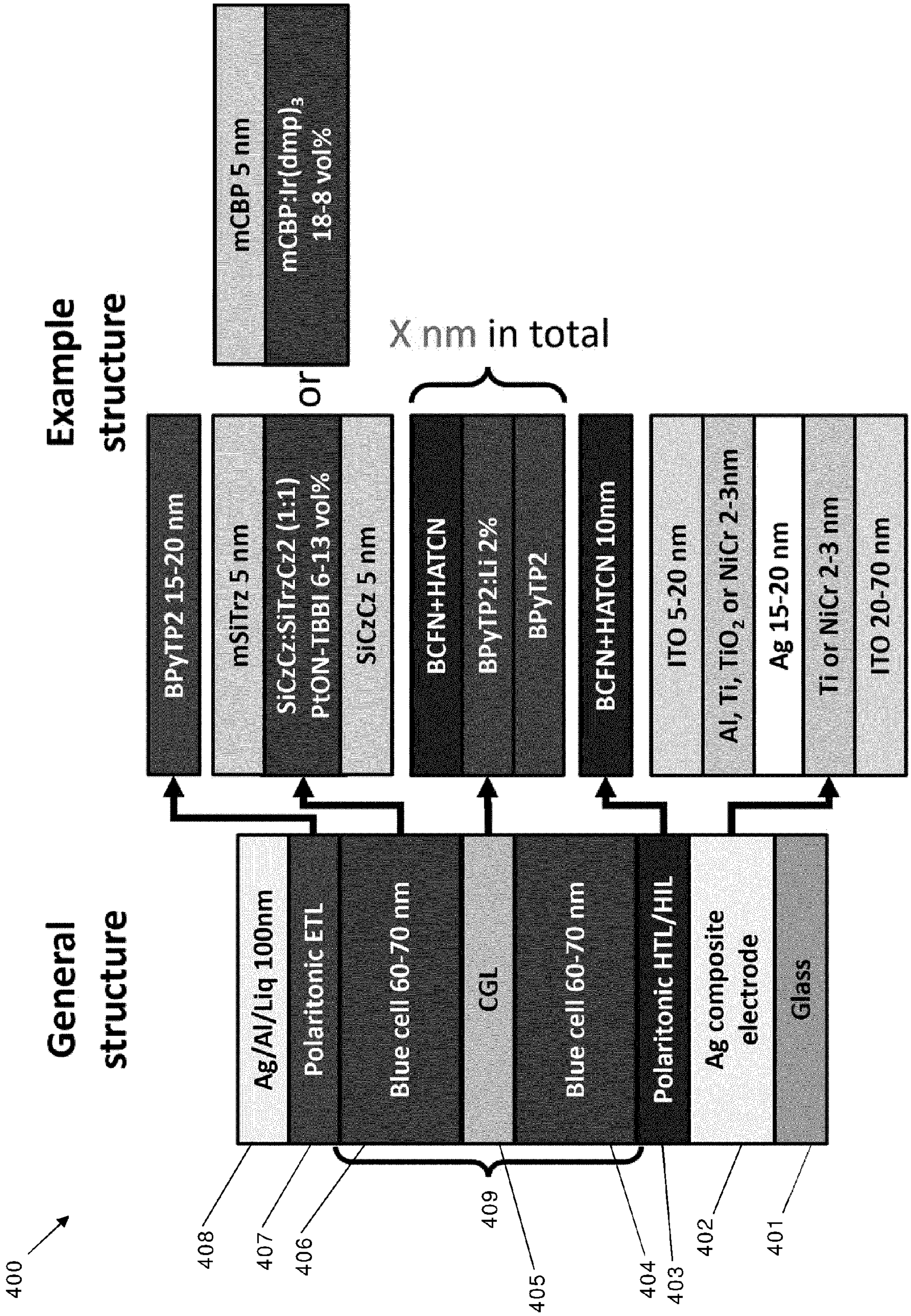
400
General structure
Ag/Al/Liq 100nm
Polaritonic ETL
Blue cell 60-70 nm
CGL
Blue cell 60-70 nm
Polaritonic HTL/HIL
Ag composite electrode
Glass
408
407
406
409
405
404
403
402
401
Example structure
BPyTP2 15-20 nm
mSiTrz 5 nm
SiCzCz:SiTrzCz2 (1:1)
PtON-TBBI 6-13 vol%
SiCzCz 5 nm
or
mCBP 5 nm
mCBP:Ir(dmp)3
18-8 vol%
X nm in total
BCFN+HATCN
BPyTP2:Li 2%
BPyTP2
BCFN+HATCN 10nm
ITO 5-20 nm
Al, Ti, TiO2 or NiCr 2-3nm
Ag 15-20 nm
Ti or NiCr 2-3 nm
ITO 20-70 nm

FIG. 5C

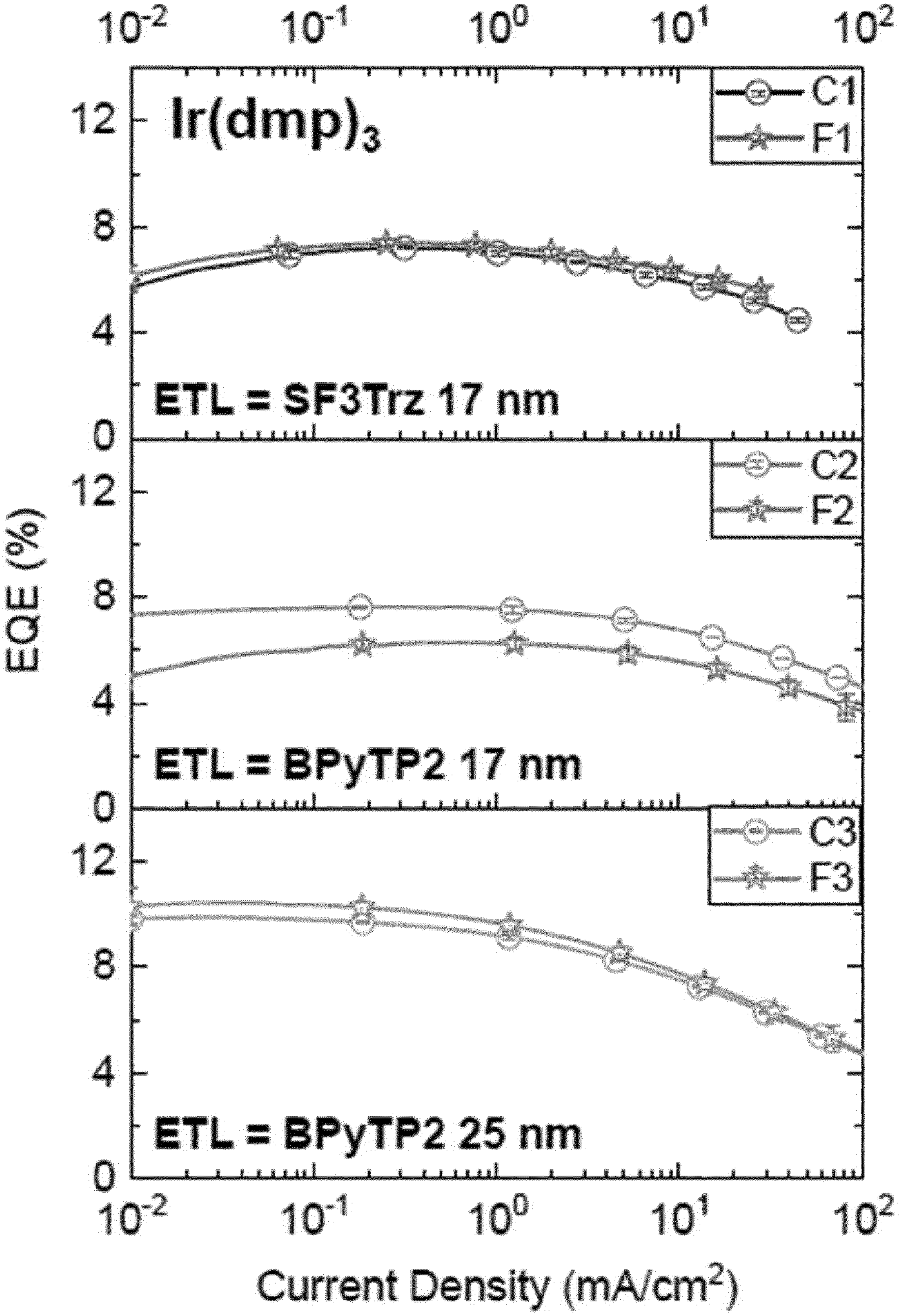
Ir(dmp)$_3$
C1
F1
ETL = SF3Trz 17 nm
C2
F2
ETL = BPyTP2 17 nm
C3
F3
ETL = BPyTP2 25 nm
EQE (%)
0
4
8
12
$10^{-2}$
$10^{-1}$
$10^{0}$
$10^{1}$
$10^{2}$
Current Density (mA/cm$^2$)

FIG. 6A

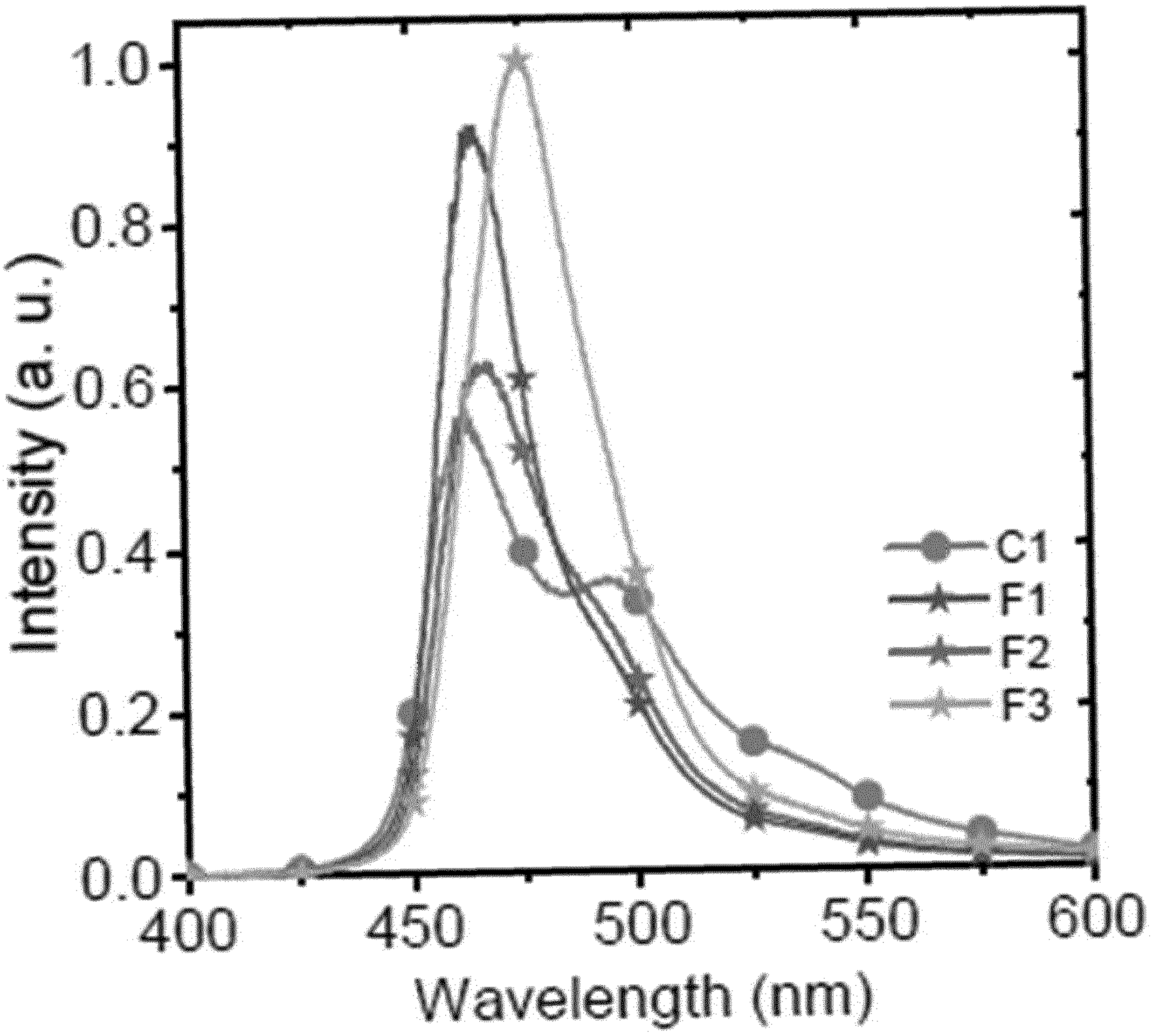
1.0
0.8
0.6
0.4
0.2
0.0
Intensity (a. u.)
400
450
500
550
600
Wavelength (nm)
C1
F1
F2
F3

FIG. 6B

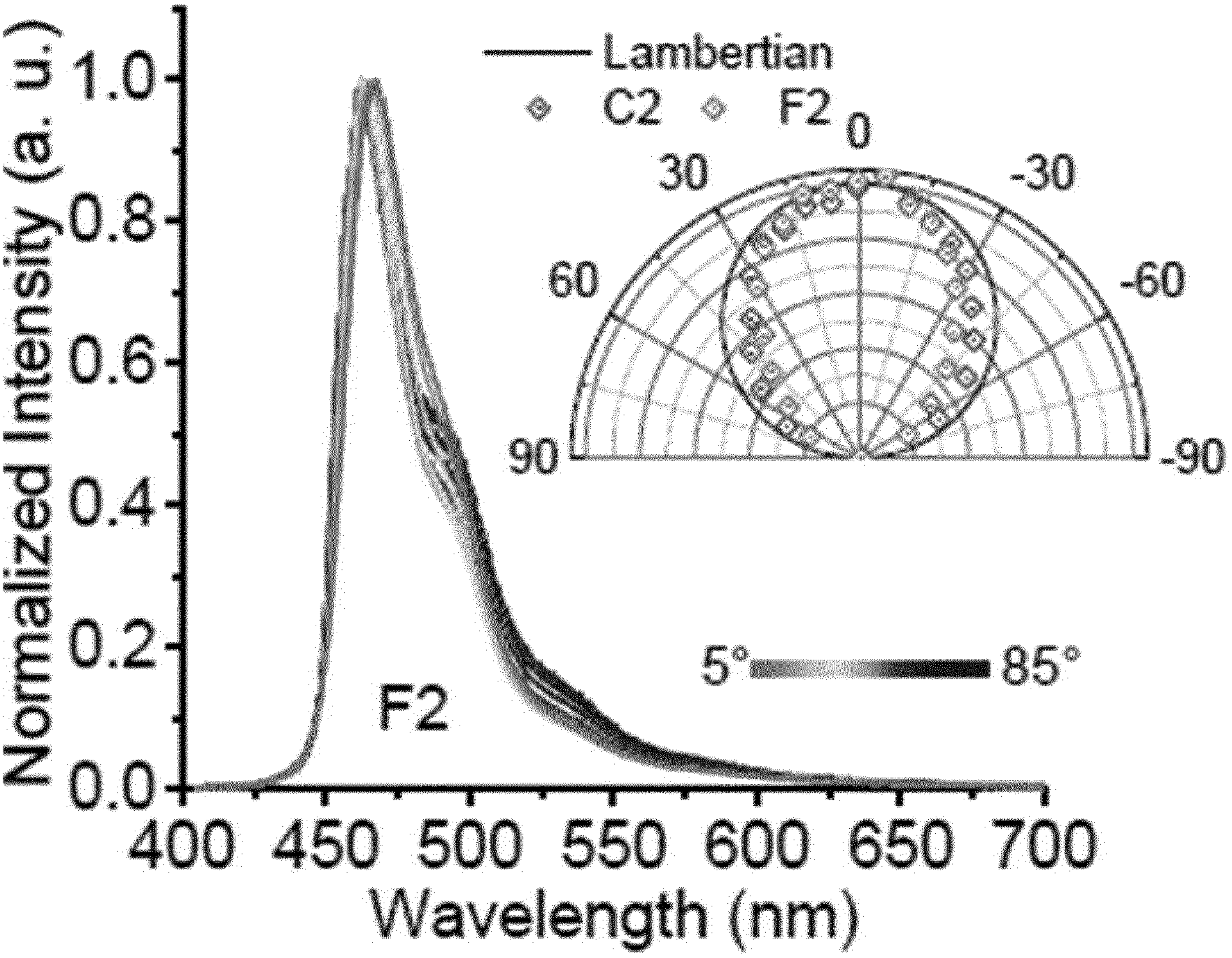
Normalized Intensity (a. u.)
1.0
0.8
0.6
0.4
0.2
0.0
400
450
500
550
600
650
700
Wavelength (nm)
F2
Lambertian
C2
F2
0
30
-30
60
-60
90
-90
5°
85°

FIG. 6C

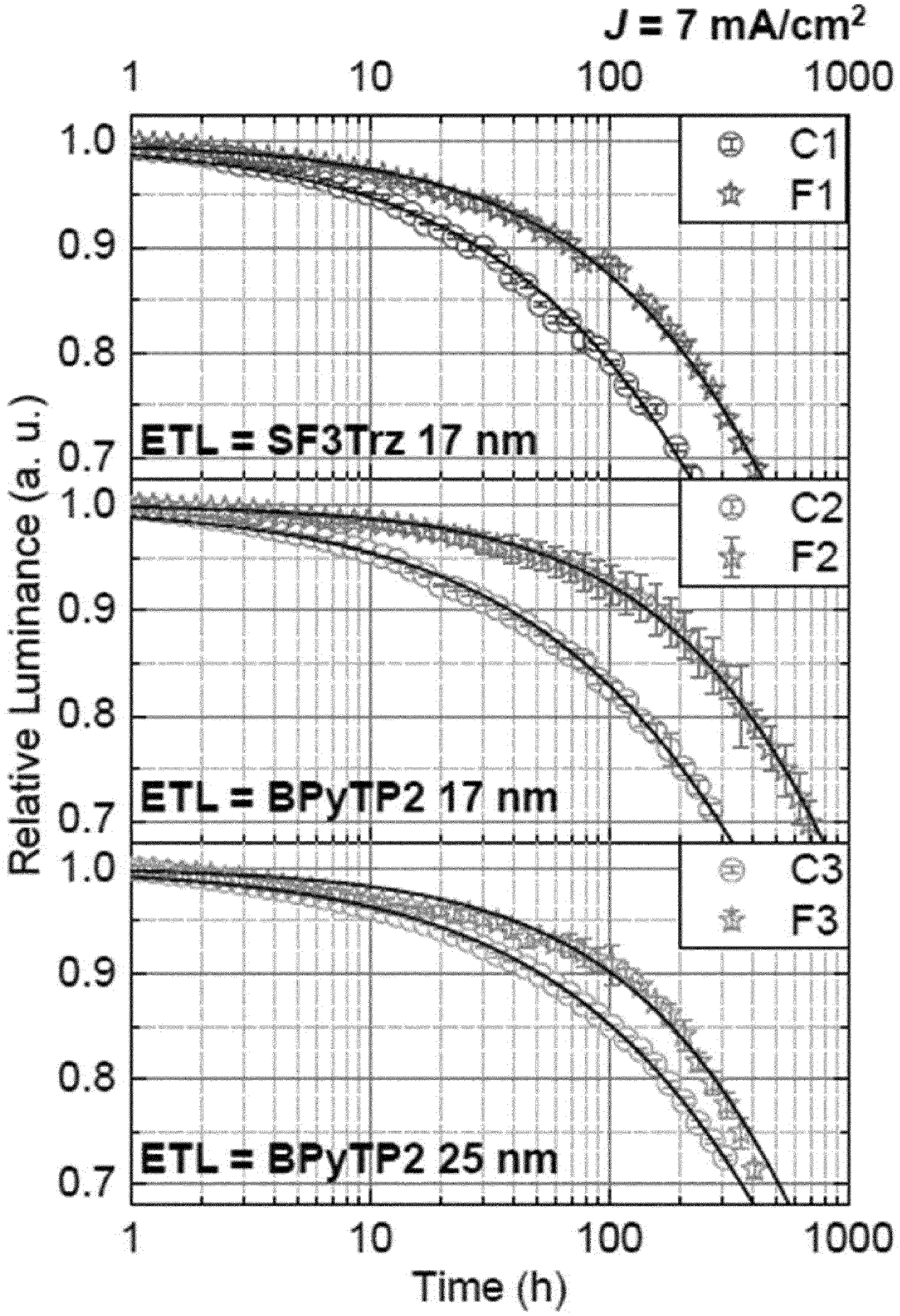
J = 7 mA/cm²
Relative Luminance (a. u.)
Time (h)
C1
F1
ETL = SF3Trz 17 nm
C2
F2
ETL = BPyTP2 17 nm
C3
F3
ETL = BPyTP2 25 nm

FIG. 6D

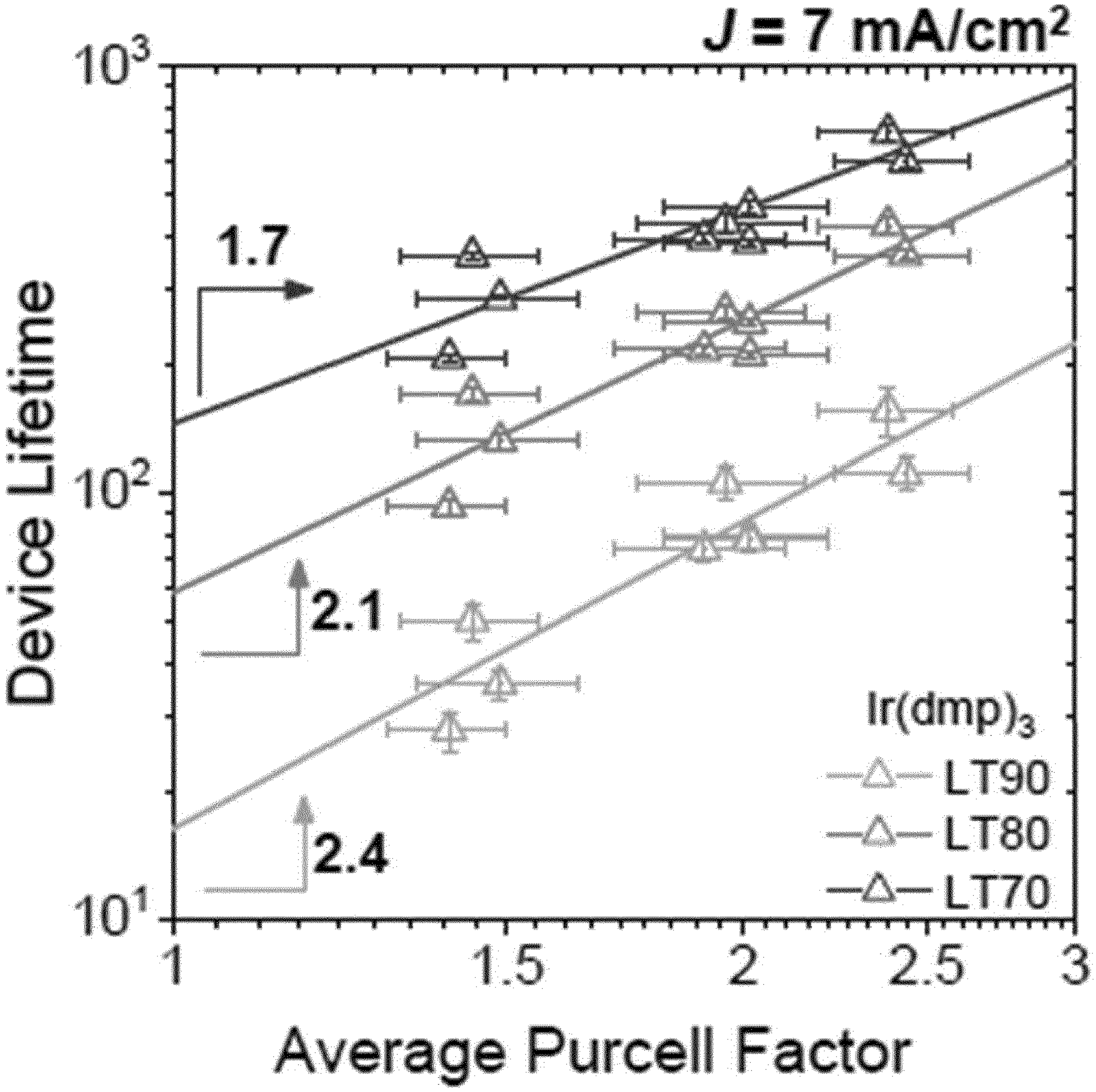
J = 7 mA/cm2
Device Lifetime
Average Purcell Factor
1.7
2.1
2.4
Ir(dmp)3
LT90
LT80
LT70
10^3
10^2
10^1
1
1.5
2
2.5
3

FIG. 7A

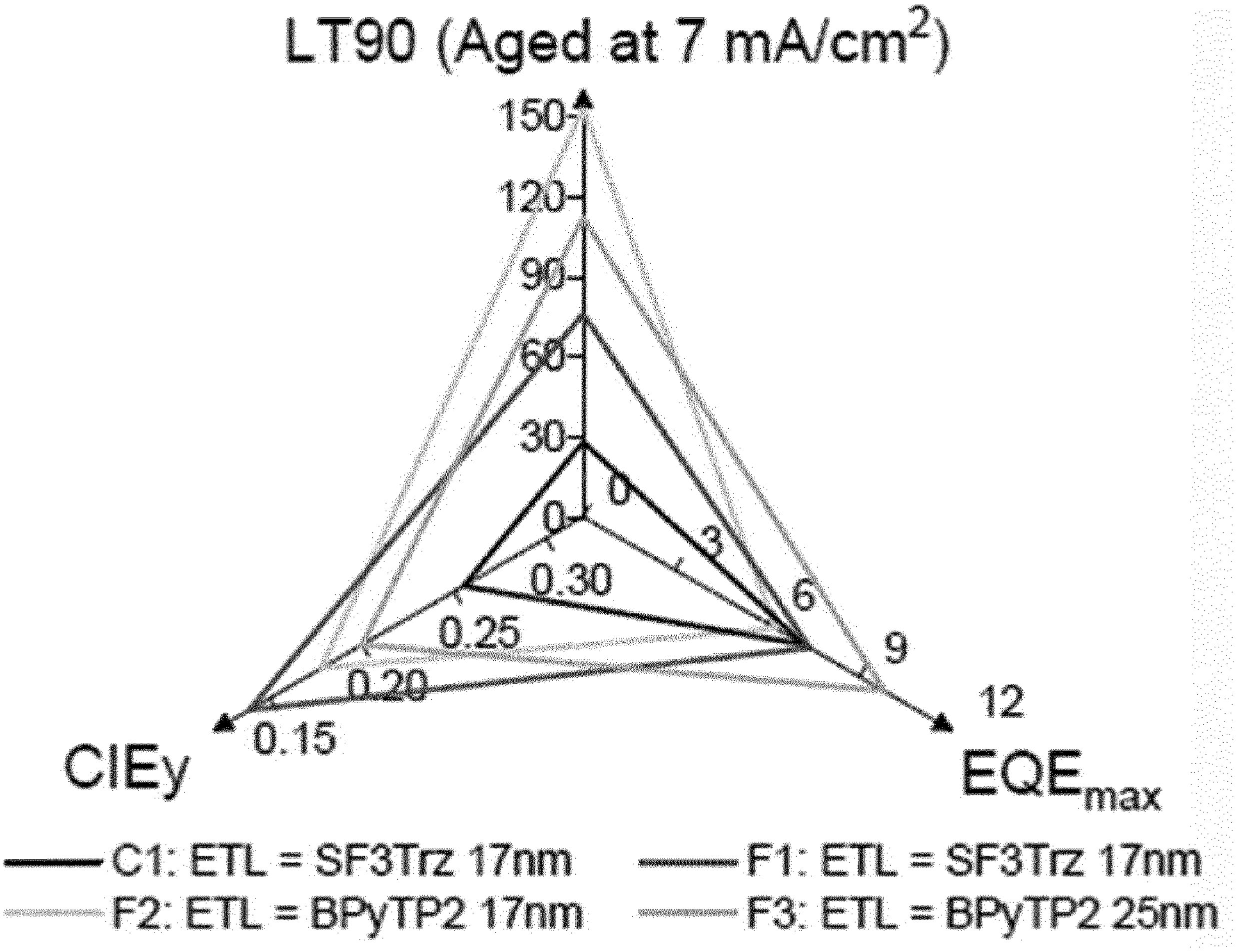

LT90 (Aged at 7 mA/cm²)
150
120
90
60
30
0
0
3
6
9
12
0.30
0.25
0.20
0.15
CIEy
EQEmax
C1: ETL = SF3Trz 17nm
F1: ETL = SF3Trz 17nm
F2: ETL = BPyTP2 17nm
F3: ETL = BPyTP2 25nm


FIG. 7B

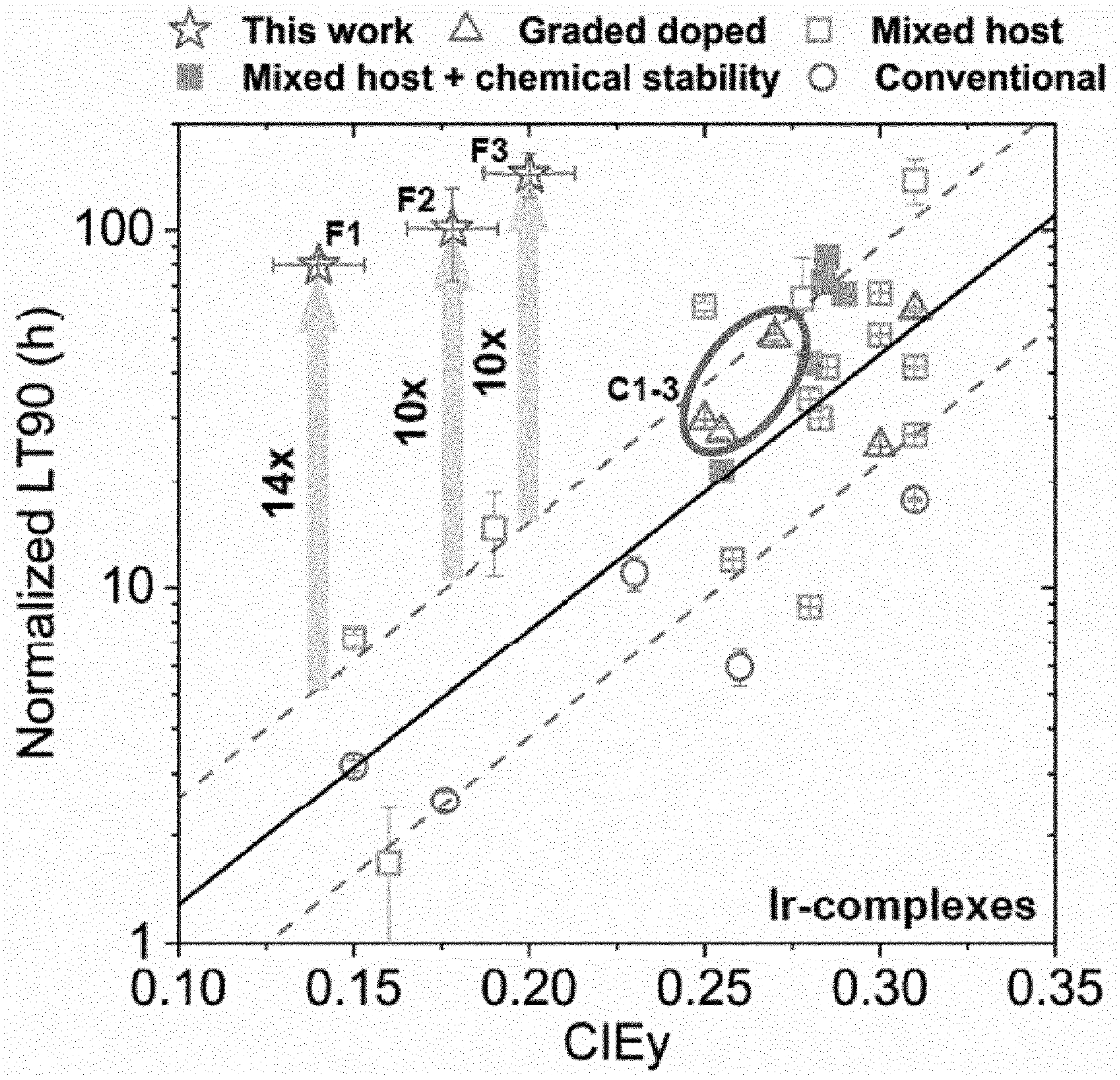
This work
Graded doped
Mixed host
Mixed host + chemical stability
Conventional
F1
F2
F3
14x
10x
10x
C1-3
Ir-complexes
Normalized LT90 (h)
100
10
1
0.10
0.15
0.20
0.25
0.30
0.35
CIEy

FIG. 7C

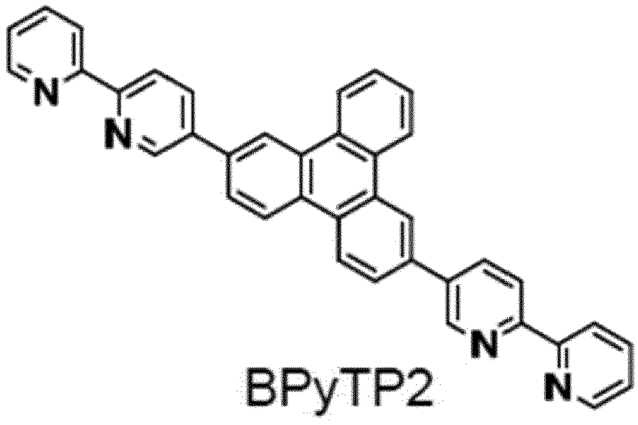

BPyTP2

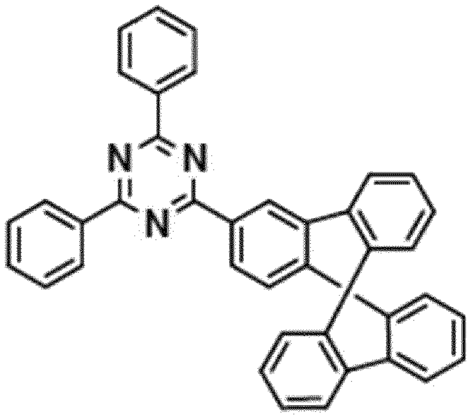

SF3Trz

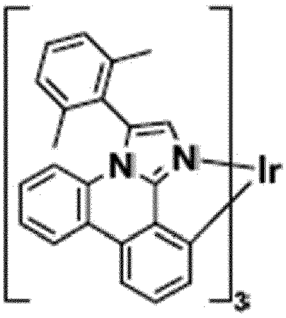

$Ir(dmp)_3$

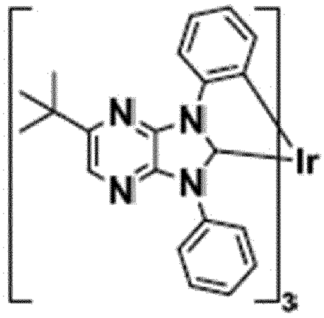

$Ir(cb)_3$

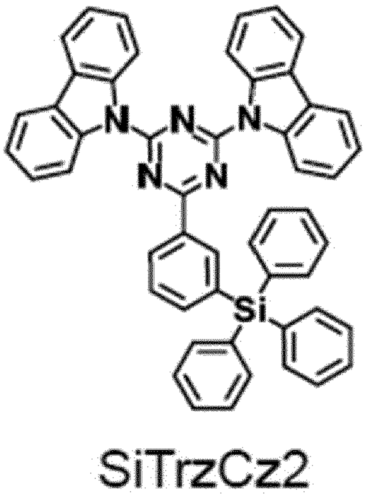

SiTrzCz2

FIG. 8

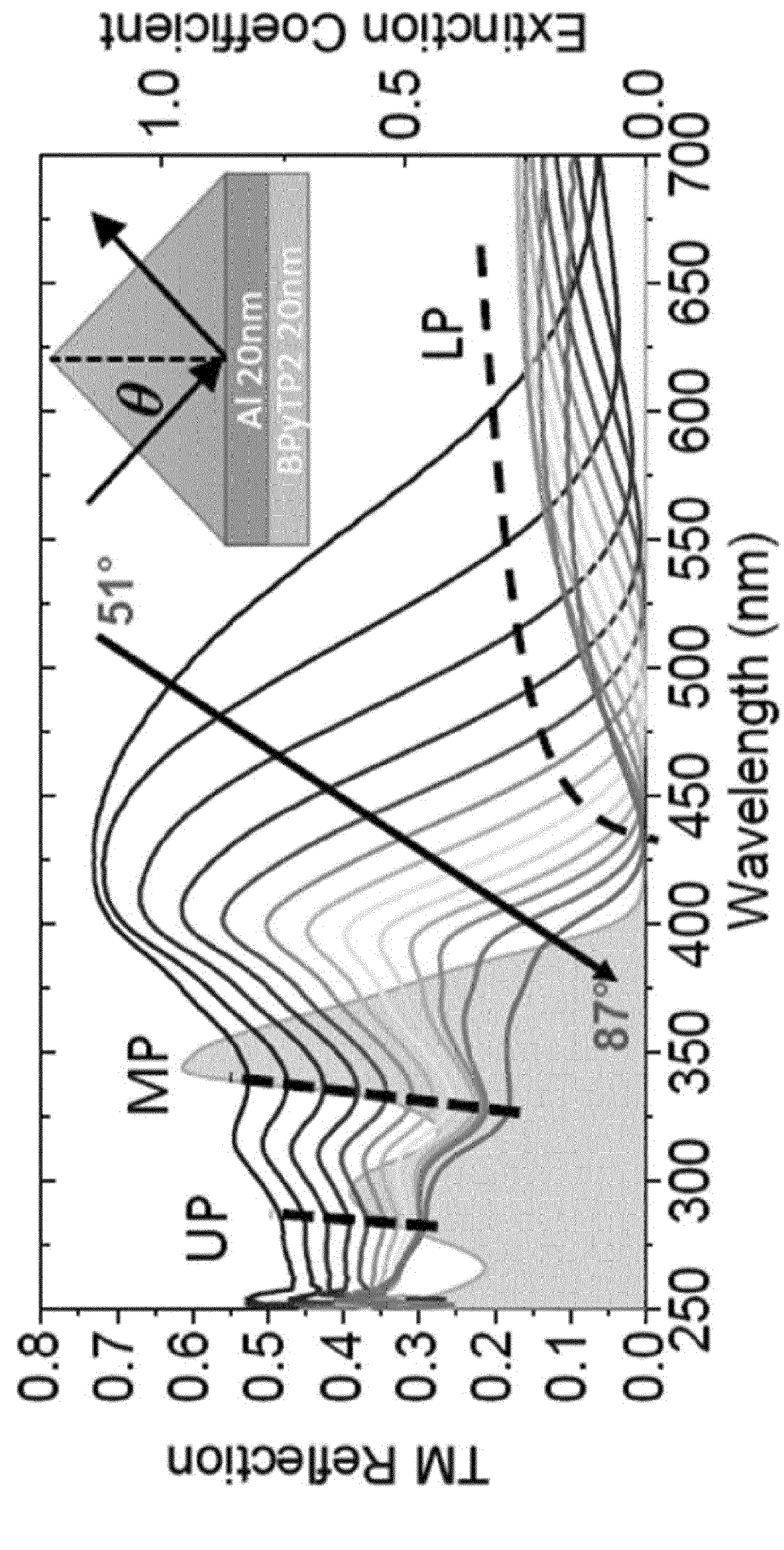
TM Reflection
Extinction Coefficient
Wavelength (nm)
UP
MP
LP
51°
87°
θ
Al 20nm
BPyTP2 20nm
0.0
0.1
0.2
0.3
0.4
0.5
0.6
0.7
0.8
0.5
1.0
250
300
350
400
450
500
550
600
650
700

FIG. 9

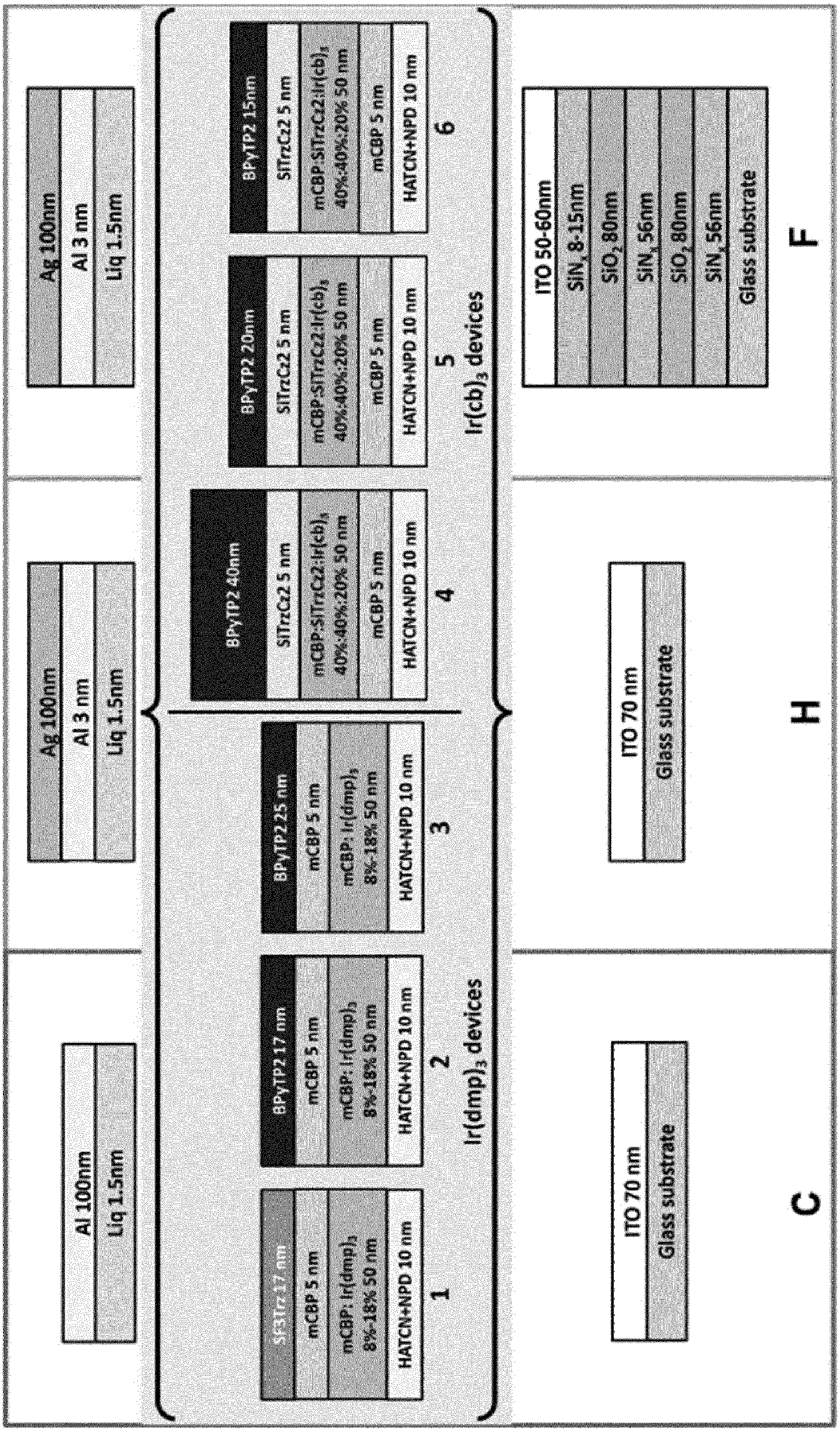
Al 100nm
Liq 1.5nm
Ag 100nm
Al 3 nm
Liq 1.5nm
Ag 100nm
Al 3 nm
Liq 1.5nm
SF3Trz 17 nm
mCBP 5 nm
mCBP: Ir(dmp)$_3$ 8%-18% 50 nm
HATCN+NPD 10 nm
1
BPyTP2 17 nm
mCBP 5 nm
mCBP: Ir(dmp)$_3$ 8%-18% 50 nm
HATCN+NPD 10 nm
2
BPyTP2 25 nm
mCBP 5 nm
mCBP: Ir(dmp)$_3$ 8%-18% 50 nm
HATCN+NPD 10 nm
3
Ir(dmp)$_3$ devices
BPyTP2 40nm
SiTrzCz2 5 nm
mCBP:SiTrzCz2:Ir(cb)$_3$ 40%:40%:20% 50 nm
mCBP 5 nm
HATCN+NPD 10 nm
4
BPyTP2 20nm
SiTrzCz2 5 nm
mCBP:SiTrzCz2:Ir(cb)$_3$ 40%:40%:20% 50 nm
mCBP 5 nm
HATCN+NPD 10 nm
5
BPyTP2 15nm
SiTrzCz2 5 nm
mCBP:SiTrzCz2:Ir(cb)$_3$ 40%:40%:20% 50 nm
mCBP 5 nm
HATCN+NPD 10 nm
6
Ir(cb)$_3$ devices
ITO 70 nm
Glass substrate
C
ITO 70 nm
Glass substrate
H
ITO 50-60nm
SiN$_x$ 8-15nm
SiO$_2$ 80nm
SiN$_x$ 56nm
SiO$_2$ 80nm
SiN$_x$ 56nm
Glass substrate
F

FIG. 10

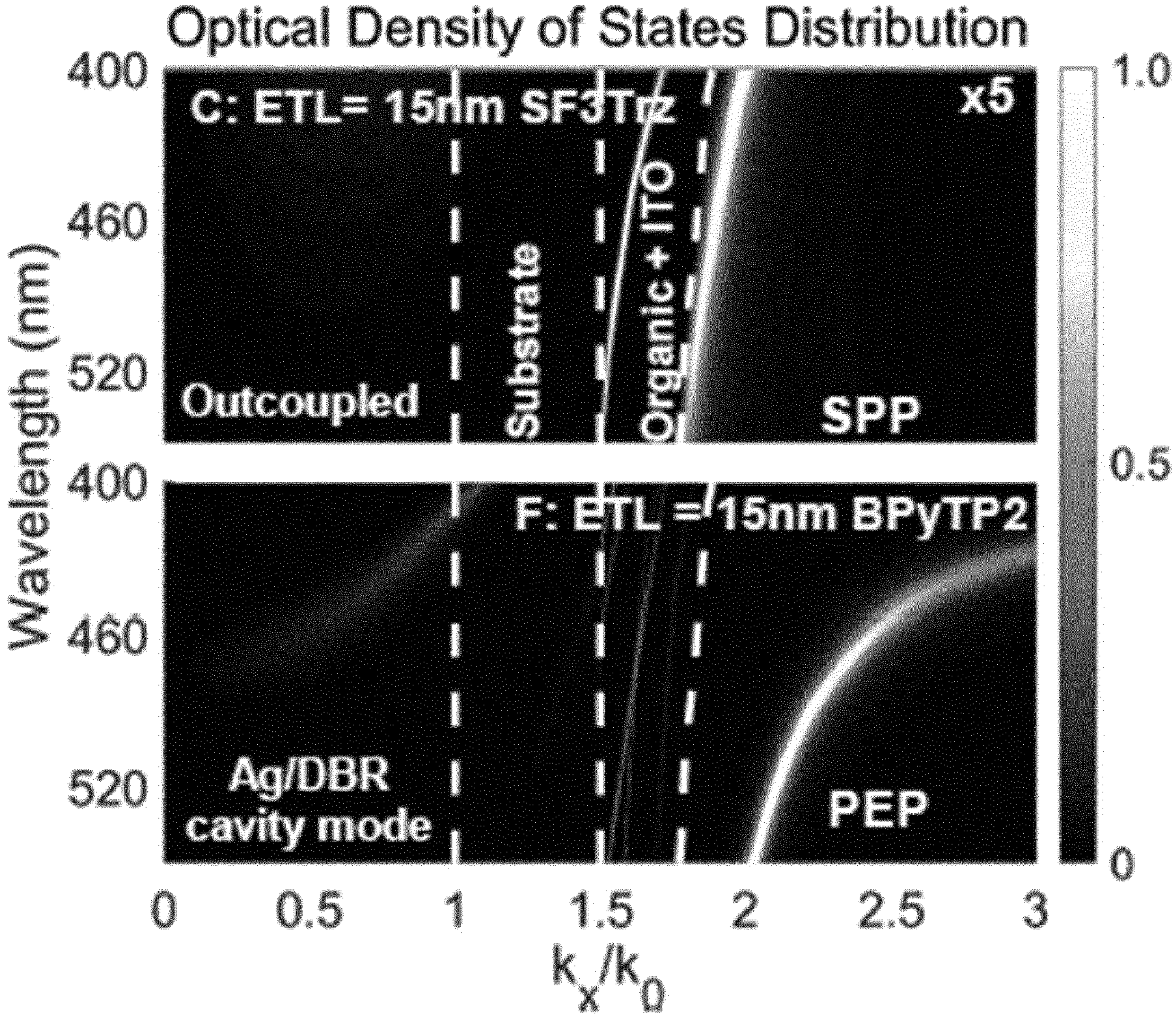
Optical Density of States Distribution
C: ETL= 15nm SF3Trz
x5
Outcoupled
Substrate
Organic + ITO
SPP
F: ETL = 15nm BPyTP2
Ag/DBR
cavity mode
PEP
Wavelength (nm)
400
460
520
400
460
520
0
0.5
1
1.5
2
2.5
3
k_x/k_0
1.0
0.5
0

FIG. 11A

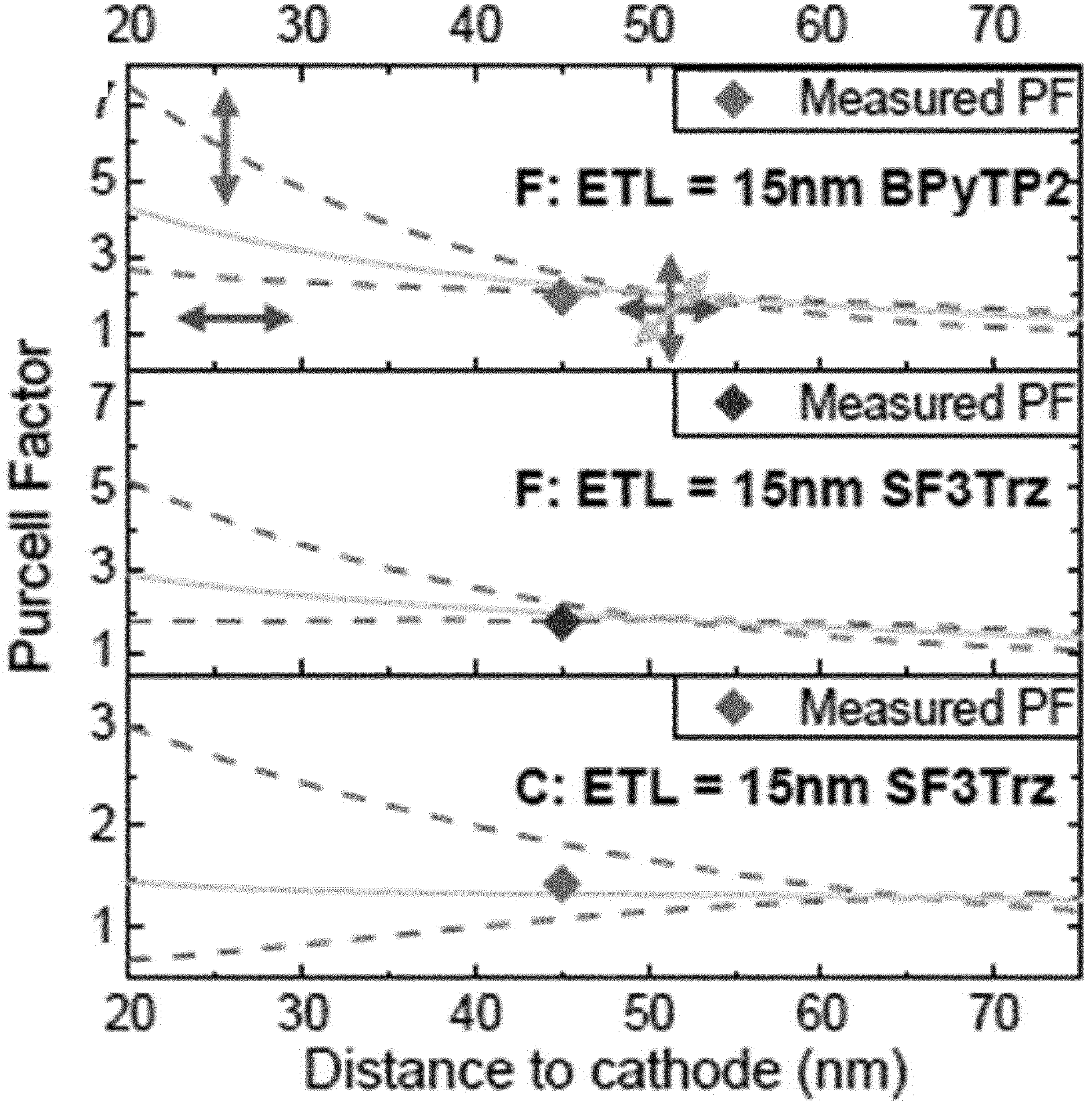
Measured PF
F: ETL = 15nm BPyTP2
Measured PF
F: ETL = 15nm SF3Trz
Measured PF
C: ETL = 15nm SF3Trz
Purcell Factor
Distance to cathode (nm)

FIG. 11B

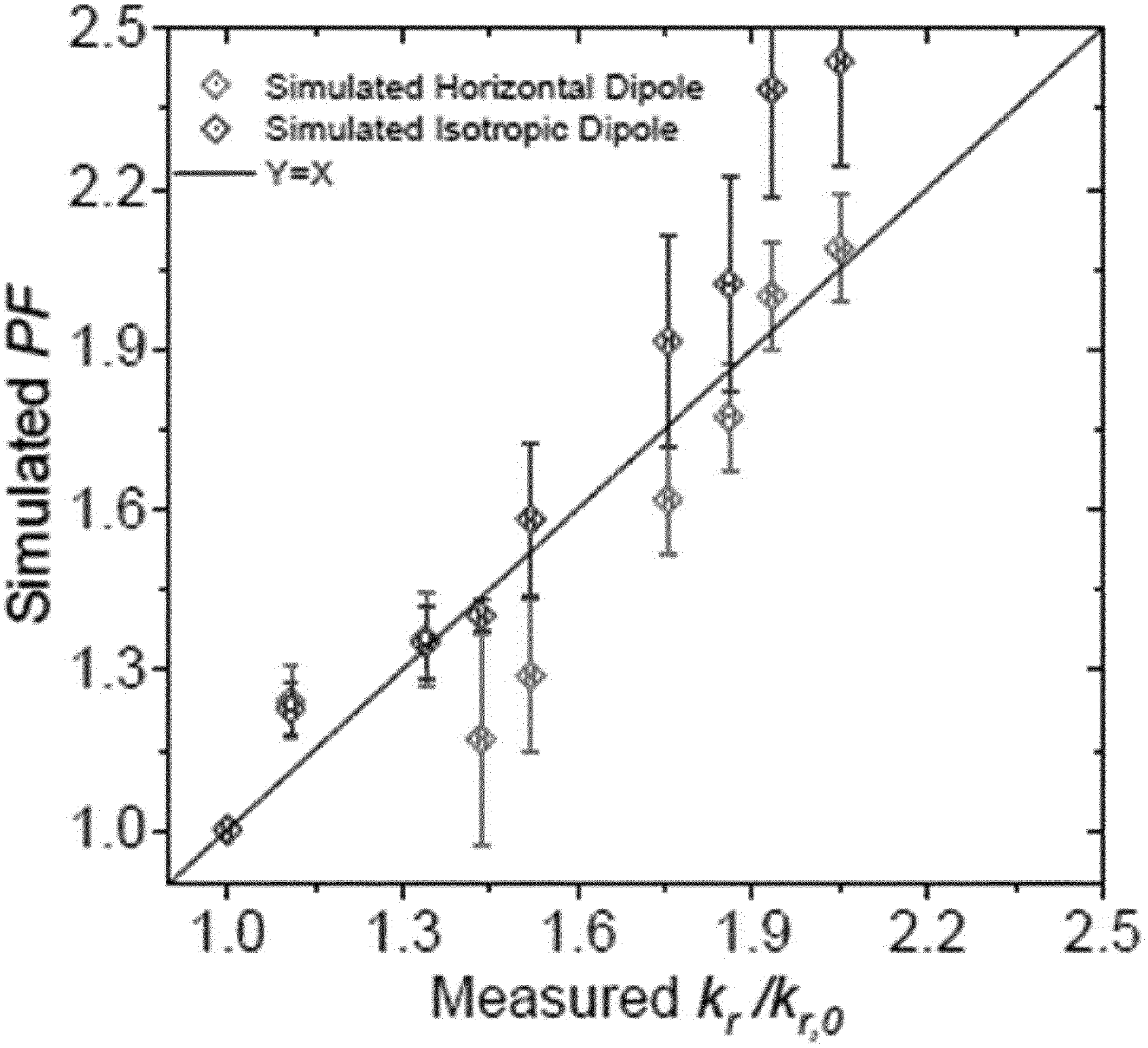
Simulated Horizontal Dipole
Simulated Isotropic Dipole
Y=X
Simulated PF
Measured $k_r/k_{r,0}$
1.0
1.3
1.6
1.9
2.2
2.5

FIG. 11C

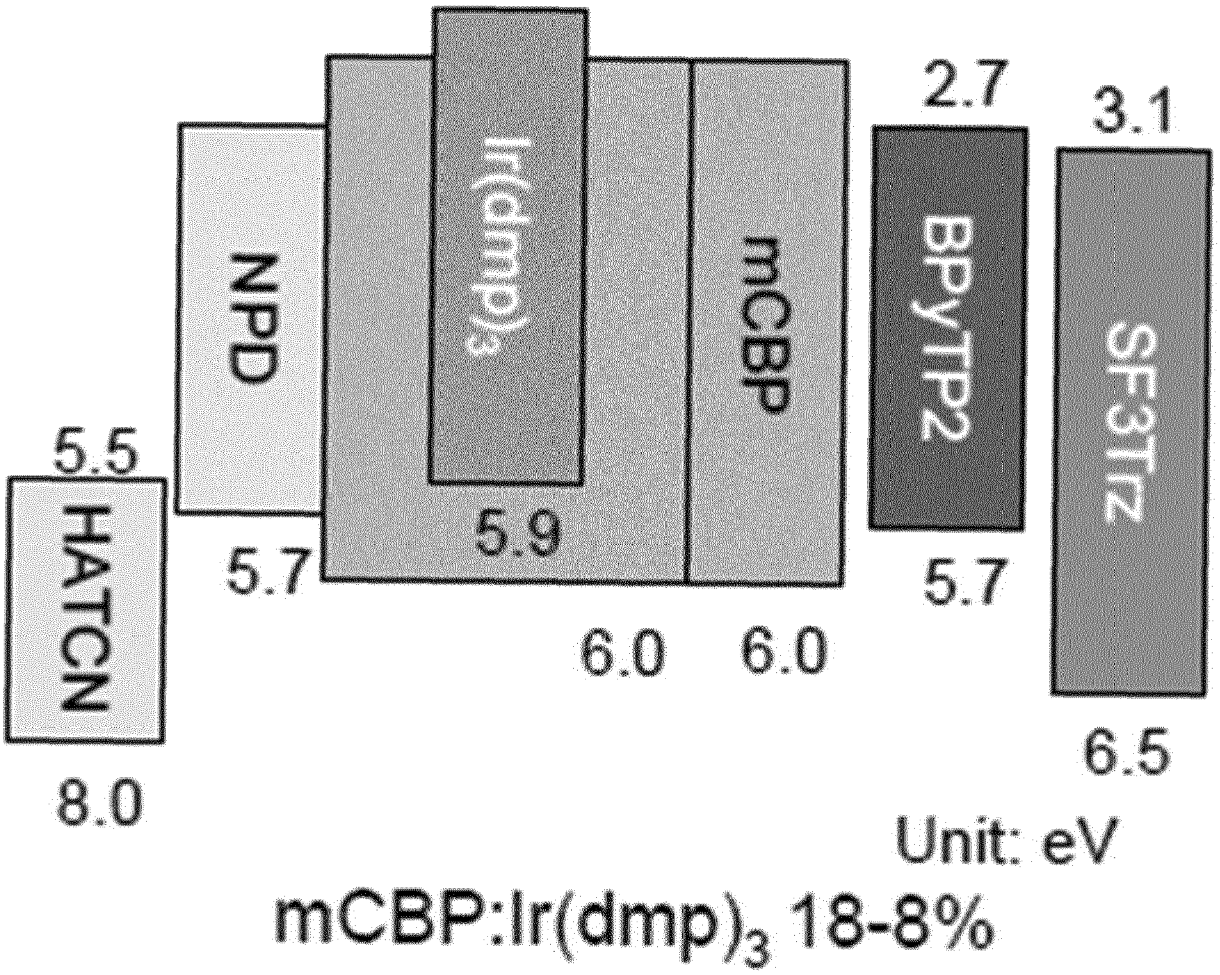

2.7
3.1
Ir(dmp)3
NPD
mCBP
BPyTP2
SF3Trz
5.5
HATCN
5.9
5.7
5.7
6.0
6.0
6.5
8.0
Unit: eV
mCBP:Ir(dmp)3 18-8%


FIG. 12A

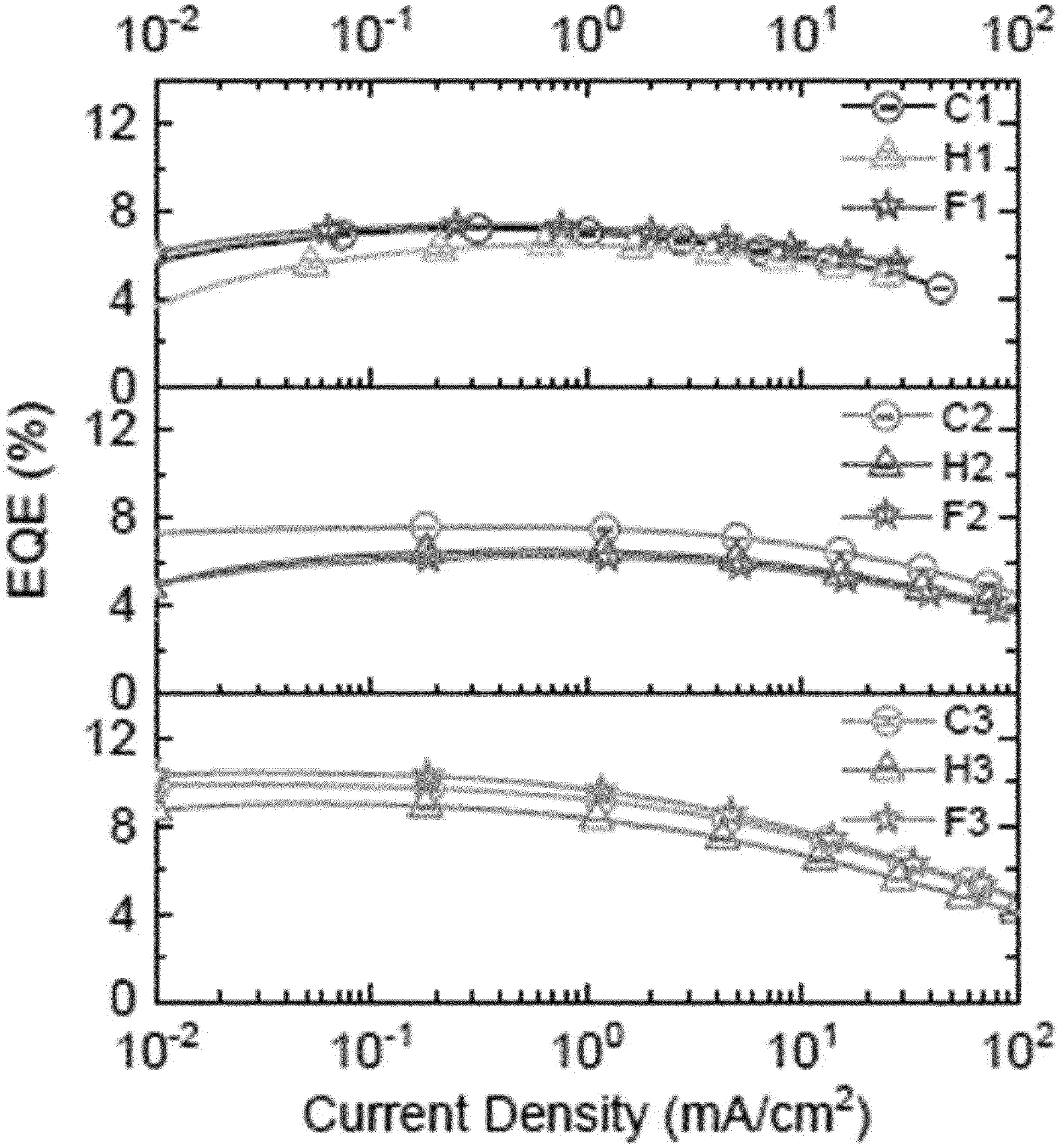
10-2
10-1
100
101
102
12
8
4
0
C1
H1
F1
C2
H2
F2
C3
H3
F3
EQE (%)
Current Density (mA/cm2)

FIG. 12B

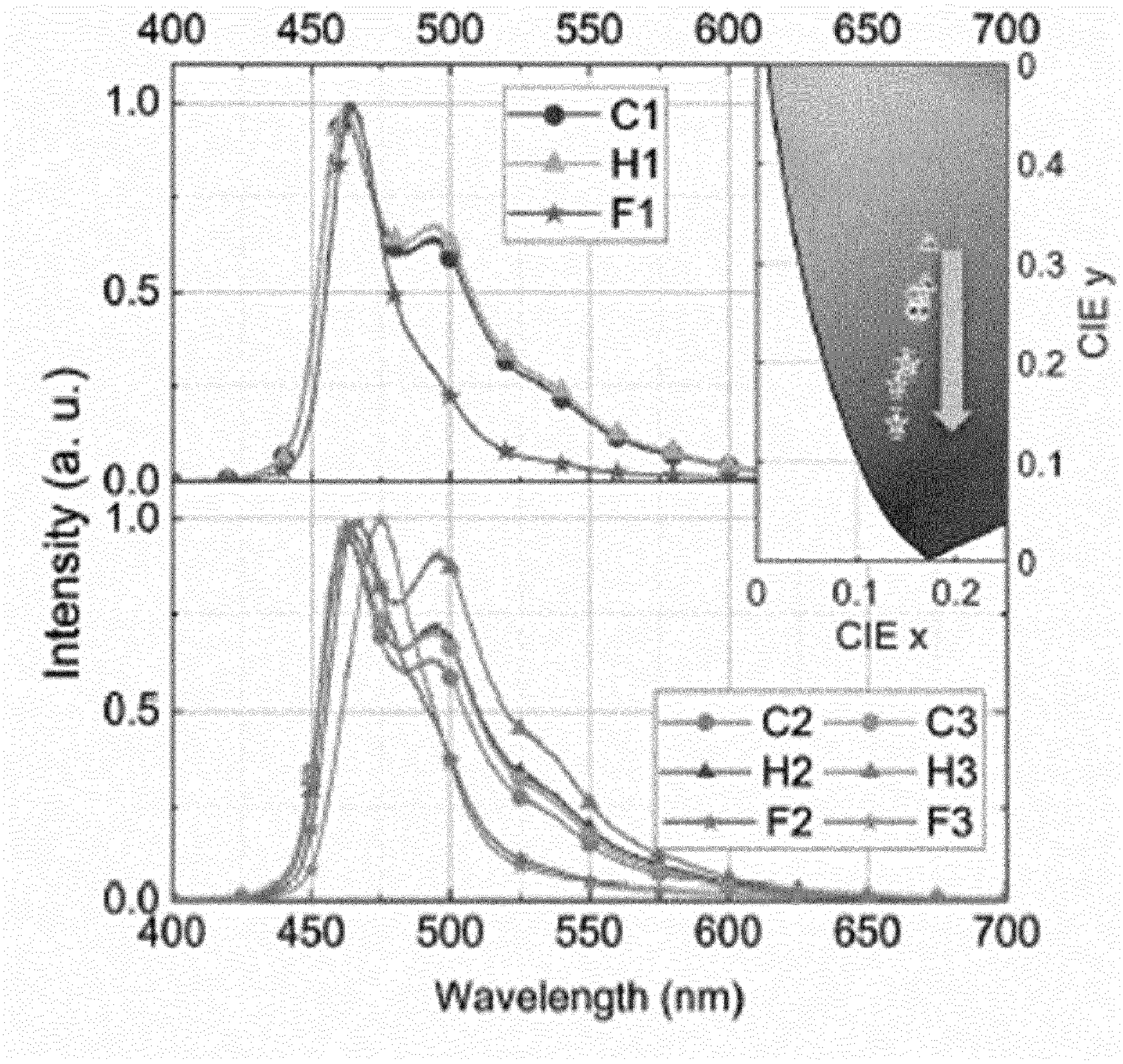
400
450
500
550
600
650
700
1.0
0.5
0.0
C1
H1
F1
Intensity (a. u.)
CIE y
0
0.4
0.3
0.2
0.1
0
0.1
0.2
CIE x
C2
C3
H2
H3
F2
F3
Wavelength (nm)

FIG. 12C

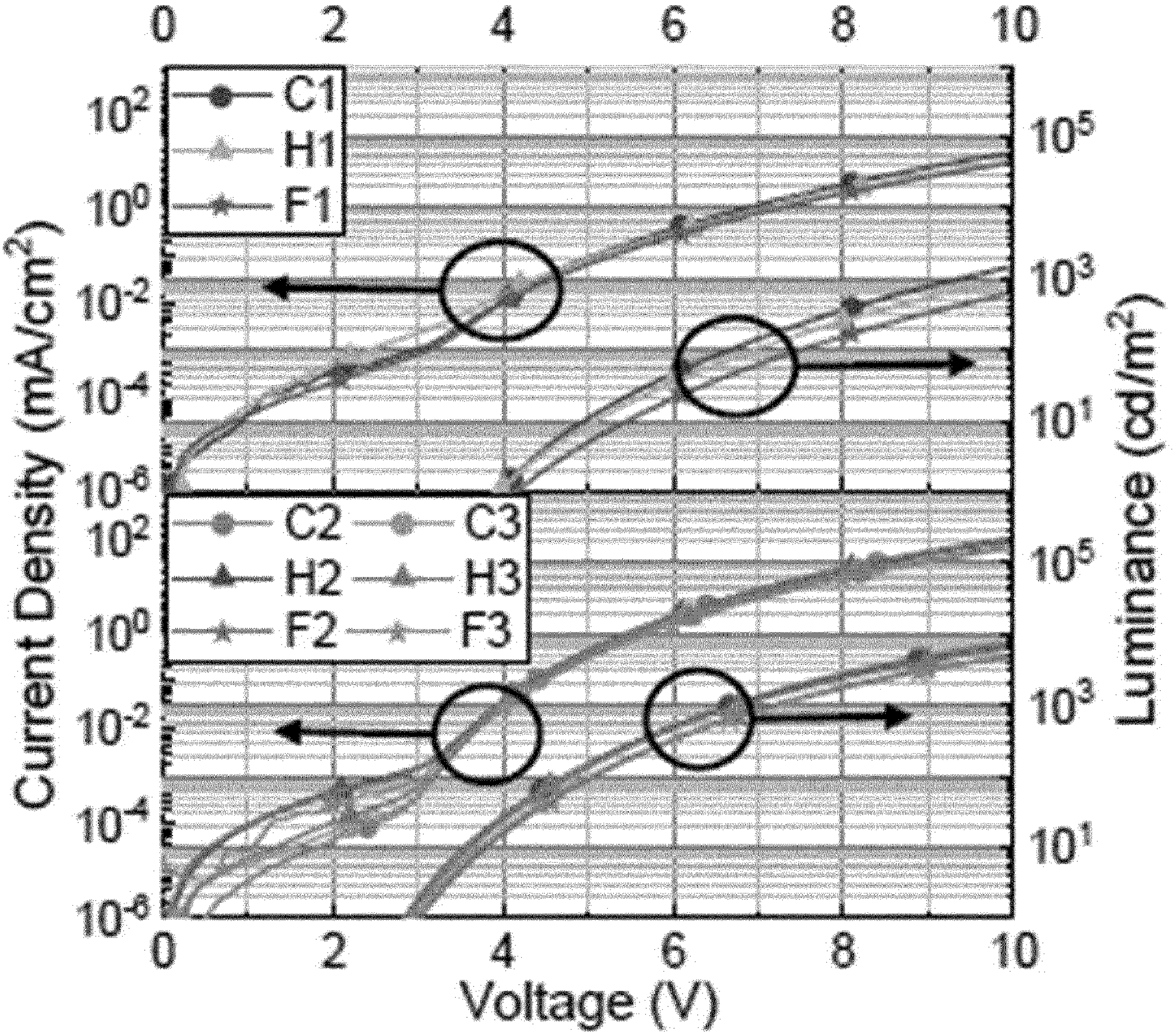
0
2
4
6
8
10
$10^2$
$10^0$
$10^{-2}$
$10^{-4}$
$10^{-6}$
C1
H1
F1
C2
C3
H2
H3
F2
F3
Current Density (mA/cm²)
Luminance (cd/m²)
$10^5$
$10^3$
$10^1$
Voltage (V)

FIG. 12D

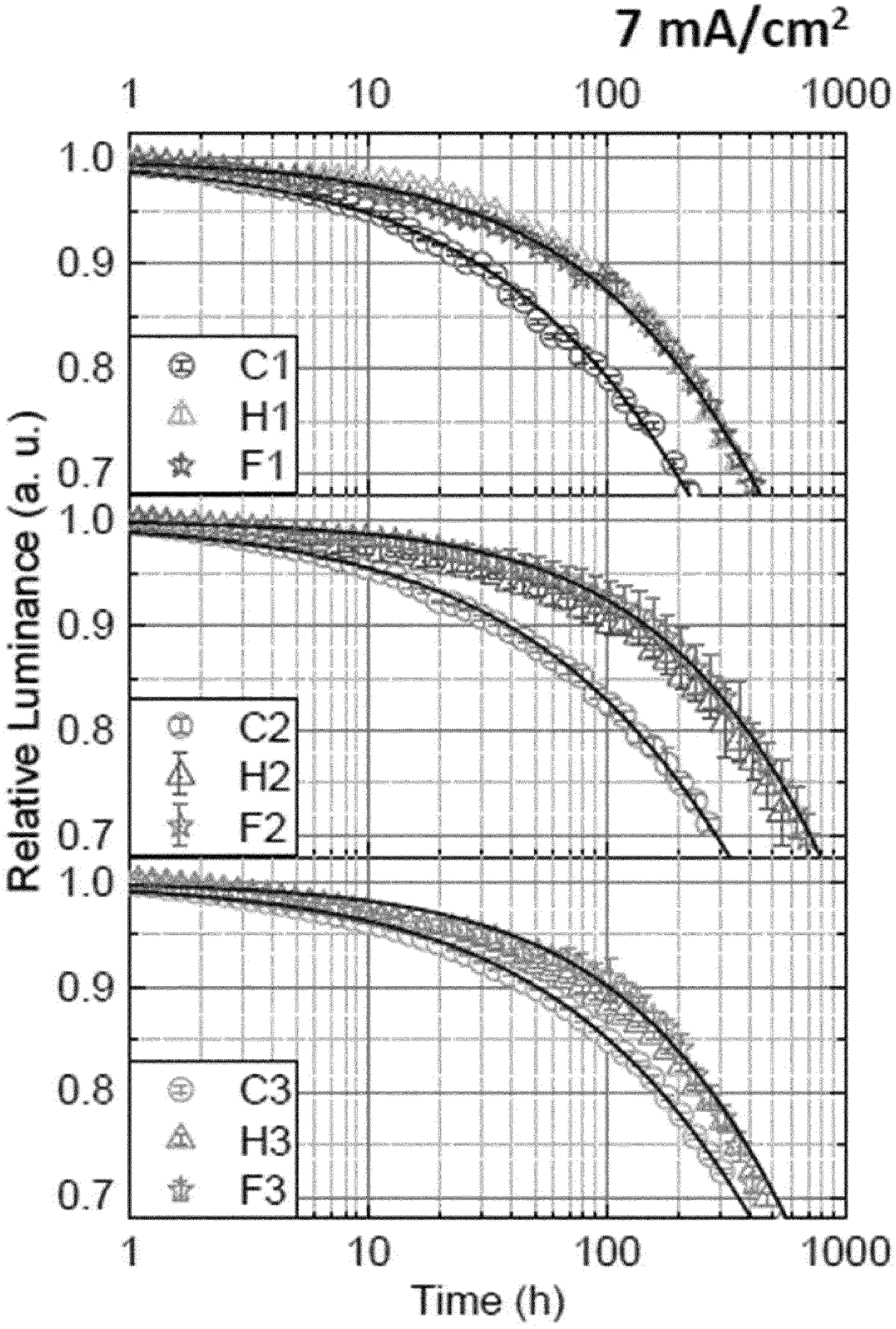
7 mA/cm2
1
10
100
1000
1.0
0.9
0.8
0.7
C1
H1
F1
C2
H2
F2
C3
H3
F3
Relative Luminance (a. u.)
Time (h)

FIG. 12E

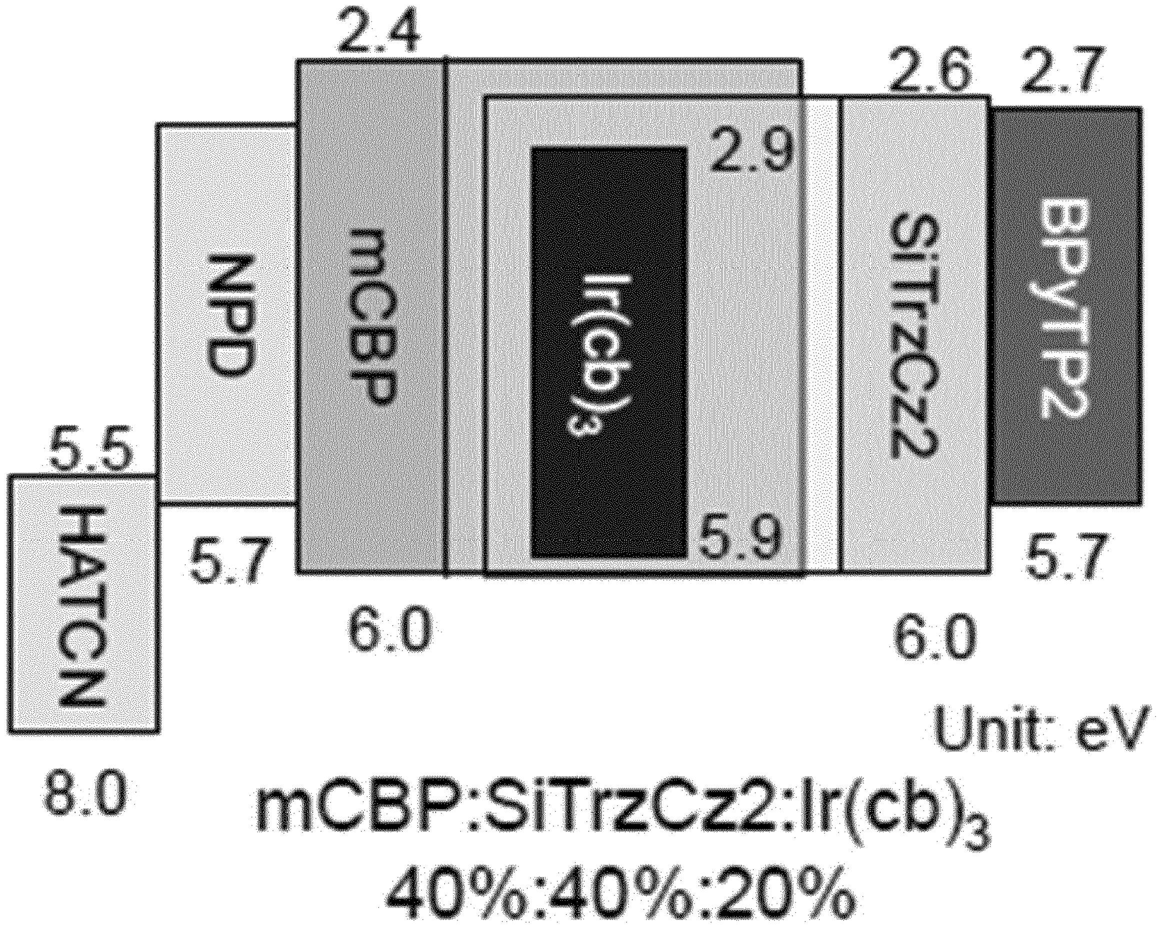
2.4
2.6
2.7
2.9
NPD
mCBP
Ir(cb)3
SiTrzCz2
BPyTP2
5.5
HATCN
5.7
5.9
5.7
6.0
6.0
Unit: eV
8.0
mCBP:SiTrzCz2:Ir(cb)3
40%:40%:20%

FIG. 13A

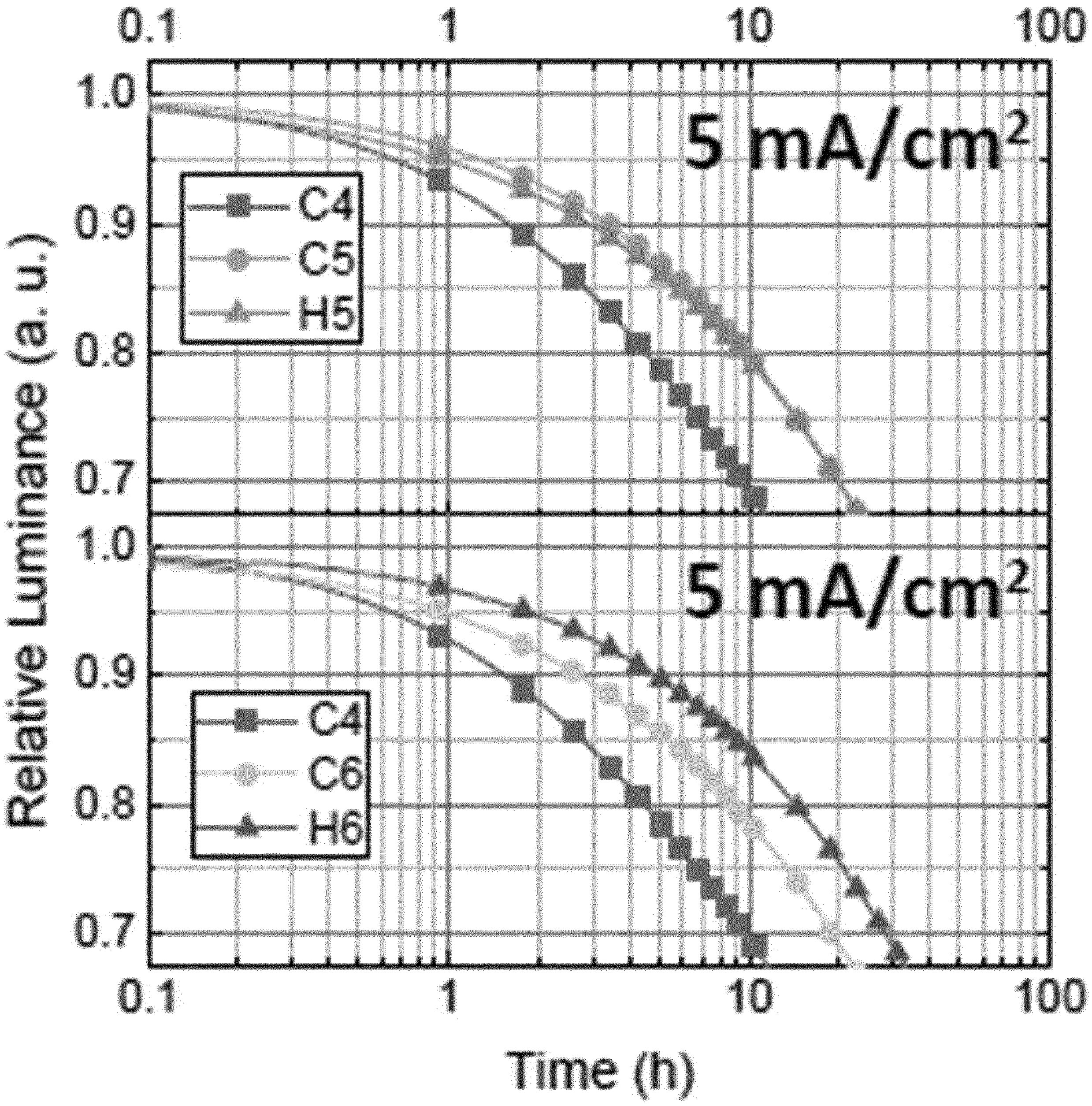
0.1
1
10
100
1.0
0.9
0.8
0.7
5 mA/cm²
C4
C5
H5
5 mA/cm²
C4
C6
H6
Relative Luminance (a. u.)
Time (h)

FIG. 13B

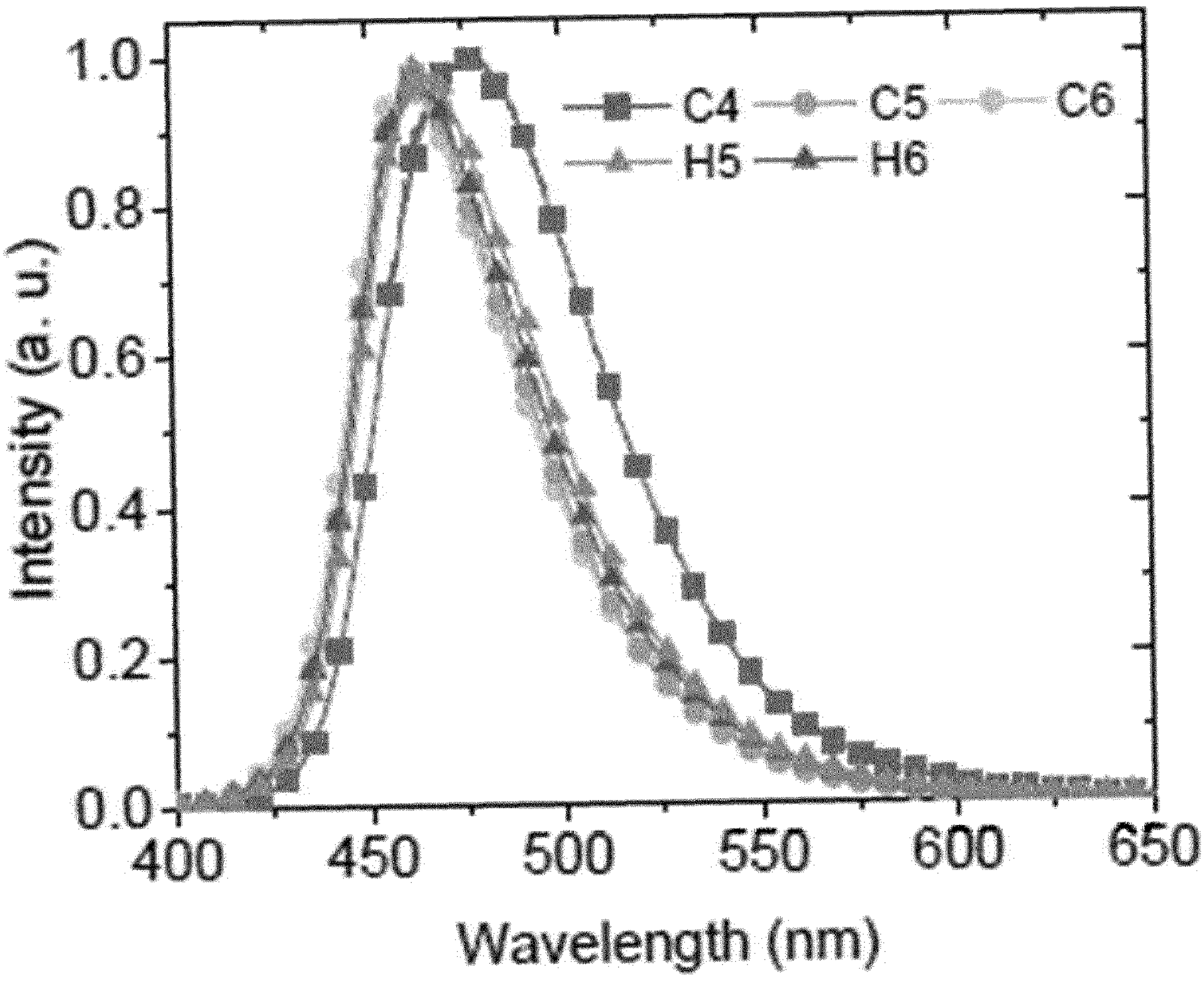
C4
C5
C6
H5
H6
Intensity (a. u.)
1.0
0.8
0.6
0.4
0.2
0.0
400
450
500
550
600
650
Wavelength (nm)

FIG. 13C

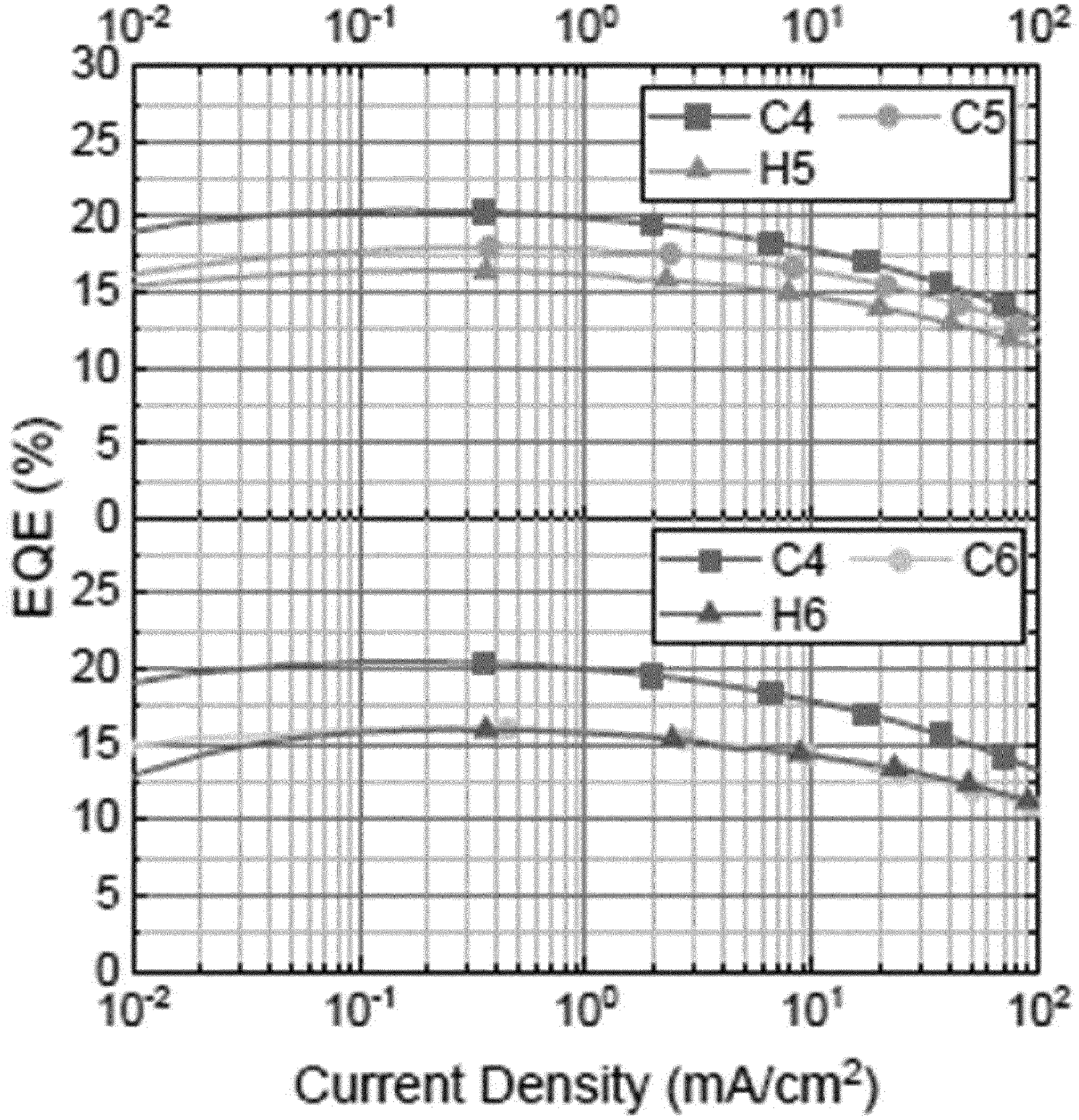

EQE (%)
Current Density (mA/cm2)
C4
C5
H5
C6
H6
30
25
20
15
10
5
0
10-2
10-1
100
101
102


FIG. 13D

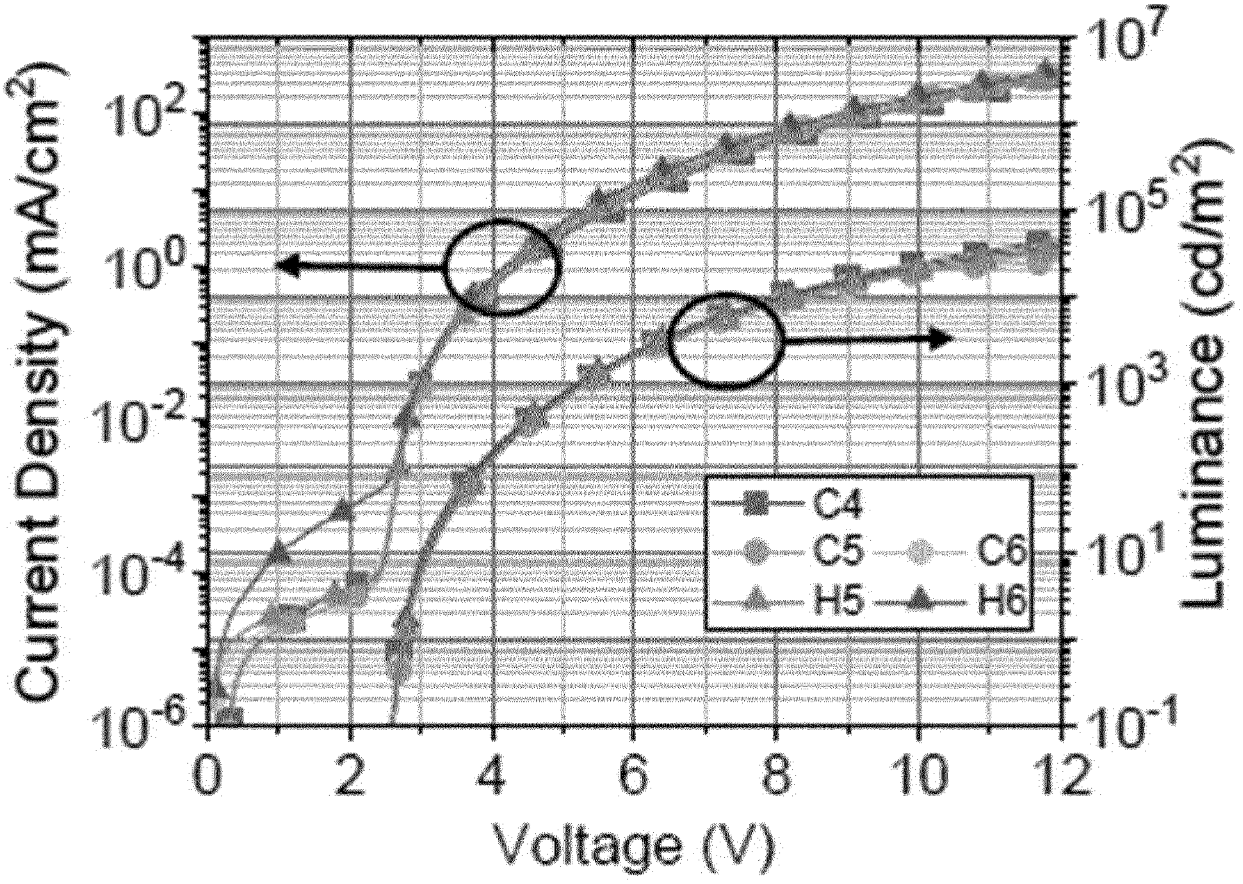

Current Density (mA/cm2)
Luminance (cd/m2)
Voltage (V)
C4
C5
C6
H5
H6


FIG. 13E

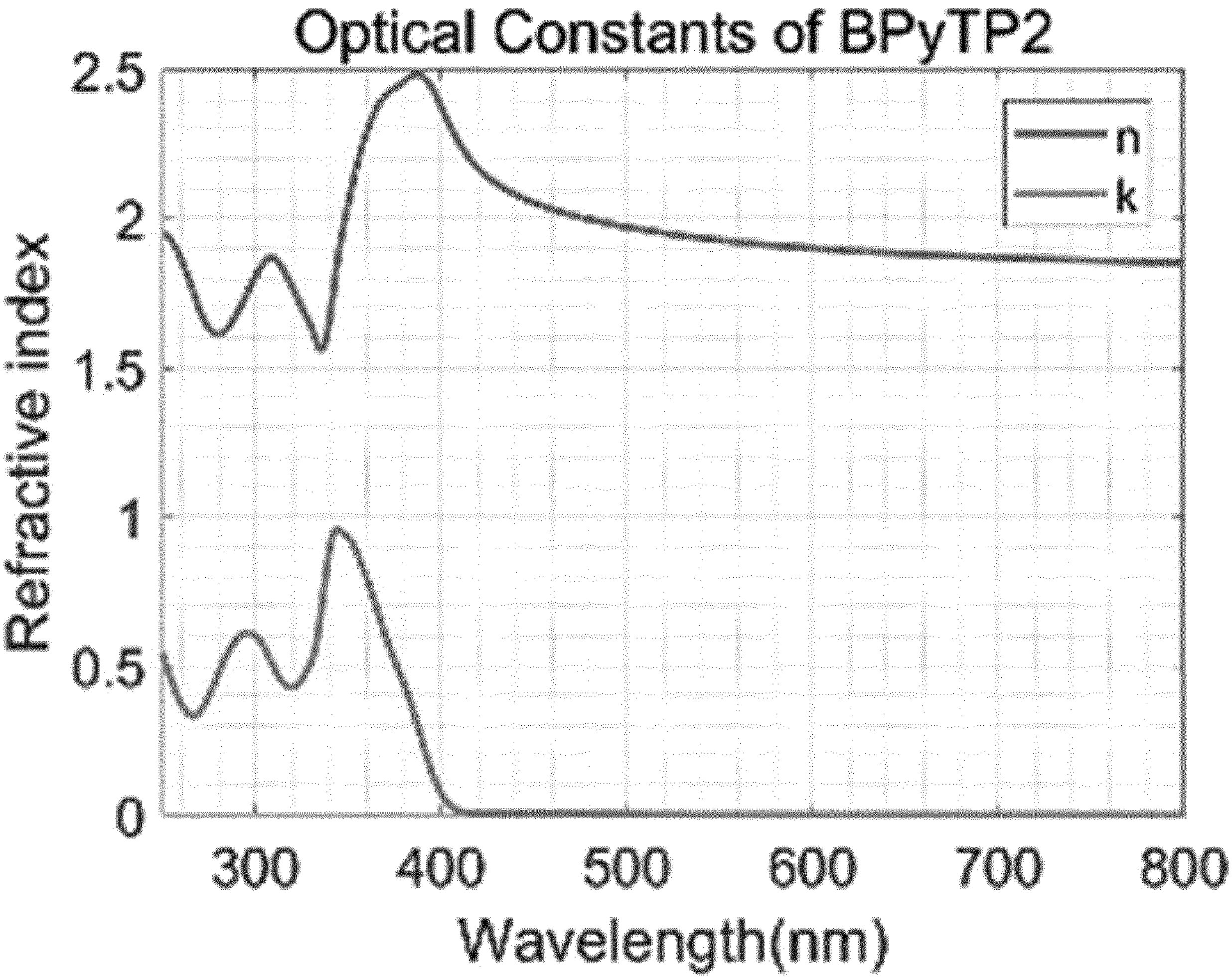
Optical Constants of BPyTP2
2.5
2
1.5
1
0.5
0
Refractive index
300
400
500
600
700
800
Wavelength(nm)
n
k

FIG. 14A

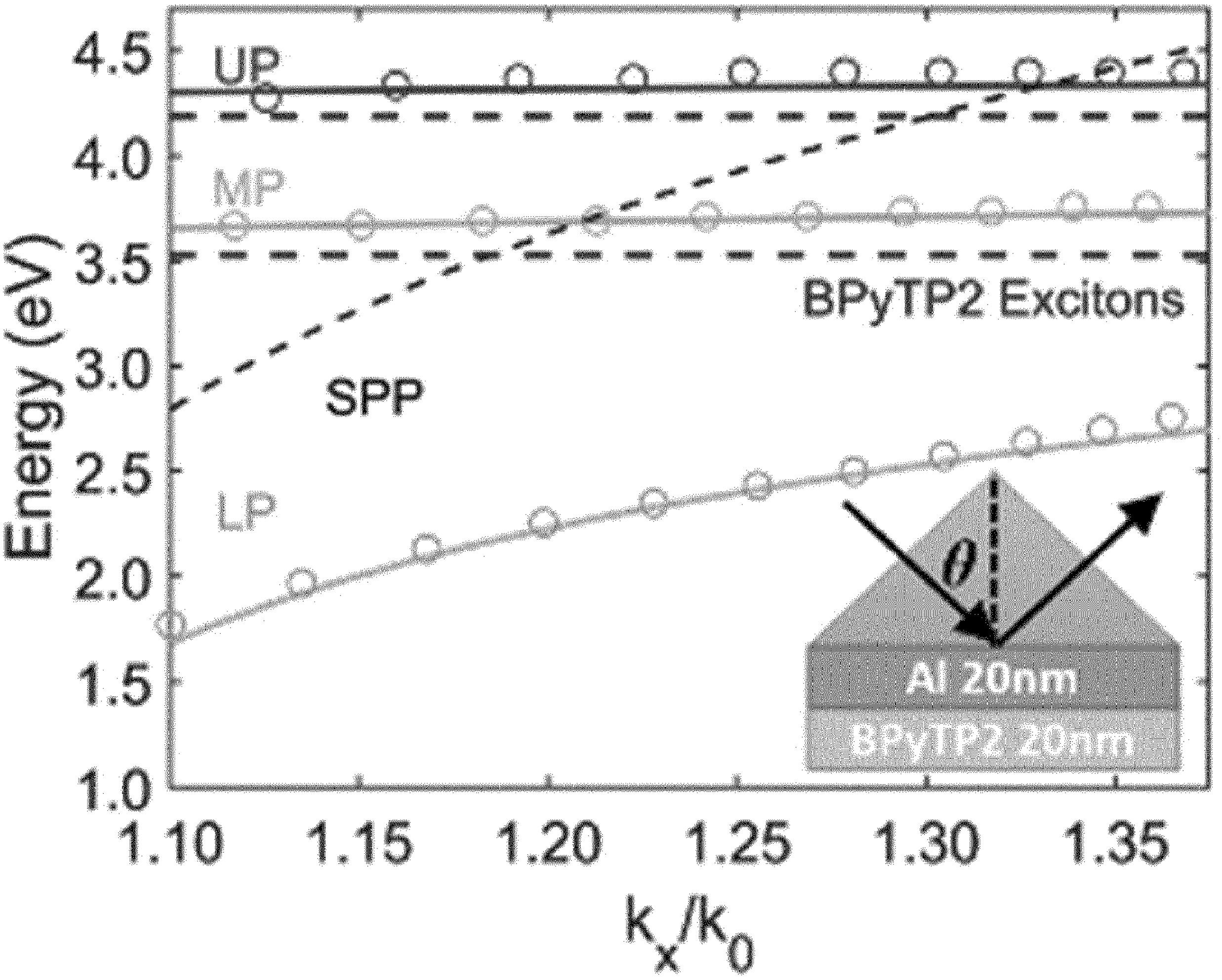
UP
MP
BPyTP2 Excitons
SPP
LP
Al 20nm
BPyTP2 20nm
θ
Energy (eV)
4.5
4.0
3.5
3.0
2.5
2.0
1.5
1.0
1.10
1.15
1.20
1.25
1.30
1.35
$k_x/k_0$

FIG. 14B

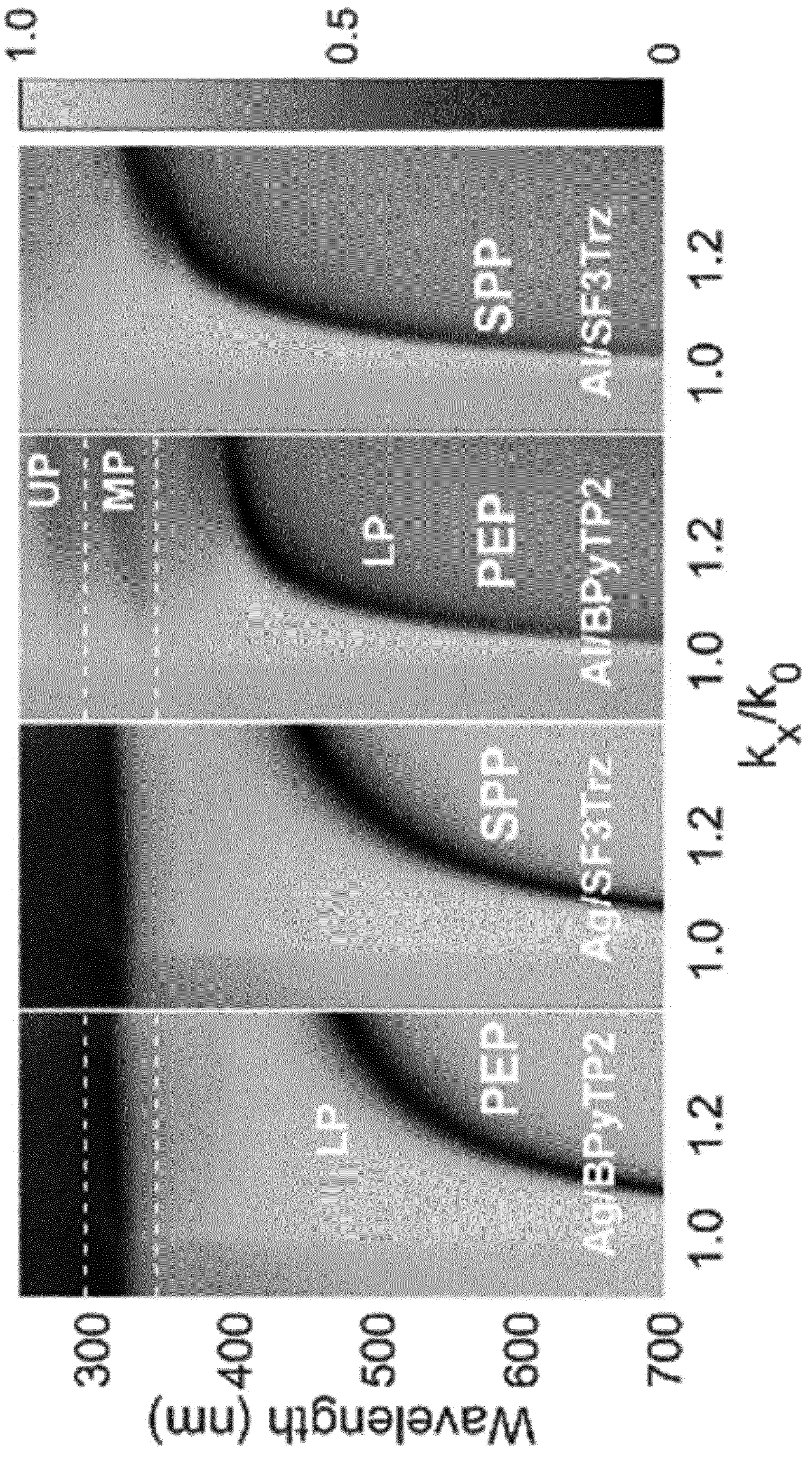
1.0
0.5
0
UP
MP
LP
PEP
SPP
Ag/BPyTP2
Ag/SF3Trz
Al/BPyTP2
Al/SF3Trz
1.0
1.2
$k_x/k_0$
300
400
500
600
700
Wavelength (nm)

FIG. 14C

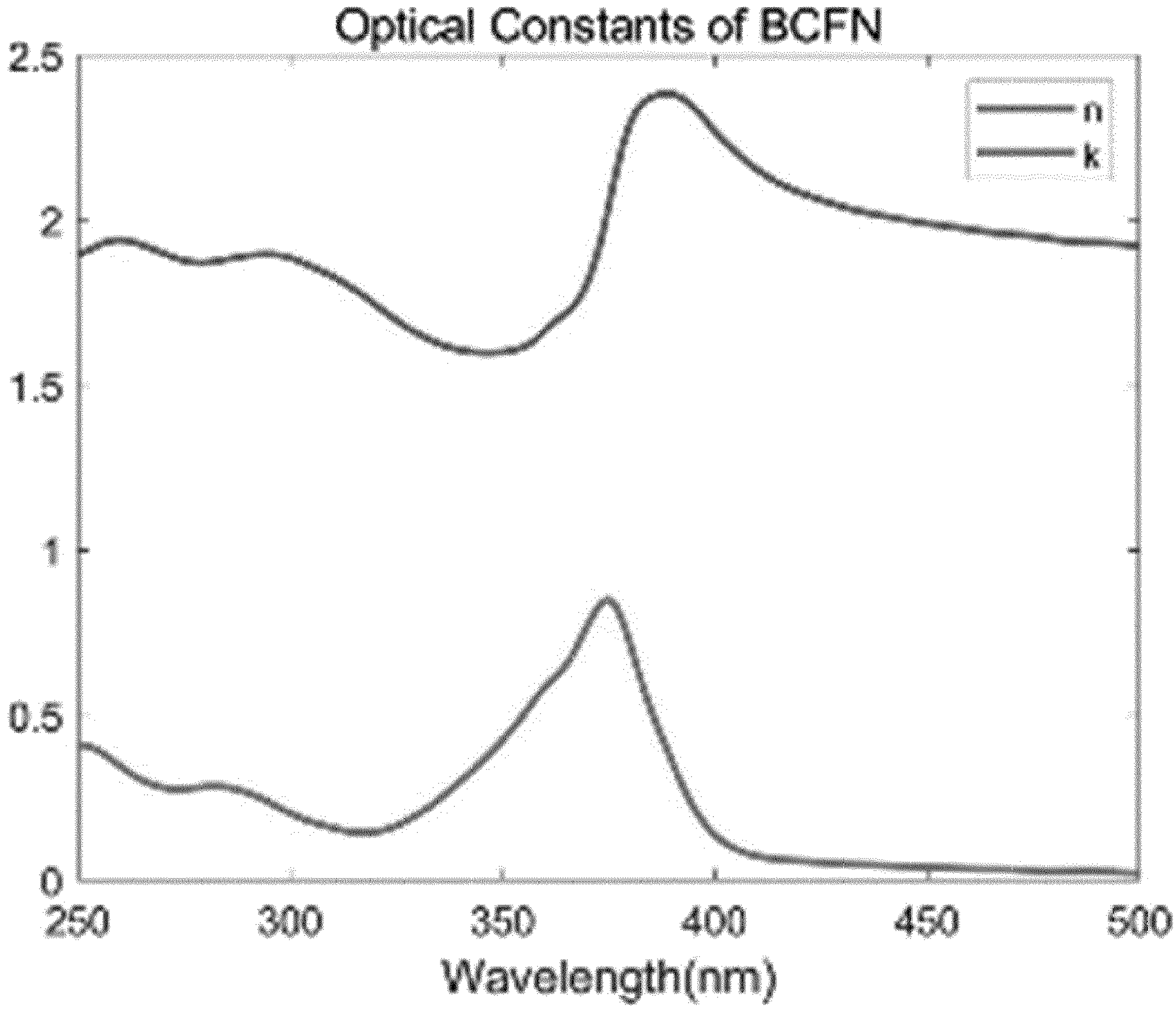
Optical Constants of BCFN
n
k
2.5
2
1.5
1
0.5
0
250
300
350
400
450
500
Wavelength(nm)

FIG. 14D

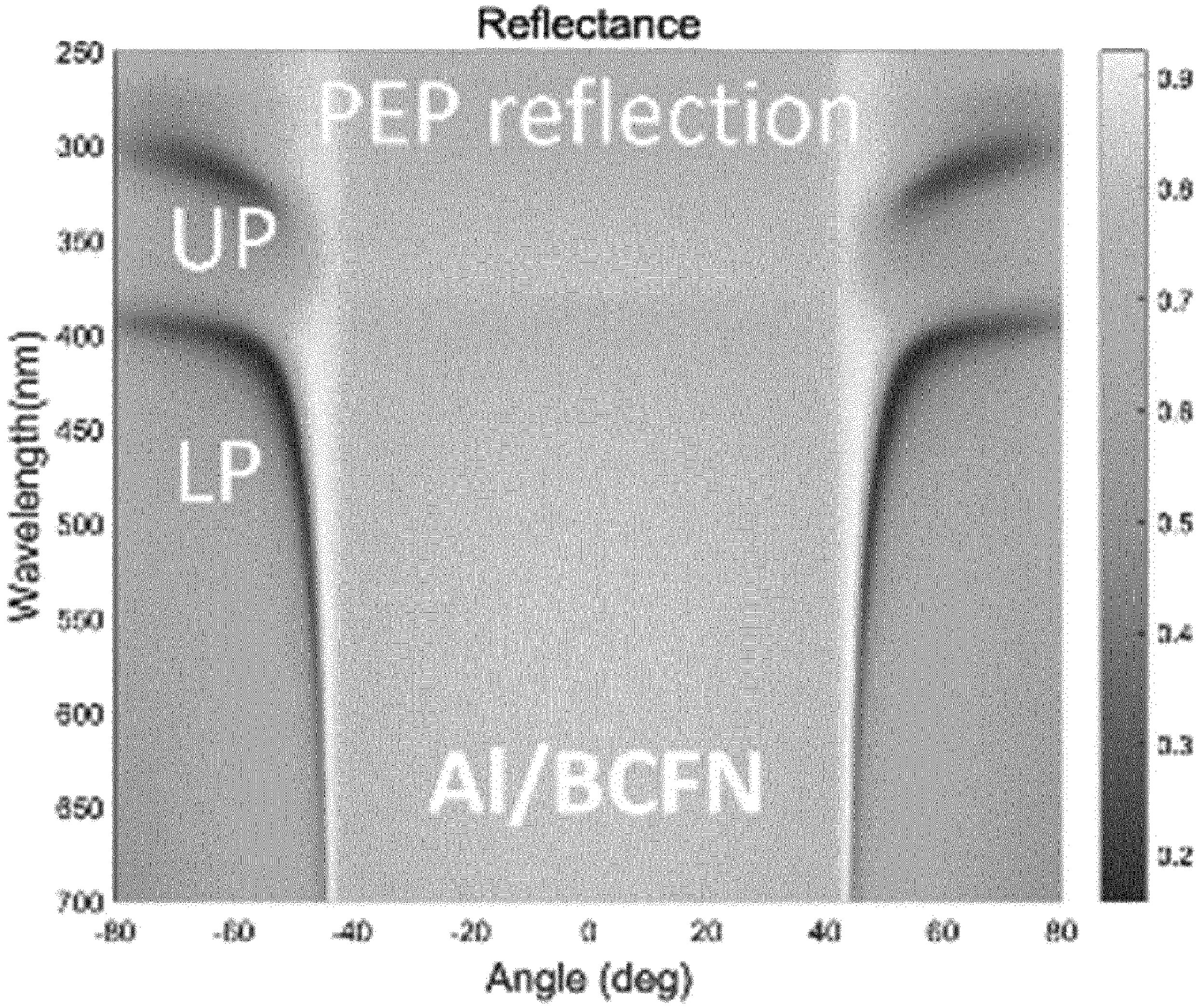
Reflectance
PEP reflection
UP
LP
Al/BCFN
Wavelength(nm)
250
300
350
400
450
500
550
600
650
700
-80
-60
-40
-20
0
20
40
60
80
Angle (deg)
0.9
0.8
0.7
0.6
0.5
0.4
0.3
0.2

FIG. 14E

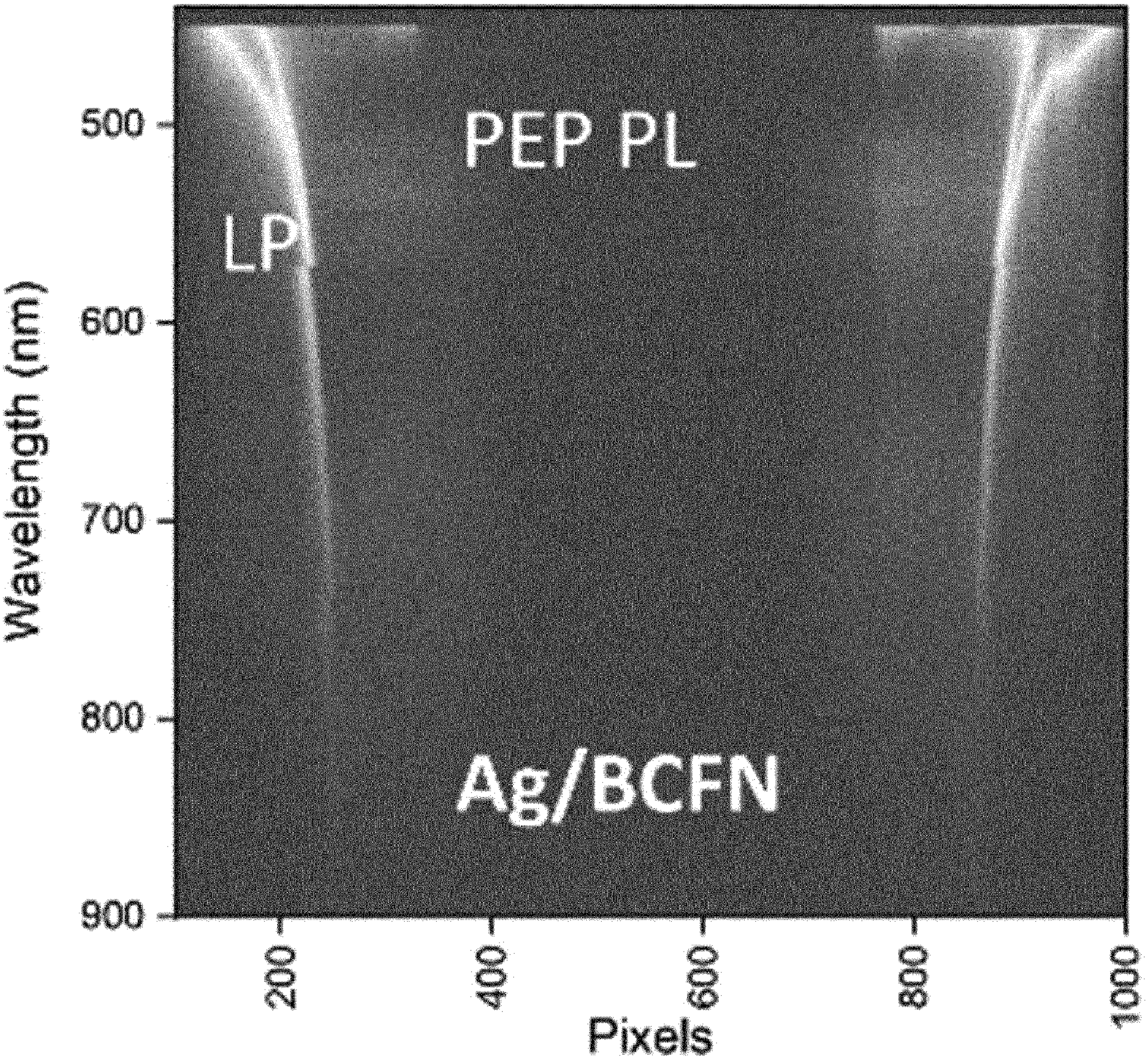
PEP PL
LP
Ag/BCFN
Wavelength (nm)
500
600
700
800
900
200
400
600
800
1000
Pixels

FIG. 14F

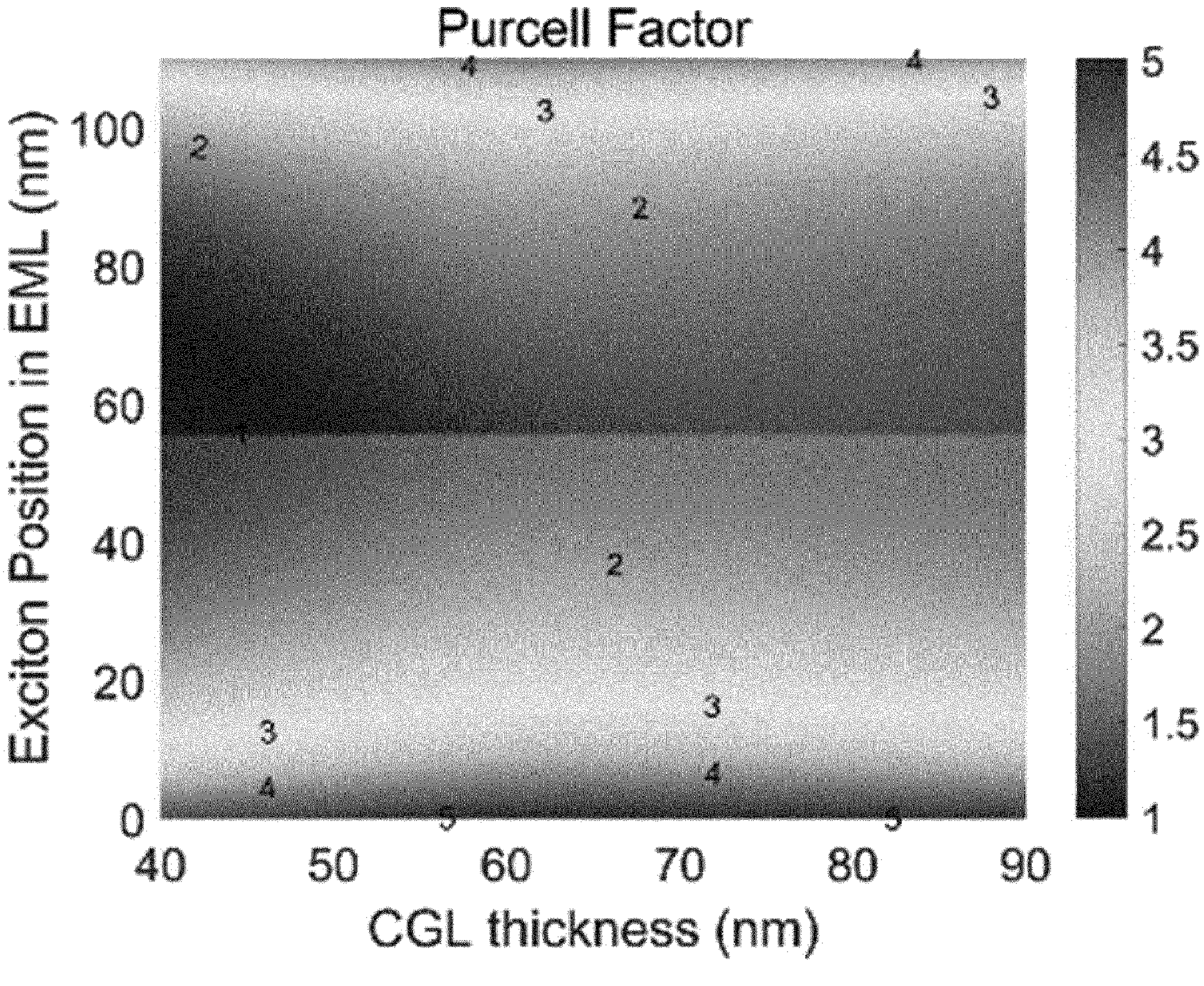
Purcell Factor
Exciton Position in EML (nm)
CGL thickness (nm)
0
20
40
60
80
100
40
50
60
70
80
90
1
1.5
2
2.5
3
3.5
4
4.5
5

FIG. 15A

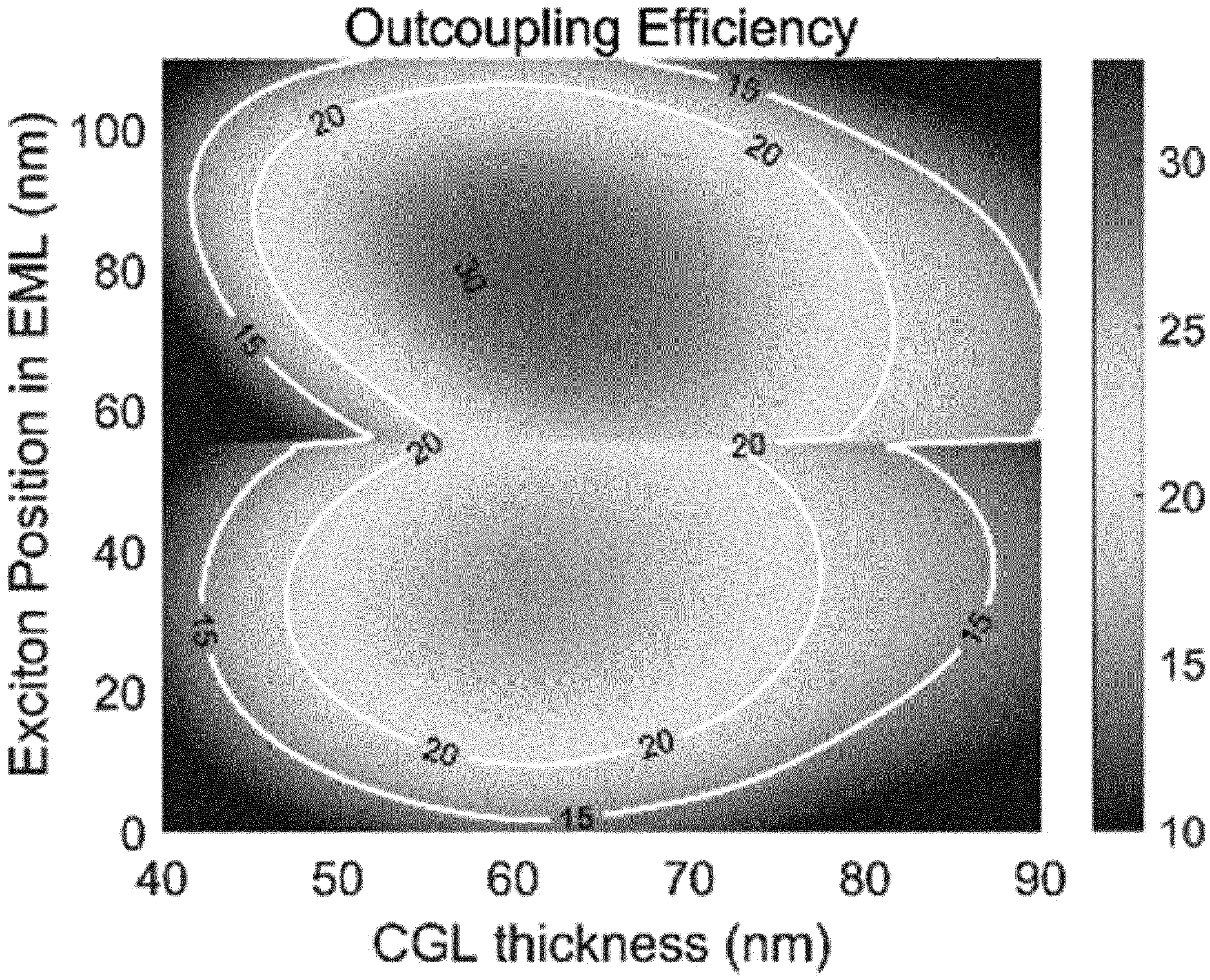
Outcoupling Efficiency
Exciton Position in EML (nm)
CGL thickness (nm)
0
20
40
60
80
100
40
50
60
70
80
90
10
15
20
25
30
15
20
30
20
20
15
20
20
15
15
20
15

FIG. 15B

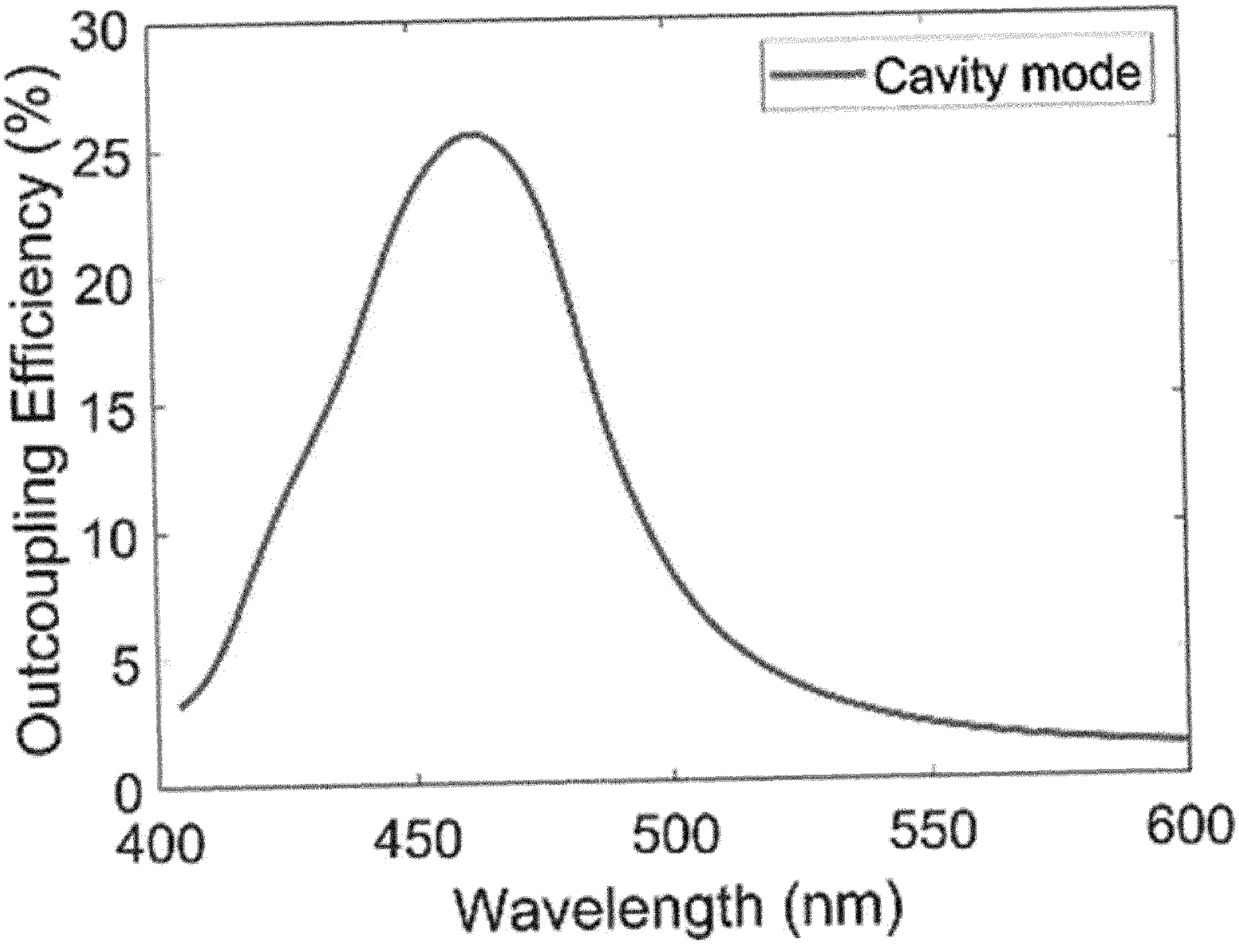
Outcoupling Efficiency (%)
30
25
20
15
10
5
0
400
450
500
550
600
Wavelength (nm)
Cavity mode

FIG. 15C

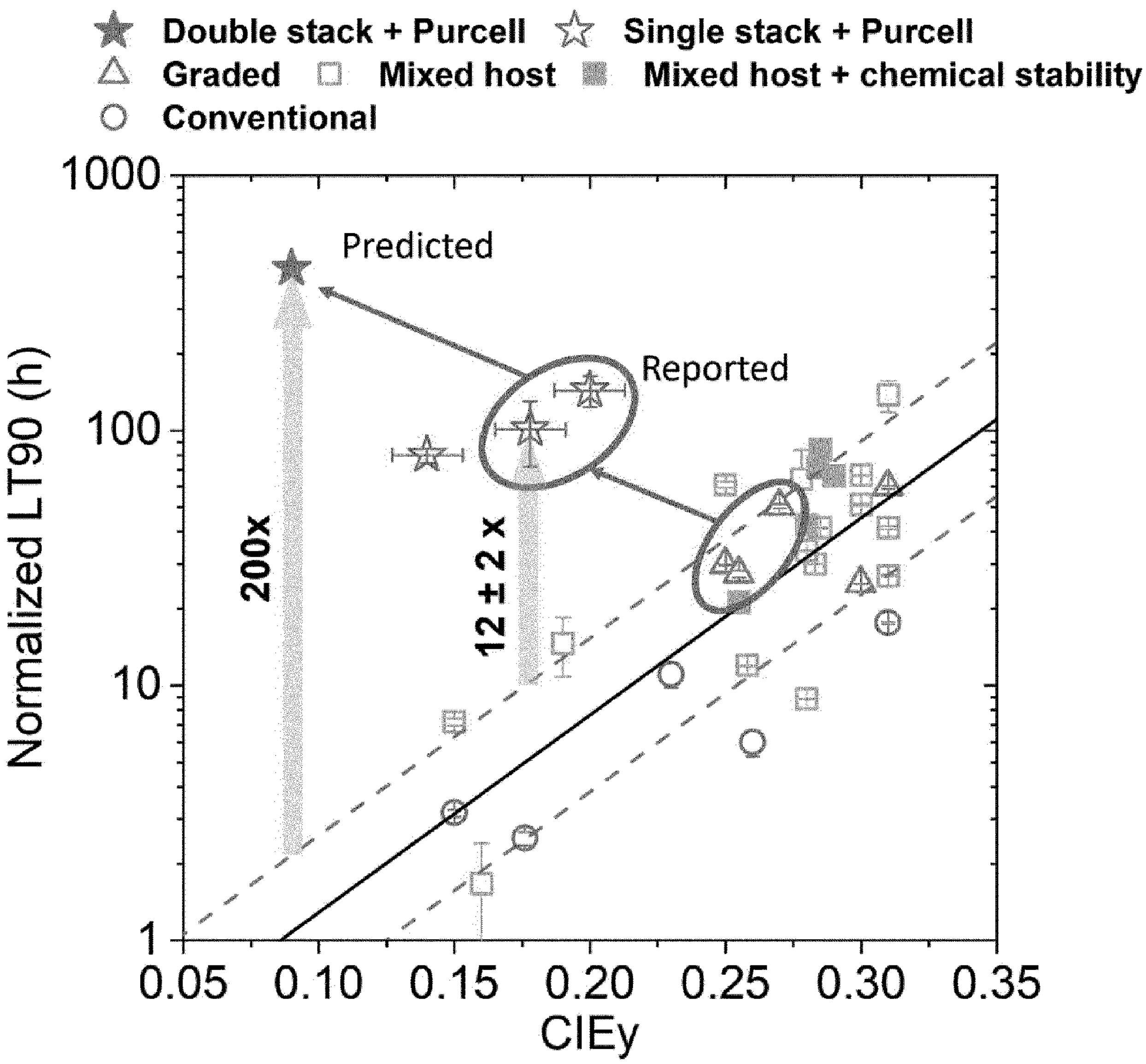
Double stack + Purcell
Single stack + Purcell
Graded
Mixed host
Mixed host + chemical stability
Conventional
Predicted
Reported
200x
12 ± 2 x
Normalized LT90 (h)
1000
100
10
1
0.05
0.10
0.15
0.20
0.25
0.30
0.35
CIEy

FIG. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 63613961
- US 63610024
- US 63512966
- US 63510702
- US 63495197
- US 63482186
- US 41323524
- DE EE0009688
- US 5844363 A
- US 6303238 B
- US 5707745 A
- US 7279704 B
- US 4769292 A
- US 20030230980
- US 5703436 A
- US 6097147 A
- US 20040174116
- US 5247190 A, Friend et al.
- US 6091195 A, Forrest et al.
- US 5834893 A, Bulovic et al.
- US 6013982 A
- US 6087196 A
- US 6337102 B, Forrest et al.
- US 7431968 B
- US 6294398 B
- US 6468819 B
- US 7968146 B
- US 2007023098 W
- US 2009042829 W
- US 20170229663


### Non-patent literature cited in the description


- **BALDO et al.** Highly Efficient Phosphorescent Emission from Organic Electroluminescent Devices. *Nature,* 1998, vol. 395, 151-154
- **BALDO et al.** Very high-efficiency green organic light-emitting devices based on electrophosphorescence. *Appl. Phys. Lett.,* 1999, vol. 75 (3), 4-6
- **BALDO, M. A. et al.** Highly efficient phosphorescent emission from organic electroluminescent devices. *Nature,* 1998, vol. 395, 151
- **ADACHI, C. ; BALDO, M. A. ; THOMPSON, M. E. ; FORREST, S. R.** Nearly 100% internal phosphorescence efficiency in an organic light emitting device. *J. Appl. Phys.,* 2001, vol. 90, 5048-5051
- *Universal PHOLED Product sheets,* 2011, https://www.oled-i nfo.com/fi les/U DC-Product-Sheets-sid-2011. pdf.
- Organic Electronics: Foundations to applications. **FORREST, S. R.** Organic Electronics: Foundations to Applications. Oxford University Press, 2020
- **GIEBINK, N. C. et al.** Intrinsic luminance loss in phosphorescent small-molecule organic light emitting devices due to bimolecular annihilation reactions. *J. Appl. Phys.,* 2008, vol. 103
- **GIEBINK, N. C. ; D'ANDRADE, B. W. ; WEAVER, M. S. ; BROWN, J. J. ; FORREST, S. R.** Direct evidence for degradation of polaron excited states in organic light emitting diodes. *J. Appl. Phys.,* 2009, vol. 105
- **JEONG, C. et al.** Understanding molecular fragmentation in blue phosphorescent organic light-emitting devices. *Org. Electron.,* 2019, vol. 64, 15-21
- **HA, D. G. et al.** Dominance of Exciton Lifetime in the Stability of Phosphorescent Dyes. *Adv. Opt. Mater.,* 2019, vol. 7, 1-5
- **DINTINGER, J. ; KLEIN, S. ; BUSTOS, F. ; BARNES, W. L. ; EBBESEN, T. W.** Strong coupling between surface plasmon-polaritons and organic molecules in subwavelength hole arrays. *Phys. Rev. B,* 2005, vol. 71, 1-5
- **ZHANG, Y. ; LEE, J. ; FORREST, S. R.** Tenfold increase in the lifetime of blue phosphorescent organic light-emitting diodes. *Nat. Commun.,* 2014, vol. 5, 1-7
- **LEE, J. et al.** Hot excited state management for long-lived blue phosphorescent organic light-emitting diodes. *Nat. Commun.,* 2017, vol. 8, 1-9
- **KIM, S. et al.** Degradation of blue-phosphorescent organic light-emitting devices involves exciton-induced generation of polaron pair within emitting layers. *Nat. Commun.,* 2018, vol. 9, 1-11
- **BAE, H. J. et al.** Protecting Benzylic C-H Bonds by Deuteration Doubles the Operational Lifetime of Deep-Blue Ir-Phenylimidazole Dopants in Phosphorescent OLEDs. *Adv. Opt. Mater.,* 2021, vol. 9

- **SIM, B. et al.** Comprehensive model of the degradation of organic light-emitting diodes and application for efficient, stable blue phosphorescent devices with reduced influence of polarons. *Phys. Rev. Appl.,* 2020, vol. 14, 1
- **YANG, K. et al.** Effects of Charge Dynamics in the Emission Layer on the Operational Lifetimes of Blue Phosphorescent Organic Light-Emitting Diodes. *Adv. Funct. Mater,* 2022, vol. 32
- **ZHAO, H. et al.** Control of Host-Matrix Morphology Enables Efficient Deep-Blue Organic Light-Emitting Devices. *Adv. Mater.,* 2023, vol. 35, 2210794
- **IHN, S. G. et al.** Cohosts with efficient host-to-emitter energy transfer for stable blue phosphorescent organic light-emitting diodes. *J. Mater. Chem. C,* 2021, vol. 9, 17412-17418
- **CHOI, K. H. ; LEE, K. H. ; LEE, J. Y. ; KIM, T.** Simultaneous Achievement of High Efficiency and Long Lifetime in Deep Blue Phosphorescent Organic Light-Emitting Diodes. *Adv. Opt. Mater.,* 2019, vol. 7, 1-7
- **SHIN, S. K. ; HAN, S. H. ; LEE, J. Y.** High triplet energy exciplex host derived from a CN modified carbazole based n-type host for improved efficiency and lifetime in blue phosphorescent organic light-emitting diodes. *J. Mater. Chem. C,* 2018, vol. 6, 10308-10314
- **KIM, J. S. et al.** Improved Efficiency and Stability of Blue Phosphorescent Organic Light Emitting Diodes by Enhanced Orientation of Homoleptic Cyclometalated Ir(III) Complexes. *Adv. Opt. Mater.,* 2020, vol. 8
- **JUNG, M. ; LEE, K. H. ; LEE, J. Y. ; KIM, T.** A bipolar host based high triplet energy electroplex for an over 10000 h lifetime in pure blue phosphorescent organic light-emitting diodes. *Mater. Horizons,* 2020, vol. 7, 559-565
- **SUN, J. et al.** Exceptionally stable blue phosphorescent organic light-emitting diodes. *Nat. Photonics,* 2022, vol. 16, 212-218
- **FUSELLA, M. A. et al.** Plasmonic enhancement of stability and brightness in organic light-emitting devices. *Nature,* 2020, vol. 585, 379-382
- **ZENGIN, G. et al.** Realizing strong light-matter interactions between single-nanoparticle plasmons and molecular excitons at ambient conditions. *Phys. Rev. Lett.,* 2015, vol. 114, 1-6
- **DENG, H. ; HAUG, H. ; YAMAMOTO, Y.** Exciton-polariton Bose-Einstein condensation. *Rev. Mod. Phys.,* 2010, vol. 82, 1489-1537